# EUROPEAN PATENT APPLICATION

(11) **EP 4 648 570 A1**
(43) Date of publication of application: **12.11.2025**
(21) Application number: 24738779.8
(22) Date of filing: 05.01.2024
(51) Int. Cl.: H05K 7/20, H01Q 1/02

(54) **ACTIVE HEAT DISSIPATION APPARATUS**

(30) Priority: 06.01.2023 KR 20230002491; 29.12.2023 KR 20230196573
(71) Applicant: KMW Inc., Hwaseong-si, Gyeonggi-do 18462 (KR)
(72) Inventor: KIM, Duk Yong, Yongin-si Gyeonggi-do 17086 (KR); KIM, Dong Won, Bucheon-si Gyeonggi-do 14574 (KR); KIM, Hye Yeon, Hwaseong-si Gyeonggi-do 18496 (KR); YANG, Jun Woo, Suwon-si Gyeonggi-do 16694 (KR); RYU, Chi Back, Hwaseong-si Gyeonggi-do 18392 (KR); JI, Kyo Sung, Hwaseong-si Gyeonggi-do 18484 (KR); CHOI, In Hwa, Yongin-si Gyeonggi-do 17148 (KR)
(74) Representative: Impuls legal PartG mbB
(86) International application number: PCT/KR2024/000308
(87) International publication number: WO 2024/147711

(57) **Abstract**

The present disclosure relates to an active heat dissipation apparatus including a thermal conduction panel body having a refrigerant flow space in which a refrigerant is stored and flows, the refrigerant flow space being formed in the thermal conduction panel body by bending or joining at least one metal panel member, in which the refrigerant flow space includes a first refrigerant flow path positioned adjacent to a press-fitting portion provided in a rear surface portion of a heat dissipation housing main body that is a heat dissipation target, the first refrigerant flow path having a vaporization zone in which the refrigerant changes from a liquid phase to a gaseous phase, and a plurality of strength reinforcement portions formed in a condensation zone excluding the vaporization zone of the first refrigerant flow path and configured to reinforce rigidity of the thermal conduction panel body configured to define one side surface and the other side surface of the refrigerant flow space, thereby significantly improving heat dissipation performance.

## Description

### [Technical Field]

The present disclosure relates to an active heat dissipation apparatus, and more particularly, to an active heat dissipation apparatus capable of improving heat dissipation performance by actively transferring heat, which is generated from a heat generation device (e.g., an electronic device), by means of a phase change of a refrigerant more effective than characteristics of a thermal conduction material of the active heat dissipation apparatus.

### [Background Art]

As an example of wireless communication technologies, a multiple-input/multiple-output (MIMO) technology refers to a technology for innovatively increasing data transmission capacity by using a plurality of antennas. This technology uses a spatial multiplexing technique, in which a transmitter transmits different data through the respective transmitting antennas, and a receiver distinguishes the transmitted data by performing appropriate signal processing.

Therefore, it is possible to transmit a larger amount of data by increasing both the number of transmitting antennas and the number of receiving antennas and thus increasing channel capacities. For example, in case that the number of antennas increases to ten, the channel capacity of about 10 times needs to be ensured by using the same frequency band in comparison with the current single antenna system. In the case of a transmitting/receiving device to which the MIMO technology is applied, the number of transmitters and the number of filters also increase as the number of antennas increases.

The increase in numbers of transmitters and filters causes a problem in that the number of heat generation elements also increases. In order to prevent deterioration in performance of an antenna device, research has been conducted in advance on the MIMO technology to provide a heat dissipation structure that effectively dissipates heat generated from a plurality of heat generation elements.

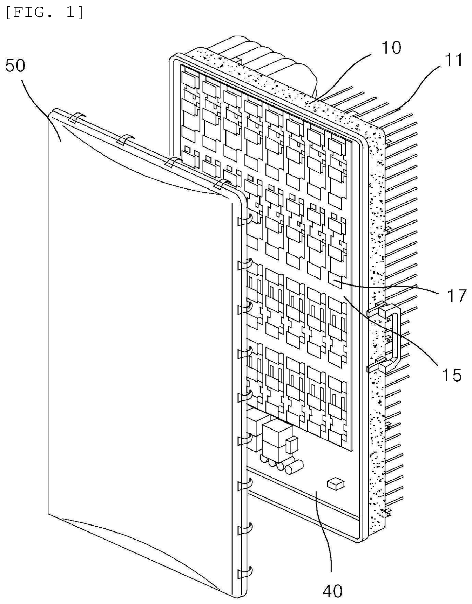

FIG. 1 is an exploded perspective view illustrating an example of an antenna device in the related art.

As illustrated in FIG. 1, a heat generation device (e.g., an electronic device) may be implemented as an antenna device.

As illustrated in FIG. 1, the antenna device in the related art includes an antenna housing main body 10 provided in the form of a rectangular parallelepiped housing opened at a front side thereof and having front and rear sides with a comparatively small thickness, the antenna housing main body 10 having a plurality of heat dissipation fins 11 integrated with a rear surface of the antenna housing main body 10, a non-illustrated main board disposed and stacked on a rear surface in the antenna housing main body 10, and an antenna board 15 disposed and stacked on a front surface in the antenna housing main body 10.

A plurality of power supply-related component elements for calibration power supply control is mounted on the main board, and heat, which is generated from the elements during a power supply process, is dissipated to the outside through the plurality of heat dissipation fins 11 disposed at a rear side of the antenna housing main body 10.

Further, a PSU board 40 mounted with PSU elements is stacked on a lower side of the main board or disposed at the same height as the main board. The PSU board 40 is designed such that heat generated from the PSU elements is also dissipated to the outside through the plurality of heat dissipation fins 11 disposed at the rear side of the antenna housing main body 10.

A plurality of non-illustrated RF filters is disposed on a front surface of the main board, and the rear surface of the antenna board 15 is disposed and stacked on front surfaces of the plurality of RF filters.

A plurality of patch-type or dipole-type radiation elements 17 may be mounted on the front surface of the antenna board 15. A radome panel 50 may be installed on a front surface of the antenna housing main body 10 to allow heat to be smoothly radiated from the radiation elements while protecting the components in the antenna housing main body 10 from the outside.

However, because the antenna device in the related art is designed such that the radome panel 50 is installed on the front portion of the antenna device, system heat, which is generated from the inside of the antenna device, needs to be uniformly and concentratedly dissipated to the rear side of the antenna housing main body 10. Therefore, it is necessary to improve heat dissipation performance of the plurality of heat dissipation fins 11.

In this case, as a method that may be considered as a solution for improving heat dissipation performance of the plurality of heat dissipation fins 11, there is a method that adopts a material with better thermal conductivity, integrates the material with the antenna housing main body 10, and manufactures the antenna housing main body 10 so that an outermost peripheral tip of the antenna housing main body 10 is spaced apart from the heat generation elements, i.e., heat sources to an external space as distantly as possible.

However, there is a problem in that the material of the plurality of heat dissipation fins 11 is limited in improving thermal conductivity, and thermal concentration, which occurs on a portion adjacent to the heat generation element, into which heat is introduced, cannot be eliminated even though outermost peripheral tips of the plurality of heat dissipation fins 11 are distantly spaced apart from the heat generation elements. Therefore, there is a problem in that a size of a product increases in a thickness direction, which makes it difficult to slim down the product.

Meanwhile, examples of thermally conductive materials (metal), which are generally adopted as materials of the plurality of heat dissipation fins 11 in the technical field associated with heat dissipation, may include aluminum (Al) alloys.

Examples of metallic materials, which have higher thermal conductivity (unit, W/mK) than aluminum (Al), may include silver (Au, 418.6), copper (Cu, 372.1), and gold (Ag, 295.3). However, because these metallic materials are more expensive than aluminum, these metallic materials cannot be widely adopted to cover a wide heat dissipation area in terms of economic feasibility (costs).

However, because only pure aluminum cannot satisfy strength and ductility, aluminum (Al) is generally processed and manufactured in the form of an aluminum alloy by approximately mixing silicon and magnesium. In this case, there is a problem in that the utilization of aluminum is sometimes extremely restrictive because aluminum is merely used to manufacture components with small scales or simple shapes because of low castability thereof. Further, the amount of costs required to manufacture aluminum is still large even though aluminum is lower in costs than copper and gold.

In addition, even the heat dissipation fins 11, which are made of an aluminum alloy material, do not overcome the limitation of the material. Therefore, recently, a refrigerant-type heat dissipation system has attracted attention. The refrigerant-type heat dissipation system adopts a refrigerant as a phase change material, fills a closed interior thereof with the refrigerant, and dissipates heat by using a temperature difference between latent heat and sensible heat used to change a phase of the refrigerant.

A key factor for maximizing heat dissipation performance of the refrigerant-type heat dissipation system is the refrigerant that changes in phases. The heat dissipation fins 11 made of an aluminum alloy merely serve to define a closed refrigerant flow space in which the refrigerant flows while changing in phase and to transfer overall heat, which is generated from heat generation elements, i.e., heat generation targets, to the refrigerant as much as possible by using thermal conductivity thereof.

Therefore, the heat dissipation fins, which define refrigerant flow spaces filled with the refrigerant, i.e., the phase change material, need to be processed and designed to minimize physical spacing distances from the heat generation elements to the refrigerant in order to improve the heat dissipation performance. However, the heat dissipation fins 11, which have been researched and developed until now, are still preferred to be made of expensive aluminum alloy materials because the aluminum alloy materials in the related art are materials that are most widely used.

Because pure aluminum has an excellent elongation ratio related to processability of metal, the pure aluminum may be used to manufacture the heat dissipation fins 11 capable of minimizing thicknesses thereof. However, the heat dissipation fins 11, which are made of aluminum alloy materials to improve strength and ductility, have low elongation ratios and are limited in minimizing thicknesses thereof.

In addition, in case that the metallic materials, which constitute the heat dissipation fins 11, are aluminum materials and water is selected as the refrigerant, the aluminum materials generate an oxidation reaction with water during an initial process of applying the refrigerant, and aluminum oxides are produced. Further, some of the aluminum oxides are replaced by hydrogen during this process, which increases an internal pressure. Therefore, a typical heat dissipation apparatus using the aluminum materials needs to select a special refrigerant, such as a Honeywell refrigerant or Freon gas (CFC), in order to prevent the above-mentioned chemical reaction, which decreases the choice of refrigerants.

Meanwhile, the phase change refers to a change in inherent states of a liquid, a gas, or a solid when the liquid, the gas, or the solid accumulates a large amount of energy or releases stored thermal energy.

The phase change refers to a change in physical arrangement of molecules instead of chemical reactions such as a chemical bond or formation. When energy is applied to a material, heat, which does not change the phase of the molecules, is called sensible heat, and heat, which changes the phase of the molecules, is called latent heat.

However, because the relationship between temperature and pressure is proportional in the heat dissipation apparatus, there is a problem in that the pressure increases when the temperature increases. The pressure, which is increased by high-temperature heat conducted from the heat generation element in the sealed heat dissipation apparatus, causes a problem in that the heat dissipation apparatus ruptures. In order to solve the problem, the pressure should not be increased, and the heat dissipation apparatus is required to have a sufficient internal volume that may implement pressure equilibrium during a phase change circulation of the material.

In addition, the refrigerant, with which the interior of the heat dissipation apparatus is filled, needs to be selected from the types of refrigerants that do not cause a chemical reaction with the metallic material constituting the heat dissipation apparatus in order to prevent an increase in internal pressure of the heat dissipation apparatus.

For example, in case that the metallic materials, which constitute the heat dissipation apparatus, are aluminum (Al) materials and water is selected as the refrigerant, the aluminum materials generate an oxidation reaction with water during the initial process of applying the refrigerant, and aluminum oxides are produced. Further, some of the aluminum oxides are replaced by hydrogen during this process, which increases an internal pressure. Therefore, a special refrigerant, such as a Honeywell refrigerant or Freon gas (CFC), is selected for the heat dissipation apparatus using the typical aluminum materials in order to prevent the above-mentioned chemical reaction.

However, recently, many countries have regulated the use of the special refrigerants such as a Honeywell refrigerant or Freon gas (CFC), except for water. This is because there is a concern that the special refrigerant leaks to the outside in the event of a breakage caused by increased internal pressure of the heat dissipation apparatus or in the event of a breakage caused when the product is transported, transferred, or installed, which may contaminate the atmosphere and external environment.

However, when the special refrigerant is excluded from the available refrigerants, the use of the heat dissipation apparatus made of aluminum materials, which are commonly used, is inevitably restrictive because the aluminum material has higher thermal conductivity than other metallic materials. Therefore, recently, the relevant heat dissipation apparatus manufactures have actively performed research to replace the metallic materials, which constitute the heat dissipation apparatus, and implement the heat dissipation design.

Meanwhile, as research data related to the above-mentioned disadvantage, a brief introduction to co-author Liqiang Deng's paper "Thermal study of the natural air cooling using roll bond flat heat pipe as plate fin under multi-heat source condition" disclosed in the International Journal of Thermal Sciences (published on August 15, 2022, hereinafter, referred to as 'preceding literature') is as follows.

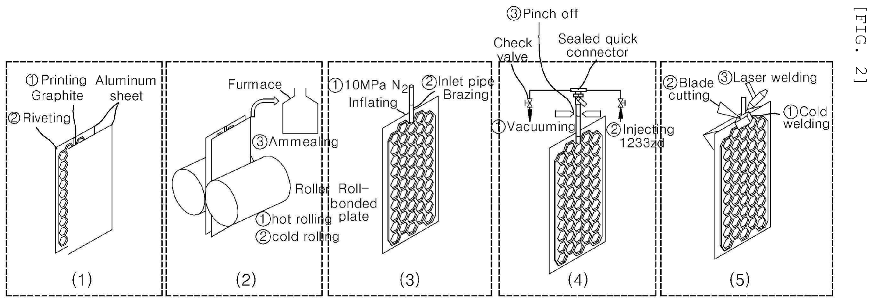

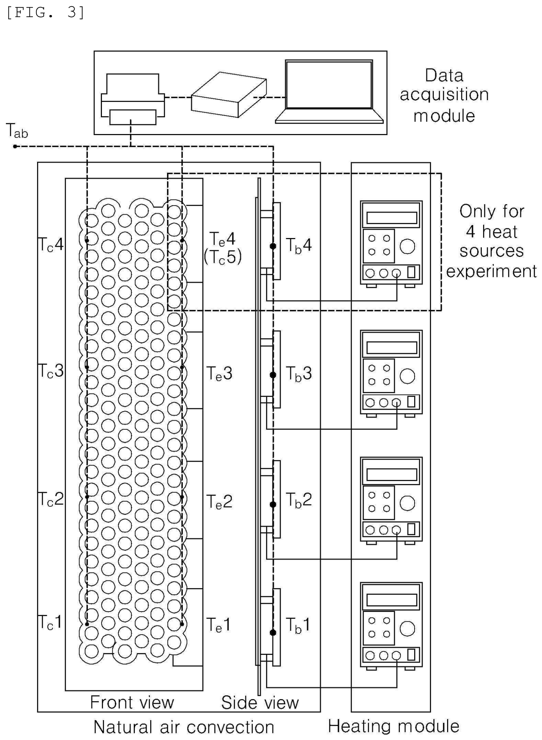

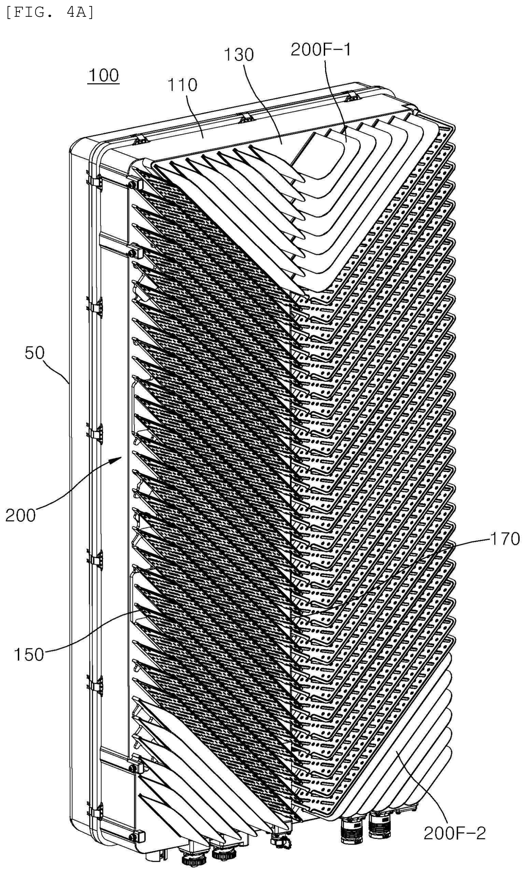

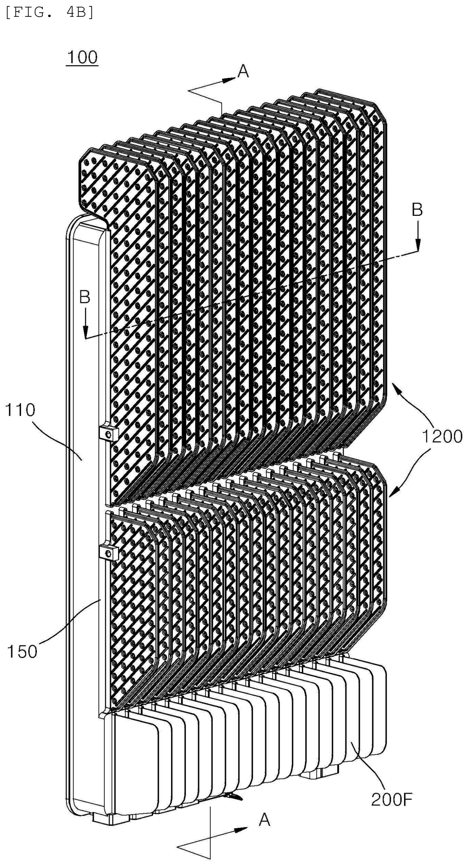

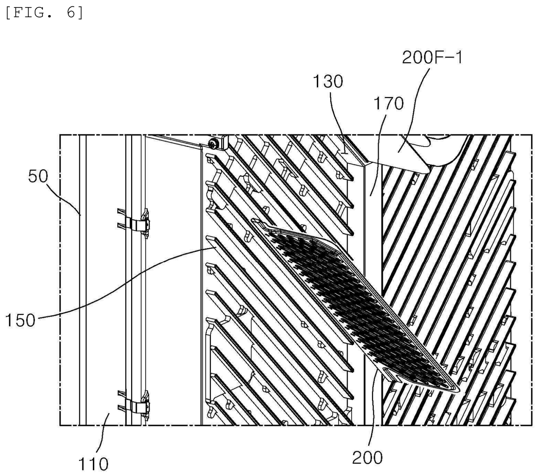

FIG. 2 is a schematic view (see FIG. 4 of the preceding literature) illustrating a process of manufacturing a roll bond flat heat pipe (hereinafter, referred to as an 'RBFHP') disclosed in the preceding literature, and FIG. 3 is a schematic view illustrating an apparatus for testing the RBFHP in FIG. 2 (see FIG. 6 of the preceding literature).

As illustrated in FIG. 2, the RBFHP of the preceding literature is formed as a self-connected chamber by printing non-bondable graphite on a first aluminum sheet by using a pre-designed mold, stacking the first aluminum sheet on a second aluminum sheet, rolling and joining the two aluminum sheets in the order of hot-rolling, cold-rolling, and annealing, soldering an inlet pipe, and inflating a nonbonded portion by injecting a high-pressure gas into a plate from an inlet.

The preceding literature concludes that the RBFHP, which is molded as described above, has a better result value than a general aluminum plate (fin) under a test condition (test on four uniformly distributed heat sources) illustrated in FIG. 3.

However, because the RBFHP of the preceding literature is manufactured by roll bonding as described above, it is difficult to dispose a refrigerant (particularly, a liquid refrigerant) adjacent to a coupling end (i.e., a rim end) positioned to be closest to the heat source.

That is, the roll bonding necessarily joins the rim end. Therefore, because a portion, where the bonding is repeatedly performed, at least needs to be spaced apart from the heat source (heat generation element), thermal conduction resistance occurs because of the material of the portion.

The reason why the method of manufacturing the RBFHP of the preceding literature is limited to the roll bonding or adopts the roll bonding is based on the optimal method for configuring the two panel sheets made of the aluminum material into a chamber. Because the sheet made of the aluminum material cannot be implemented in practice by the bending method, the method of manufacturing the RBFHP of the preceding literature is inevitably adopted.

Meanwhile, the RBFHP of the preceding literature has a honeycomb structure in order to maximize an area of a condensation zone when the refrigerant vaporized in the vicinity of of the heat source moves to the condensation zone and condensed in the condensation zone. However, a flow section, in which a gaseous refrigerant quickly moves to an upper end most distant from the heat source, is lengthened, and a return route of the liquid refrigerant condensed in the condensation zone overlaps the flow section of the gaseous refrigerant, which also causes a problem in that high flow resistance occurs.

### [Disclosure]

### [Technical Problem]

The present disclosure has been made in an effort to solve the above-mentioned technical problem, and an object of the present disclosure is to provide an active heat dissipation apparatus capable of improving heat dissipation performance of a heat generation device (electronic device).

The present disclosure has also been made in an effort to provide an active heat dissipation apparatus capable of maximizing a heat transport ability of a refrigerant with which the active heat dissipation apparatus is filled.

The present disclosure has also been made in an effort to provide an active heat dissipation apparatus capable of providing excellent manufacturability.

The present disclosure has also been made in an effort to provide an active heat dissipation apparatus capable of expanding the use of water as a refrigerant, and producing an inexpensive product by replacing an aluminum (Al) material, which has a comparatively high thermal conductivity among typical metallic materials, with a metallic material having low thermal conductivity, thereby realizing an effect identical to or better than a heat dissipation performance effect in the related art.

The present disclosure has also been made in an effort to provide an active heat dissipation apparatus capable of sufficiently satisfying country-specific regulations by adopting and applying water as a phasechangeable refrigerant.

Technical problems of the present disclosure are not limited to the aforementioned technical problems, and other technical problems, which are not mentioned above, may be clearly understood by those skilled in the art from the following descriptions.

### [Technical Solution]

One embodiment of an active heat dissipation apparatus according to the present disclosure includes: a thermal conduction panel body having a refrigerant flow space in which a refrigerant is stored and flows, the refrigerant flow space being formed in the thermal conduction panel body by bending or joining at least one metal panel member, in which the refrigerant flow space includes: a first refrigerant flow path positioned to be adjacent to a press-fitting portion provided on a rear surface portion of a heat dissipation housing main body that is a heat dissipation target, the first refrigerant flow path having a vaporization zone in which the refrigerant changes from a liquid phase to a gaseous phase; and a plurality of strength reinforcement portions formed in a condensation zone excluding the vaporization zone of the first refrigerant flow path and configured to reinforce rigidity of the thermal conduction panel body configured to define one side surface and the other side surface of the refrigerant flow space, and in which the plurality of strength reinforcement portions include: a plurality of line reinforcement portions positioned in a relatively upper region based on a gravitational direction in a state in which the plurality of line reinforcement portions are installed on the press-fitting portion, the plurality of line reinforcement portions being configured to form the second refrigerant flow paths configured to guide a flow of a liquid refrigerant in the refrigerant, with which the refrigerant flow space is filled, to the vaporization zone; and a plurality of dot reinforcement portions that are portions that are not occupied by the plurality of line reinforcement portions, the plurality of dot reinforcement portions being positioned in a relatively lower region based on the gravitational direction in a state in which the plurality of dot reinforcement portions are installed on the press-fitting portion.

In this case, the plurality of line reinforcement portions may be provided in the condensation zone, and a single line reinforcement portion may be provided on each of a plurality of inclined guides provided to define the second refrigerant flow path as a space, except for a thickness direction of the refrigerant flow space.

In addition, the plurality of line reinforcement portions may further protrude toward the refrigerant flow space than the plurality of inclined guides and define independent flow paths as the second refrigerant flow paths on the inclined guides.

In addition, lower ends of the plurality of line reinforcement portions and the plurality of inclined guides may be formed to be inclined toward the first refrigerant flow path so as to have predetermined inclination angles.

In addition, any one of two opposite ends of each of the plurality of line reinforcement portions and the plurality of inclined guides, which adjoins the first refrigerant flow path, may always be positioned below the other end based on the gravitational direction.

In addition, the plurality of dot reinforcement portions may be arranged to have an inclination angle equal to inclination angles of the plurality of line reinforcement portions and the plurality of inclined guides.

In addition, the thermal conduction panel body may include: one side thermal conduction panel configured to define one side surface of the refrigerant flow space; and the other side thermal conduction panel configured to define the other side surface of the refrigerant flow space, and the plurality of line reinforcement portions and the plurality of dot reinforcement portions may be symmetrically formed based on the first refrigerant flow paths of one side thermal conduction panel and the other side thermal conduction panel.

In addition, the second refrigerant flow paths may be symmetrically formed on one side thermal conduction panel and the other side thermal conduction panel in the upper region and defined directly by the plurality of line reinforcement portions protruding to be in surface contact with one another in the refrigerant flow space, and the second refrigerant flow paths may be symmetrically formed on one side thermal conduction panel and the other side thermal conduction panel in the lower region and defined indirectly by the plurality of dot reinforcement portions protruding to be in surface contact with one another in the refrigerant flow space.

In addition, the plurality of dot reinforcement portions may be arranged so that a vertical centerline of any arbitrarily selected one of the dot reinforcement portions is spaced apart farther from a portion where the first refrigerant flow path is positioned than a vertical line that connects a midpoint of a separation space between the two dot reinforcement portions positioned at a relatively upper side.

In addition, an arrangement density of the plurality of dot reinforcement portions may be set in consideration of surface tension of the refrigerant with which the refrigerant flow space is filled.

### [Advantageous Effects]

The embodiment of the active heat dissipation apparatus according to the present disclosure may achieve the following various effects.

First, it is possible to minimize thermal concentration on the rear surface of the heat dissipation housing main body caused by an ascending flow of heat and to enable the active heat transfer by changing the phases of the refrigerant, thereby significantly improving the overall heat dissipation performance.

Second, it is possible to achieve the effect of improving the heat dissipation performance by maximizing the heat transport ability by shortening the gas-liquid circulation cycle of the refrigerant filled therein.

Third, the material of the thermal conduction panel body, which constitutes the refrigerant flow space in which the refrigerant flows while changing the phases, is replaced with the SUS material that is a metallic material lower in thermal conductivity than an aluminum material. Therefore, it is possible to achieve the effect of implementing higher heat dissipation performance in comparison with the thermal conduction panel body in the related art made of an aluminum material.

Fourth, because the refrigerant may be limited to water and selectively used, it is possible to achieve the effect of particularly ensuring design diversity in product use and manufacturing in countries that regulate the use of refrigerants.

Fifth, even when the metallic material, which has lower thermal conductivity than a metallic material relatively excellent in thermal conductivity, is used, it is possible to manufacture the heat dissipation apparatus having the same or better heat dissipation performance, which may achieve the effect of reducing the manufacturing costs and simplifying the manufacturing process.

### [Description of Drawings]

FIG. 1 is an exploded perspective view illustrating an example of an antenna device in the related art.
FIG. 2 is a schematic view illustrating a process of manufacturing a roll bond flat heat pipe (hereinafter, referred to as an 'RBFHP') disclosed in the preceding literature (see FIG. 4 in the preceding literature).
FIG. 3 is a schematic view illustrating an apparatus for testing the RBFHP in FIG. 2 (see FIG. 6 in the preceding literature).
FIGS. 4A and 4B are perspective views illustrating two types of installation embodiments of a rear portion of an antenna device of an active heat dissipation apparatus according to an embodiment of the present disclosure.
FIGS. 5A and 5B are exploded perspective views illustrating the rear portion of the antenna device in FIGS. 4A and 4B.
FIG. 6 is an exploded perspective view illustrating an installed state of the active heat dissipation apparatus according to the embodiment of the present disclosure with respect to a press-fitting portion formed on the rear portion of the antenna device in FIG. 5A.
FIG. 7 is a cross-sectional view and a partially enlarged view thereof illustrating the installed state of the active heat dissipation apparatus according to the embodiment of the present disclosure with respect to the press-fitting portion in FIG. 6.
FIG. 8 is a cut-away perspective view and a partially enlarged view thereof illustrating the installed state of the active heat dissipation apparatus according to the embodiment of the present disclosure with respect to the press-fitting portion in FIG. 6.
FIG. 9 is a cut-away perspective view illustrating an internal structure of the single active heat dissipation apparatus among the components in FIG. 8.
FIG. 10 is a cross-sectional rear side view illustrating an internal structure for explaining a trench structure in FIGS. 4A and 5A.
FIG. 11 is a partial perspective view illustrating the installed state of the active heat dissipation apparatus according to the embodiment of the present disclosure with respect to the press-fitting portion among the components in FIGS. 4A and 5A.
FIG. 12 is a perspective view illustrating a process of manufacturing the active heat dissipation apparatus according to the embodiment of the present disclosure.
FIG. 13 is a top plan view illustrating a thermal conduction panel body in a state made before the thermal conduction panel body is bent among the components of the active heat dissipation apparatus according to the embodiment of the present disclosure illustrated in FIG. 12.
FIG. 14 is an enlarged perspective view and an enlarged top plan view illustrating a press-fitting end and a modified example thereof among the components of the active heat dissipation apparatus according to the embodiment of the present disclosure.
FIG. 15 is a cross-sectional view illustrating a state in which an absorber is excluded among the components in FIG. 14D and 14E.
FIGS. 16 and 17 are a perspective view and a partially enlarged view thereof illustrating states made before and after the active heat dissipation apparatus according to the embodiment of the present disclosure is bent.
FIG. 18 is a top plan view illustrating a state made after the active heat dissipation apparatus according to the embodiment of the present disclosure is bent.
FIG. 19 is a cross-sectional view taken along line C-C in FIG. 18.
FIGS. 20 and 21 are perspective view illustrating an example of the absorber among the components of the active heat dissipation apparatus according to the embodiment of the present disclosure.
FIGS. 22A and 22B are development views illustrating states made before thermal conduction panel bodies according to the first and second modified examples 200T-1 and 200T-2 are bent relative to some of the components of the embodiment of the present disclosure.
FIGS. 23A to 24B are development views illustrating thermal conduction panel bodies of additional embodiments to which various modified examples in FIGS. 22A and 22D are complexly applied.
FIG. 25 is a cross-sectional view illustrating installed states of a comparative example 200D (a) and an active heat dissipation apparatus 200 (b) according to the embodiment of the present disclosure with respect to the press-fitting portion.
FIG. 26 is a cross-sectional view taken along line A-A in FIG. 4B and a partially enlarged view thereof.
FIG. 27 is a cut-away perspective view taken along line A-A in FIG. 4B and a partially enlarged view thereof.
FIG. 28 is a cut-away perspective view taken along line B-B in FIG. 4B and a partially enlarged view thereof.
FIG. 29 is a perspective view illustrating an active heat dissipation apparatus according to another embodiment of the present disclosure.
FIG. 30 is an exploded perspective view of FIG. 29.
FIG. 31 is a cut-away perspective view (a), a partially enlarged view (b) thereof, and a cross-sectional view (c) of the corresponding part in FIG. 29.
FIG. 32 is a cross-sectional view illustrating a state in which the active heat dissipation apparatus according to another embodiment of the present disclosure is coupled to the press-fitting portion.
FIG. 33 is a comparison graph (a) and a comparison view (b) for comparing temperatures of heat generation elements 140 of the active heat dissipation apparatus 200D according to the comparative example in FIG. 25 and the active heat dissipation apparatus 200 according to the embodiment of the present disclosure.
FIG. 34 is a table illustrating a result of measuring times for which the comparative example 200D including the thermal conduction panel bodies 200D-1 and 200D-2 made of an aluminum material and the active heat dissipation apparatus 200 according to the embodiment of the present disclosure made of a SUS material reach 50°C, 60°C, and 70°C.
FIG. 35 is a graph for comparing temperatures of a heat dissipation fin (AL6063_REF) made of a general aluminum material and provided without using a refrigerant and products with two types of specifications estimated as an RBFHP of the preceding literature (a roll bonding fin (292*115 and 310*90) and an active heat dissipation apparatus (PTX (310*90) according to the embodiment of the present disclosure) in accordance with positions of the heat sources (heat generation elements).
FIG. 36 is a flowchart illustrating a method of manufacturing the active heat dissipation apparatus according to the embodiment of the present disclosure.
FIG. 37 is a flowchart illustrating a method of manufacturing the active heat dissipation apparatus according to another embodiment of the present disclosure.

### <Description of Reference Numerals>

100: Antenna device
110: Heat dissipation housing main body
200: Active heat dissipation apparatus
200-1: One side thermal conduction panel
200-2: The other side thermal conduction panel
201: Press-fitting end
203: Heat dissipation plate portion
205: Refrigerant flow space
210: First refrigerant flow path
215: Inclined guide
220: Second refrigerant flow path
230: Third refrigerant flow path
240: Plurality of strength reinforcement portions
241: Line reinforcement portion
242: Dot reinforcement portion
250: Absorber fixing guide
300: Absorber
301: Auxiliary absorber
301-1: Upper auxiliary absorber
301-2: Lower auxiliary absorber
1200: Active heat dissipation apparatus
1261, 1262: Auxiliary absorber installation portion
1263: Plurality of fixing ribs
T: Arbitrary reference line
S10: Pressing process
S20: Bending process
S30: Absorber installation process
S40: Joining process
S50: Refrigerant filling process
S60: Heat dissipation apparatus fastening process

### [Best Mode]

Hereinafter, embodiments of an active heat dissipation apparatus according to the present disclosure will be described in detail with reference to the accompanying drawings.

In giving reference numerals to constituent elements of the respective drawings, it should be noted that the same constituent elements will be designated by the same reference numerals, if possible, even though the constituent elements are illustrated in different drawings. Further, in the following description of the embodiments of the present disclosure, a detailed description of related publicly-known configurations or functions will be omitted when it is determined that the detailed description obscures the understanding of the embodiments of the present disclosure.

In addition, the terms first, second, A, B, (a), and (b) may be used to describe constituent elements of the embodiments of the present disclosure. These terms are used only for the purpose of discriminating one constituent element from another constituent element, and the nature, the sequences, or the orders of the constituent elements are not limited by the terms. Further, unless otherwise defined, all terms used herein, including technical or scientific terms, have the same meaning as commonly understood by those skilled in the art to which the present disclosure pertains. The terms such as those defined in commonly used dictionaries should be interpreted as having meanings consistent with meanings in the context of related technologies and should not be interpreted as ideal or excessively formal meanings unless explicitly defined in the present application.

### 1. Installation aspect of heat dissipation apparatus - antenna device

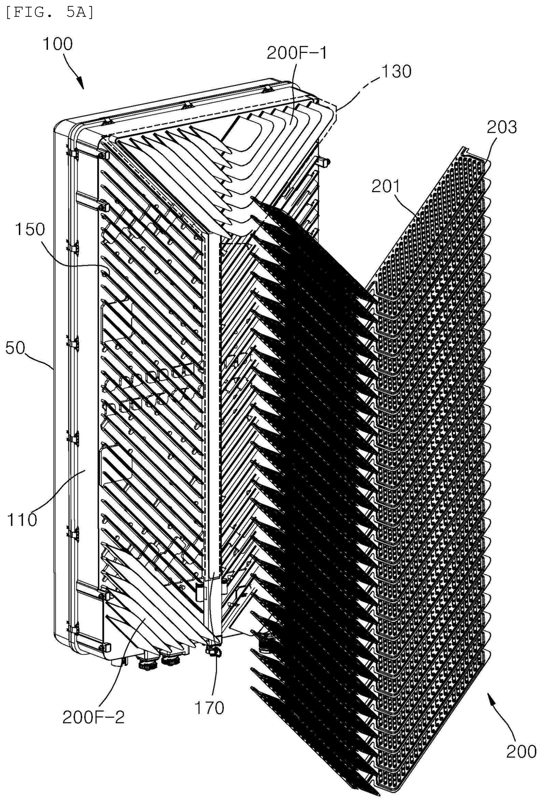

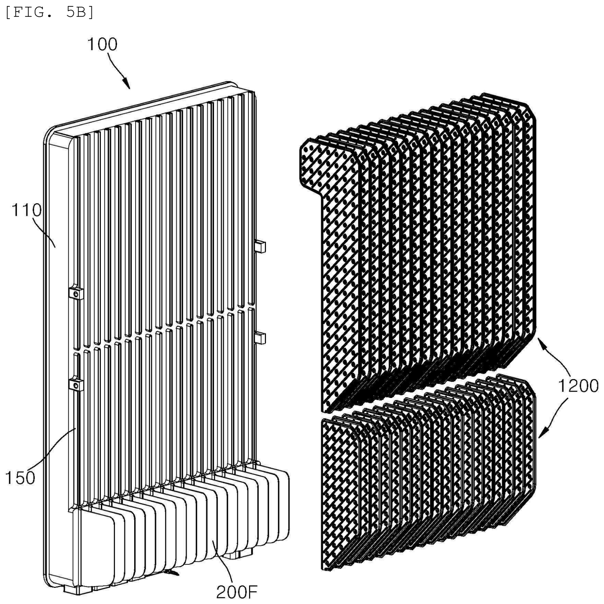

FIGS. 4A and 4B are perspective views illustrating two types of installation embodiments of a rear portion of an antenna device of an active heat dissipation apparatus according to an embodiment of the present disclosure, and FIGS. 5A and 5B are exploded perspective views illustrating the rear portion of the antenna device in FIGS. 4A and 4B.

In general, heat generation devices (electronic devices) are manufactured in various shapes throughout the industries, but the applicant of the present disclosure is a company involved in the manufacturing of other wireless communication equipment. A representative heat generation device (electronic device) of the wireless communication equipment is an antenna device, and the antenna device will be described below as a specific example of the heat generation device.

However, an active heat dissipation apparatus according to the embodiments of the present disclosure, will be described below, should not be interpreted as being necessarily limited only to a configuration applied to the antenna device.

As illustrated in FIGS. 4A and 4B, an antenna device 100, to which an active heat dissipation apparatus 200 or 1200 according to an embodiments of the present disclosure is applied, includes a heat dissipation housing main body 110 having an accommodation space opened forward and formed in a rectangular parallelepiped shape having a long, thin forward/rearward accommodation width in an approximately vertical direction.

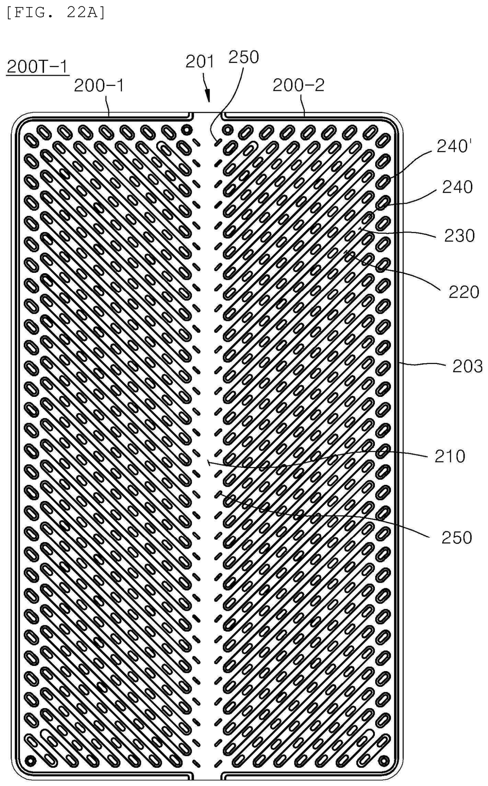

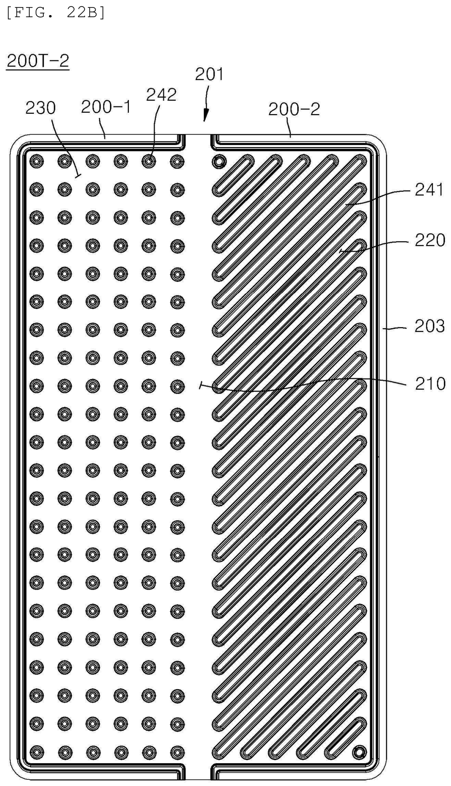

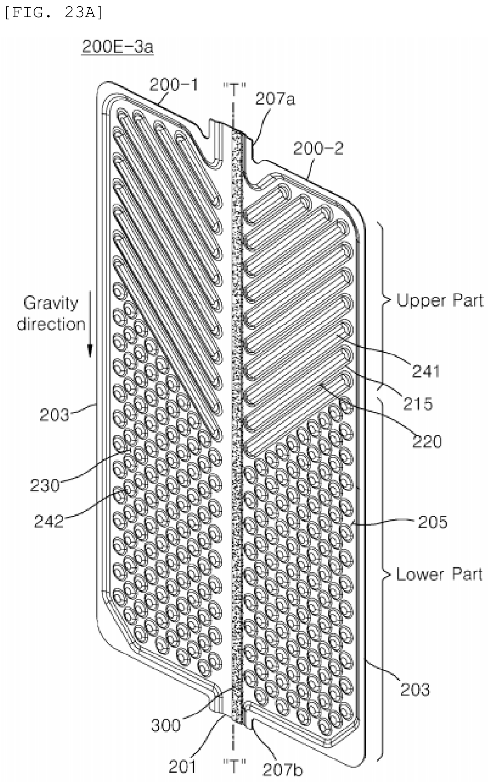

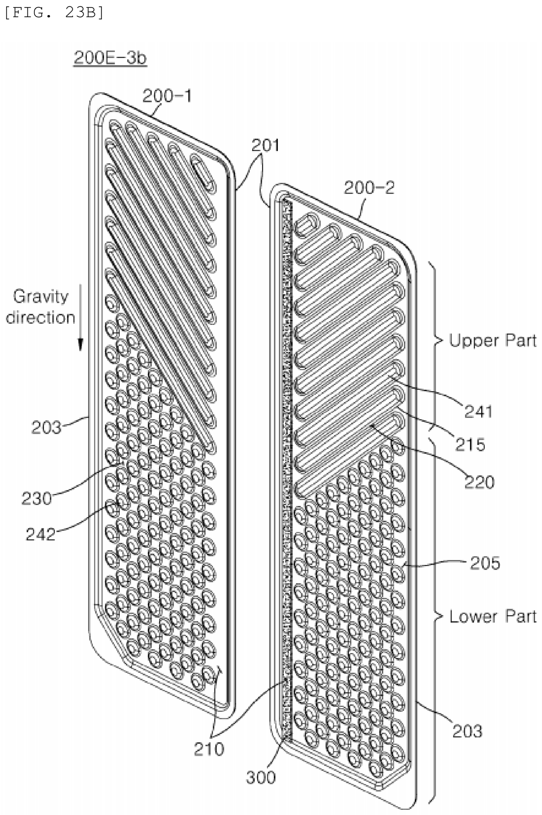

The heat dissipation housing main body 110 may be made of a thermally conductive material (particularly, a metallic material) to effectively transfer heat by being thermally in surface contact with heat generation elements to be described below (see reference numeral '140' in FIGS. 22 and 23 to be described below).

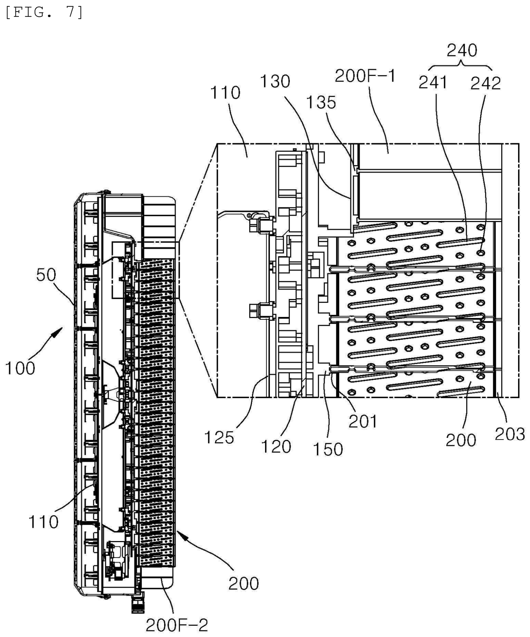

Although not illustrated in the drawings, a main board (see reference numeral '120' in FIG. 7) may be stacked and disposed in the accommodation space of the heat dissipation housing main body 110, a plurality of micro bellows filter (MBF) elements may be mounted on a front surface of the main board by means of a clamshell (see reference numeral '125' in FIG. 7) as a substrate for a power amplifier unit (PAU) and a digital transceiving unit (DTU), and heat generation elements 140 may be mounted on a rear surface of the main board.

In this case, the heat generation elements 140 may be mounted on the main board 120 and defined as heat generation elements, such as RFIC elements or power amplifier (PA) elements, that generate a large amount of heat when operating. However, in the embodiment of the present disclosure, the antenna device is adopted as the electronic device and described. However, it should be noted that the heat generation elements 140 are not limited to the configuration. For example, semiconductors, CPUs of PCs, or the like, which are representative heat generation elements, may be adopted as the heat generation elements 140.

A radome panel 50 may be installed on a front surface of an accommodation space of the heat dissipation housing main body 110 and serve to protect radiation elements, which are implemented as antenna elements, from the outside and allow heat to be smoothly radiated from the radiation elements.

However, in the case of the antenna device having a comparatively large need for heat dissipation among the electronic devices, the radome panel 50, which is not suitable for heat dissipation, is installed on the front surface of the heat dissipation housing main body 110, as described above. Therefore, it is appreciated that the need for concentrated heat dissipation through the remaining portion, except for the front surface of the heat dissipation housing main body 110, is greater, and an effective heat dissipation design within a limited heat dissipation area is required.

Meanwhile, the active heat dissipation apparatus 200 or 1200 according to the embodiments of the present disclosure may be installed on the rear surface of the heat dissipation housing main body 110.

The active heat dissipation apparatus 200 or 1200 according to the embodiments of the present disclosure is provided in the form of a heat dissipation fin. Strictly speaking, unlike stationary heat dissipation fins 200F-1 and 200F-2 to be described below, the active heat dissipation apparatus 200 or 1200 is characterized by being provided as a vapor chamber type having a small thickness and having an interior essentially filled with a refrigerant, i.e., a material that may be changed in phase by heat supplied from the outside.

In this case, an absorber 300 may be included in the active heat dissipation apparatus 200 according to the embodiments of the present disclosure. The absorber 300 absorbs a liquid refrigerant in the refrigerant, retains the liquid refrigerant at a position close to the heat generation elements 140, and promotes the vaporization of the liquid refrigerant to a gaseous refrigerant.

In this case, the concept of the absorber 300 for retaining the liquid refrigerant is not limited to a configuration in which the absorber simply absorbs and stores the liquid refrigerant, and the concept should be understood as a concept including a configuration in which absorbency (or capillary force) at least allows the liquid refrigerant to flow in a direction (upward) opposite to the gravitational direction to a position higher than a level of the liquid refrigerant.

In general, a wick member having a wick structure having a plurality of pores is typically provided in a well-known (already publicly-known) vapor chamber. In this case, the wick member may be manufactured by sintering metallic powder to have a plurality of pores so that the liquid refrigerant, with which the inside of the panel member made of a thermal conduction material is filled, may be moved by a capillary force to a side, at which the heat generation elements are provided, and the gaseous refrigerant may be freely moved to the outside.

However, the wick member is not limited to the wick member made of the sintered metallic material. In particular, the wick member may be defined as including all possible materials, such as fiber materials, despite any designation, such as the absorber 300, as long as the wick member may promote absorption and dispersion or vaporization of the liquid refrigerant. This configuration will be described below in more detail.

### 2-1. First installation embodiment (Embodiment of present disclosure) and installation on press-fitting portion

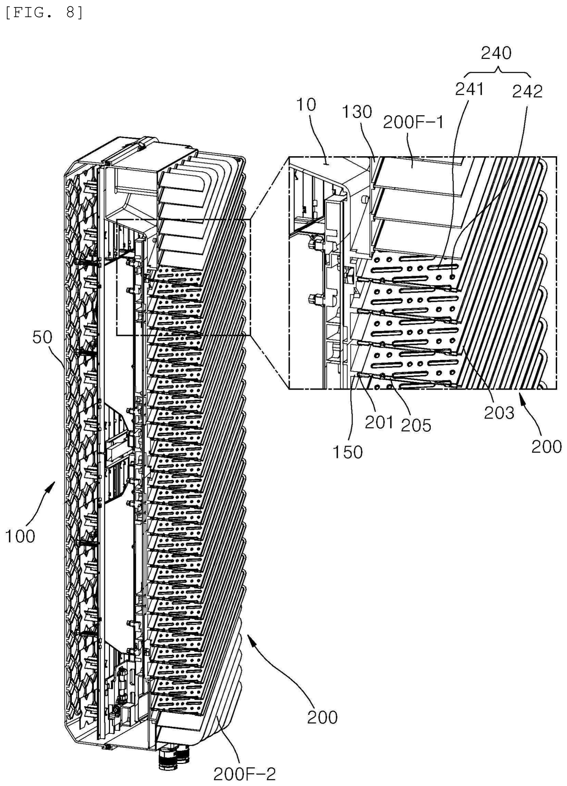

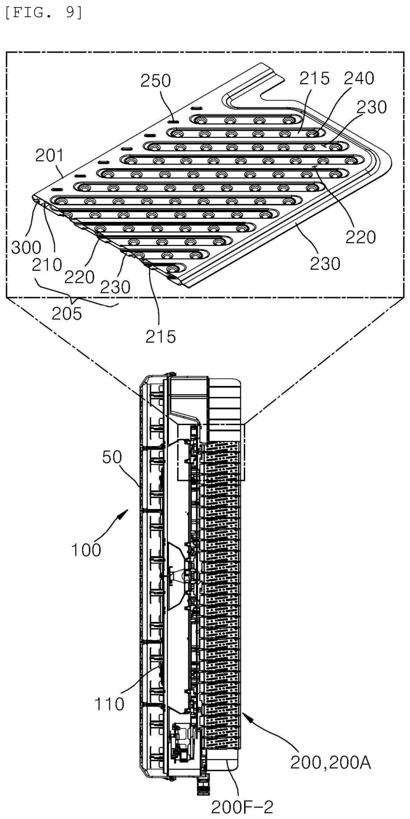

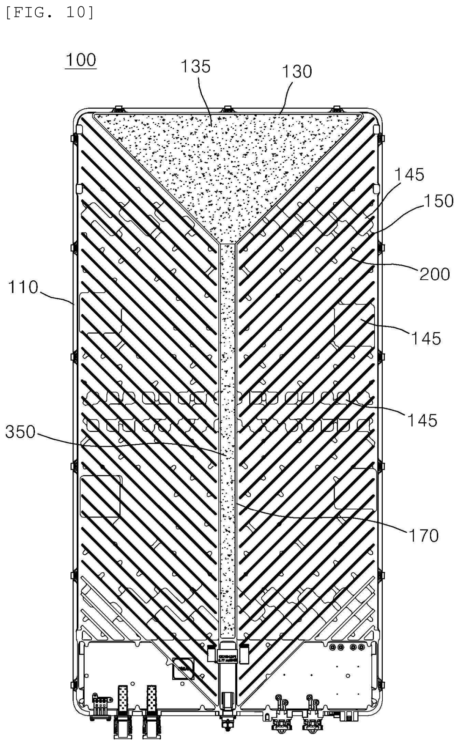

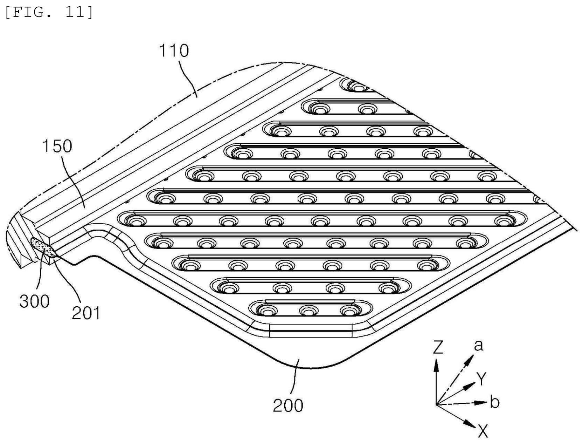

FIG. 6 is an exploded perspective view illustrating an installed state of the active heat dissipation apparatus according to the embodiment of the present disclosure with respect to a press-fitting portion formed on the rear portion of the antenna device in FIG. 5A, FIG. 7 is an exploded perspective view illustrating the installed state of the active heat dissipation apparatus according to the embodiment of the present disclosure with respect to the press-fitting portion formed on the rear portion of the antenna device in FIG. 6, FIG. 8 is a cross-sectional view and a partially enlarged view thereof illustrating the installed state of the active heat dissipation apparatus according to the embodiment of the present disclosure with respect to the press-fitting portion in FIG. 6, FIG. 9 is a cut-away perspective view and a partially enlarged view thereof illustrating the installed state of the active heat dissipation apparatus according to the embodiment of the present disclosure with respect to the press-fitting portion in FIG. 8, FIG. 10 is a cut-away perspective view illustrating an internal structure of the single active heat dissipation apparatus among the components in FIG. 8, FIG. 11 is a cross-sectional rear side view illustrating an internal structure for explaining a trench structure in FIGS. 4A and 5A, and FIG. 12 is a partial perspective view illustrating the installed state of the active heat dissipation apparatus according to the embodiment of the present disclosure with respect to the press-fitting portion among the components in FIGS. 4A and 5A.

With reference to FIGS. 4A and 5A, a trench structure 170 may be provided on a rear surface of the heat dissipation housing main body 110 implemented in a first installation embodiment, and the trench structure 170 may be an empty portion that vertically defines a central portion between left and right ends.

In this case, a plurality of press-fitting portions 150 may be provided on the rear surface of the heat dissipation housing main body 110 corresponding to two opposite left and right side portions of the trench structure 170, and the plurality of active heat dissipation apparatuses 200 according to the embodiment of the present disclosure is respectively disposed on the plurality of press-fitting portions 150 so as to be inclined upward toward the left and right ends. That is, the press-fitting portions 150 are inclined leftward and rightward based on the trench structure 170. The plurality of active heat dissipation apparatuses 200 fixed to the press-fitting portions 150 may be patterned and disposed in the vertical direction so that a pair of active heat dissipation apparatuses 200 defines a 'V' shape.

Meanwhile, all the plurality of active heat dissipation apparatuses 200 according to the embodiment of the present disclosure are the same rectangular standard elongated in the same longitudinal direction. With reference to FIG. 4A, in case that the active heat dissipation apparatuses 200 having the same standard are installed on the plurality of press-fitting portions 150, one point having an inversed triangular shape on an upper portion of the rear surface of the heat dissipation housing main body 110 and two points having a right-angled triangular shape at left and right sides of a lower portion of the rear surface of the heat dissipation housing main body 110 are not occupied by the active heat dissipation apparatuses 200, and the stationary heat dissipation fins 200F-1 and 200F-2 may be disposed at these points.

In this case, as illustrated in FIG. 4A, the stationary heat dissipation fins 200F-1 and 200F-2 may include upper stationary heat dissipation fins 200F-1 disposed at the upper side of the rear portion of the heat dissipation housing main body 110 that is not occupied by the active heat dissipation apparatus 200 according to the embodiment of the present disclosure, and lower stationary heat dissipation fins 200F-2 disposed at the lower sides of the left and right sides of the rear portion of the heat dissipation housing main body 110 that are not occupied by the active heat dissipation apparatus 200 according to the embodiments of the present disclosure.

Unlike the active heat dissipation apparatus 200 or 1200 according to the embodiments of the present disclosure, the stationary heat dissipation fins 200F-1 and 200F-2 are provided in the form of general heat dissipation fins that do not include the refrigerant therein. The stationary heat dissipation fins 200F-1 and 200F-2 may be made of an aluminum material or aluminum alloy material having excellent thermal conductivity among the metallic materials.

A heat transfer medium 135 provided as a general vapor chamber type may be provided in a region in which the trench structure 170 is provided on the rear surface of the heat dissipation housing main body 110 implemented in the first installation embodiment and a region (inverted triangular region) 130 in which the upper stationary heat dissipation fins 200F-1 are installed among the stationary heat dissipation fins 200F-1 and 200F-2.

An interior of the heat transfer medium 135 provided as a vapor chamber type may be filled with a predetermined refrigerant. That is, the heat transfer medium 135 of the vapor chamber type may be coupled, in an embedded manner, to the rear surface of the heat dissipation housing main body 110 so that the heat transfer medium 135 may be filled with the refrigerant.

Further, like the heat transfer medium 135 provided in the inverted triangular region 130, the region corresponding to the trench structure 170 may be filled with a predetermined refrigerant.

However, with reference to FIG. 5A, the trench structure 170 needs to be elongated in the vertical direction (gravitational direction) from a lower vertex of the inverted triangular region 130 provided on the rear surface of the heat dissipation housing main body 110, and the liquid refrigerant, with which the interior of the trench structure 170 is filled, needs to be retained to be uniformly dispersed in the vertical longitudinal direction.

To this end, a main body part absorber 350 may be further provided in the trench structure 170 so that the refrigerant may be uniformly and easily vaporized over an overall vertical length by heat transferred from the heat generation elements 140 or the inside of the heat dissipation housing main body 110, and a uniform amount of liquid refrigerant is retained regardless of vertical positions.

The main body part absorber 350 may be provided as any one of a non-woven fabric or a non-woven fabric coupled to an interior of a braided body made of a metallic material and any one of metal sintered bodies formed by sintering metallic powder. In case that the fiber material, such as a non-woven fabric, absorbs a liquid such as the liquid refrigerant, the fiber material, a load of the liquid makes it difficult to maintain the fiber material elongated in the vertical direction (gravitational direction). Therefore, the shape of the fiber material may be maintained by the braided body made of a copper wire material. A non-woven fabric may be coupled to the interior of the braided body made of a copper wire material or the braided body made of a copper wire material may spirally surround an outer peripheral surface of a non-woven fabric as long as the shape of the main body part absorber 350 may be maintained.

However, the main body part absorber 350 installed on the trench structure 170 may be interpreted as being identical in function to and performing the same function as the absorber 300 of the active heat dissipation apparatus 200 or 1200 according to the embodiments of the present disclosure to be described below in that the liquid refrigerant, with which the absorbers is filled, may flow to a position upward of a level of the liquid refrigerant defined naturally.

In this case, the heat transfer medium 135 and the trench structure 170 may be provided independently without communicating with each other.

In particular, on the rear surface of the heat dissipation housing main body 110, the liquid refrigerant, with which the interior of the trench structure 170 is filled, may perform partial heat dissipation by being changed in phases while being vaporized to a gaseous state by a change in temperature made by heat transferred from the heat generation elements 140 in a vaporization zone positioned on a relatively lower portion defined as the trench structure 170.

In addition, even in the inverted triangular region 130, i.e., a condensation zone positioned at a relatively upper portion and having the upper stationary heat dissipation fin 200F-1, the refrigerant may perform partial heat dissipation by being changed in phases while being vaporized from a liquid state to a gaseous state by the main body part absorber 350.

The gaseous refrigerant in a gaseous state vaporized in the trench structure 170 and the inverted triangular region 130 repeatedly performs a gas-liquid circulation that generates a phase change in which the refrigerant is liquefied to a liquid state by means of heat exchange with outside air, such that the refrigerant performs the partial heat dissipation function on the rear surface of the heat dissipation housing main body 110.

For reference, the refrigerant, with which a refrigerant flow space to be described below corresponding to the interior of the active heat dissipation apparatus 200 according to the embodiments of the present disclosure is filled, and the refrigerant, with which the inverted triangular region 130 and a trench coupling structure 170 are filled, are provided independently of each other. Therefore, the refrigerants with different specifications may be applied in accordance with the same specifications or the amount of heat generation and mounting positions of the heat generation elements 140.

Meanwhile, with reference to FIGS. 4A and 5A, the press-fitting portions 150 may be provided on the rear surface of the heat dissipation housing main body 110 implemented in the first installation embodiment so that the plurality of active heat dissipation apparatuses 200 according to the embodiment of the present disclosure is press-fitted and installed.

As described above, because the active heat dissipation apparatuses 200 according to the embodiment of the present disclosure implemented in the first installation embodiment are disposed to be inclined upward toward the left and right ends based on the trench structure 170, the plurality of press-fitting portions 150 may be provided and disposed to define a 'V' shape based on the trench structure 170.

That is, with reference to FIGS. 4A and 5A and FIGS. 6 to 11, the active heat dissipation apparatuses 200 according to the embodiment of the present disclosure may be press-fitted, by press-fitting, with the plurality of press-fitting portions 150 formed on the rear surface of the heat dissipation housing main body 110.

In this case, although not illustrated in the drawings, the active heat dissipation apparatus may be press-fitted with the press-fitting portion 150 after being subjected to a thermal epoxy treatment in order to improve the heat transfer efficiency.

In this case, with reference to FIG. 10, the press-fitting portion 150 may be recessed rearward from the front side so that heat generation surfaces of the heat generation elements 140 are accommodated on an inner surface corresponding to the rear side of the heat dissipation housing main body 110, or the press-fitting portion 150 may be disposed to pass one or more heat generation matching surfaces 145 protruding forward toward the heat generation surfaces of the heat generation elements 140.

In addition, with reference to FIG. 11, the press-fitting portion 150 may be formed to be inclined so that a rear end of a heat dissipation plate portion 203 to be described below is positioned above a press-fitting end 201 to be described below so that the refrigerant (particularly, the liquid refrigerant), with which the interior of the active heat dissipation apparatus 200 according to the embodiment of the present disclosure is filled, is easily captured downward in the gravitational direction by gravity.

More specifically, with reference to a coordinate plot in FIG. 11, as described above, because the left and right sides of the press-fitting portions 150 are formed to be inclined upward based on the trench structure 170, the press-fitting portions 150 may be formed in the rear portion of the heat dissipation housing main body 110 so as to be inclined at a predetermined angle (see arrow 'a') based on a coordinate Y expressed in a horizontal leftward/rightward direction.

In addition, with reference to a coordinate plot in FIG. 11, the press-fitting portion 150 may be formed so that the rear end of the active heat dissipation apparatus 200 according to the embodiment of the present disclosure installed to be press-fitted with the press-fitting portion 150 is inclined upward at a predetermined angle (see arrow 'b') based on a coordinate X.

Therefore, in case that the refrigerant, with which the refrigerant flow space of the active heat dissipation apparatus 200 according to the embodiment of the present disclosure is filled, is a refrigerant in a liquid state (liquid refrigerant), the refrigerant may naturally flow downward to the press-fitting end 201 positioned in the gravitational direction. In case that the refrigerant is a refrigerant in a gaseous state (gaseous refrigerant), the refrigerant may be naturally diffused from the press-fitting end 201 to the heat dissipation plate portion 203.

However, the press-fitting portion 150 need not necessarily be formed to be inclined at a predetermined angle (see arrows a and b in FIG. 11) based on the rear surface of the heat dissipation housing main body 110 as described above as long as a flow of the condensed liquid refrigerant is uniformly guided by a plurality of second refrigerant flow paths 220 or a plurality of inclined guides 215 that will be described below.

### 2-2. Second installation embodiment

With reference to FIGS. 4B and 5B, the plurality of active heat dissipation apparatuses 1200 according to another embodiment of the present disclosure may be disposed to be elongated straight in the vertical direction at a rear side of the heat dissipation housing main body 110 implemented in a second installation embodiment.

Therefore, the press-fitting portions 150, which are provided to couple the active heat dissipation apparatuses 1200 according to another embodiment of the present disclosure, may be disposed to be elongated straight in the vertical direction on the rear surface of the heat dissipation housing main body 110 implemented in the second installation embodiment, and the press-fitting portions 150 may be horizontally spaced apart from one another at predetermined distances in the leftward/rightward direction.

In this case, with reference to FIGS. 4A and 5A, the rear structure of the heat dissipation housing main body 110, which is implemented in the first installation embodiment, is a structure in which the plurality of active heat dissipation apparatuses 200 according to the embodiment of the present disclosure is arranged to be spaced apart from one another to define a 'V' shape based on the trench structure 170 in order to achieve the effect of uniformly dissipate heat leftward, rightward, and upward when the heat is generated from the heat generation elements 140 concentratedly disposed at the left and right sides based on the central portion in a leftward/rightward width direction. In contrast, with reference to FIGS. 4B and 5B, on the rear portion of the heat dissipation housing main body 110 implemented in the second installation embodiment, the plurality of active heat dissipation apparatuses 1200 according to another embodiment of the present disclosure is disposed to be elongated in the vertical direction and designed, such that an upward flow of hot air made by heat dissipation is not immediately upward subjected to flow resistance.

Hereinafter, for convenience of description, the active heat dissipation apparatus 200 installed on the rear surface of the heat dissipation housing main body 110 implemented in the first installation embodiment is defined as 'the active heat dissipation apparatus 200 according to the embodiment of the present disclosure' and described, and the active heat dissipation apparatus 1200 installed on the rear surface of the heat dissipation housing main body 110 implemented in the second installation embodiment is defined as 'the active heat dissipation apparatus 1200 according to another embodiment of the present disclosure' and described. However, because the embodiments 200 or 1200 are merely different from each other in the external shapes and installed states, the embodiments 200 and 1200 may be installed interchangeably regardless of the above-mentioned installation embodiments.

### 3. First refrigerant flow path (comprehensive flow path) and second refrigerant flow path (liquid refrigerant guide flow path)

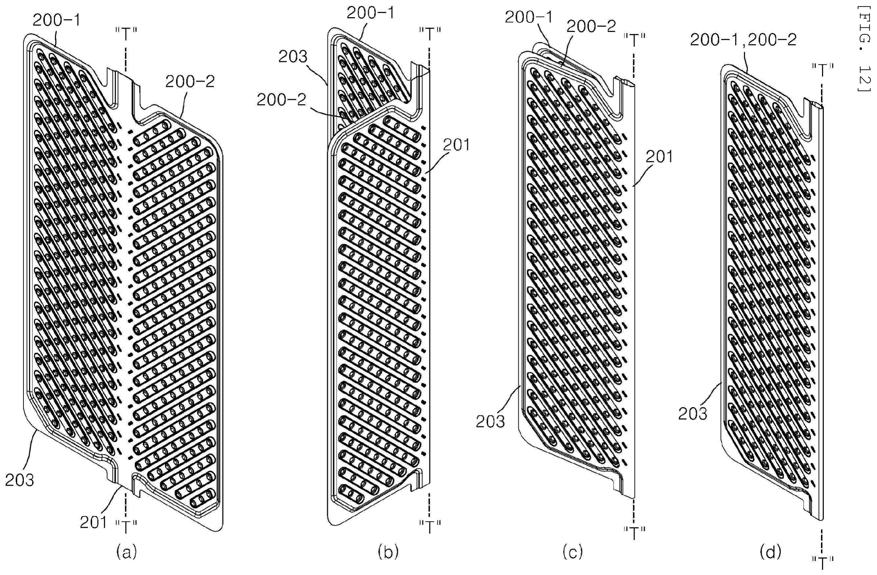

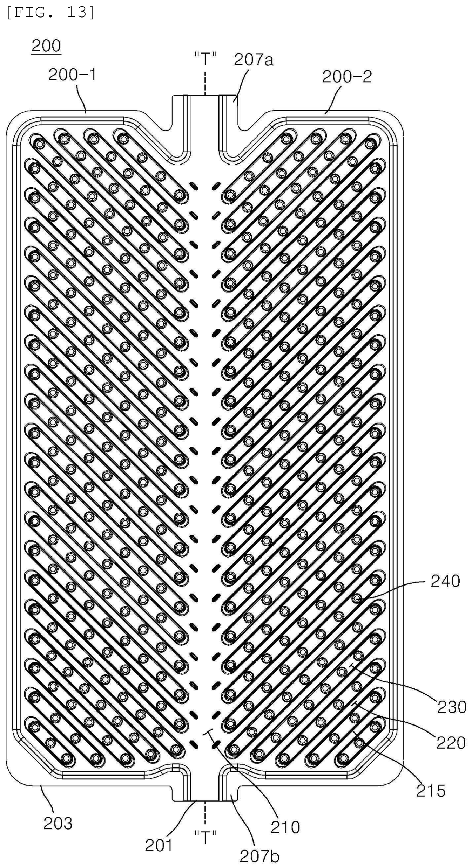

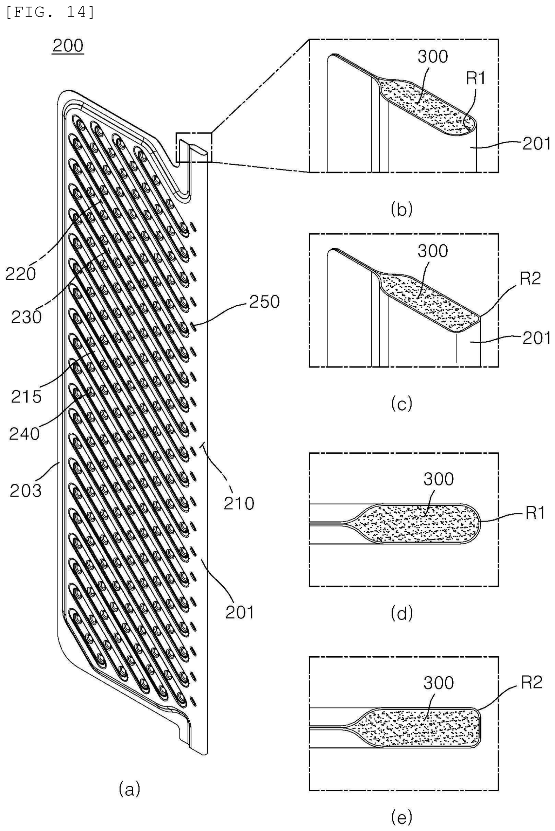

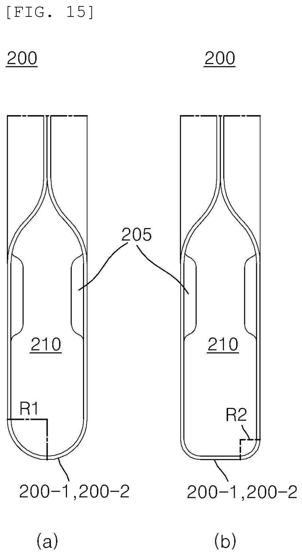

FIG. 12 is a perspective view illustrating a process of manufacturing the active heat dissipation apparatus according to the embodiment of the present disclosure, FIG. 13 is a top plan view illustrating a thermal conduction panel body in a state made before the thermal conduction panel body is bent among the components of the active heat dissipation apparatus according to the embodiment of the present disclosure illustrated in FIG. 12, FIG. 14 is an enlarged perspective view and an enlarged top plan view illustrating a press-fitting end and a modified example thereof among the components of the active heat dissipation apparatus according to the embodiment of the present disclosure, and FIG. 15 is a cross-sectional view illustrating a state in which the absorber 300 is excluded among the components in FIG. 14D and 14E.

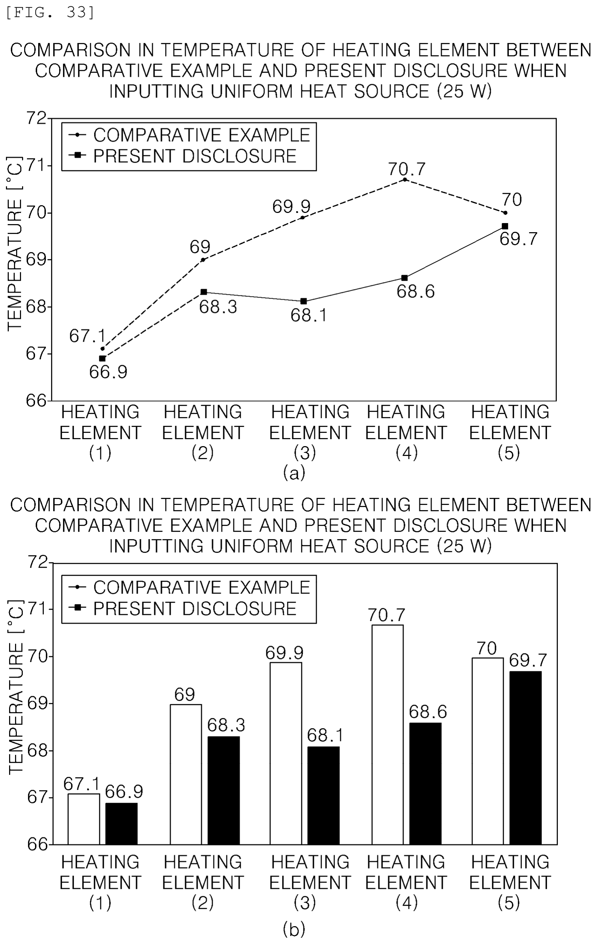

As illustrated in FIGS. 12 to 15, the active heat dissipation apparatus 200 according to the embodiment of the present disclosure includes thermal conduction panel bodies 200-1 and 200-2 that constitute a single metal panel member and have refrigerant flow spaces provided by a bending process S20 and a joining process S40 (see FIG. 33 to be described below) so that the refrigerant is stored and flows in the refrigerant flow spaces.

That is, the active heat dissipation apparatus 200 according to the embodiment of the present disclosure may be manufactured by bending the thermal conduction panel bodies 200-1 and 200-2, which constitute a single metal panel member, about a predetermined arbitrary reference line T illustrated in FIG. 10 (the bending process S20) and joining (bonding) the thermal conduction panel bodies 200-1 and 200-2 (the joining process S40) so that sealed refrigerant flow spaces 205 are formed therein.

That is, the refrigerant flow spaces 205 of the thermal conduction panel bodies 200-1 and 200-2, which constitute the single metal panel member, may be formed in a predetermined way. In particular, in the active heat dissipation apparatus 200 according to the embodiment of the present disclosure, a first refrigerant flow path 210 to be described below may be at least directly formed among the refrigerant flow spaces 205, in which the refrigerant is stored and flows, by the bending process (including the bending process S20 and the joining process S40 that will be described below) among the predetermined methods.

In this case, the refrigerant flow spaces 205 may be provided at portions positioned at a relatively lower side based on a relatively gravitational direction so that the liquid refrigerant is easily captured (retained) or stored. The refrigerant flow spaces 205 may include the first refrigerant flow path 210 configured to define a vaporization zone in which the liquid refrigerant is changed in phase to the gaseous refrigerant, and second refrigerant flow paths 220 provided in a condensation zone, which is a portion other than the first refrigerant flow path 210, and configured to guide the flow of the liquid refrigerant, which has been changed in phase to the gaseous refrigerant, to the vaporization zone.

That is, when a portion where the first refrigerant flow path 210 is provided, i.e., a portion formed by the bending process (the bending process S20) is defined as the vaporization zone in which the liquid refrigerant in the refrigerant is vaporized and a portion other than the vaporization zone is defined as the condensation zone, the second refrigerant flow paths 220 may be provided in the condensation zone.

In particular, the first refrigerant flow path 210 is a portion made by deforming a shape of the single metal panel member by the bending process among the predetermined methods. The first refrigerant flow path 210 is formed to be spaced apart from the heat generation element 140 or the press-fitting portion 150, on which the heat generation element 140 is provided, at a spacing distance corresponding to a material thickness of the metal panel member so that the liquid refrigerant in the refrigerant is stored in the first refrigerant flow path 210.

In this case, the first refrigerant flow path 210 is a portion where the liquid refrigerant in the refrigerant stored in the refrigerant flow spaces 205 is stored and retained, and the first refrigerant flow path 210 may be disposed vertically in the upward/downward direction in the gravitational direction or have upper and lower ends inclined with respect to the gravitational direction. Therefore, a refrigerant surface of the liquid refrigerant stored in the first refrigerant flow path 210 is positioned at least adjacent to the lower end between the upper and lower ends disposed to be inclined. This principle is applied to the active heat dissipation apparatus 1200 according to another embodiment of the present disclosure in the same way.

More specifically, the active heat dissipation apparatus 200 according to the embodiment of the present disclosure may be manufactured by bending the thermal conduction panel bodies 200-1 and 200-2, which constitute the single metal panel member, about the predetermined arbitrary reference line T (see FIG. 12 in detail) (the bending process S20) and then joining the thermal conduction panel bodies 200-1 and 200-2 (the joining process S40) so that the sealed refrigerant flow spaces 205 are formed therein.

Therefore, the first refrigerant flow path 210 is a portion deformed in shape by the bending process (the bending process S20). The first refrigerant flow path 210 may be defined as a refrigerant storage/flow space spaced apart from the heat generation element 140 or the press-fitting portion 150, on which the heat generation element 140 are provided, at the spacing distance corresponding to the material thickness of the metal panel member so that the liquid refrigerant in the refrigerant is stored in the first refrigerant flow path 210.

However, the first refrigerant flow path 210 of the active heat dissipation apparatus 200 according to the embodiment of the present disclosure is defined to be different from a first refrigerant flow path 1210 of the active heat dissipation apparatus 1200 according to another embodiment of the present disclosure to be described below. In this case, it will be appropriated that the first refrigerant flow path 210 includes a common technical component as a vaporization zone, which is one widthwise end of the thermal conduction panel bodies 200-1 and 200-2 that receives heat from the heat generation element 140, i.e., the heat dissipation target or the press-fitting end 201 installed by being inserted directly into the press-fitting portion 150.

For example, the active heat dissipation apparatus according to the present disclosure is not necessarily limited to the manufacturing method of the embodiment 200 using the bending process.

That is, the active heat dissipation apparatus 1200 according to another embodiment of the present disclosure may be manufactured by forming the sealed refrigerant flow spaces 205 therein by joining two separated metal panel members by using a joining process (the joining process S40), as illustrated in FIGS. 4B and 5B and FIGS. 23 to 29 to be described below.

As described above, the first refrigerant flow path 1210 of the active heat dissipation apparatus 1200 according to another embodiment of the present disclosure, which is manufactured by the joining process, is different from that of the active heat dissipation apparatus 200 according to the embodiment of the present disclosure. This is because the position or arrangement characteristics, which are based on the spacing distance corresponding to the material thickness, cannot be applied to the active heat dissipation apparatus 1200 according to another embodiment of the present disclosure in an intact manner. Hereinafter, specific features of the active heat dissipation apparatus 1200 according to another embodiment of the present disclosure will be described below more specifically.

Meanwhile, the plurality of second refrigerant flow paths 220 is formed in the condensation zone excluding the first refrigerant flow path 210. The second refrigerant flow path 220 may serve as a flow path through which the liquid refrigerant in the refrigerant, which is condensed into the liquid state from the gaseous state, flows from the other widthwise end of the thermal conduction panel bodies 200-1 and 200-2 toward the first refrigerant flow path 210 by surface tension or gravity.

More specifically, the second refrigerant flow path 220 provides a flow path through the liquid refrigerant, which is condensed by heat exchange between the gaseous refrigerant and outside air in the condensation zone and gradually increases in volume at the position in the refrigerant flow space 205 in which the refrigerant is condensed, flows downward in uniform amount toward the first refrigerant flow path 210 when the liquid refrigerant flows downward in the gravitational direction.

In particular, as described below, the second refrigerant flow paths 220 may be defined between the plurality of inclined guides 215. A dispersion flow toward the second refrigerant flow path 220 adjacent to the second refrigerant flow path 220, i.e., a self-flow path may be suppressed by surface tension when the liquid refrigerant condensed in the condensation zone flows downward toward the first refrigerant flow path 210.

That is, because the plurality of inclined guides 215 each have a narrower flow space than the second refrigerant flow path 220, the flow toward the adjacent second refrigerant flow path 220 is suppressed by the applied surface tension.

As described above, when the dispersion flow of the liquid refrigerant, which is condensed by the plurality of inclined guides 215 and the second refrigerant flow paths 220, is suppressed, it is eventually possible to minimize the fall of the liquid refrigerant immediately downward in the gravitational direction, such that the liquid refrigerant condensed in the condensation zone may be supplied in uniform amount toward the first refrigerant flow path 210 without being concentrated at the lower ends connected to the first refrigerant flow path 210 at uniform intervals.

Further, the plurality of second refrigerant flow paths 220 may be defined between the plurality of inclined guides 215 protruding into the refrigerant flow spaces 205 from the surfaces of the thermal conduction panel bodies 200-1 and 200-2 that face each other.

With reference to FIG. 12A, in the active heat dissipation apparatus 200 according to the embodiment of the present disclosure, the first refrigerant flow path 210, the second refrigerant flow paths 220, and the plurality of inclined guides 215, which will be described below and configured to implement the first refrigerant flow path 210 and the second refrigerant flow paths 220, may be simultaneously formed by performing a pressing process S10 on the thermal conduction panel bodies 200-1 and 200-2, which constitute a single member made of a predetermined thermally conductive material, prior to the bending process S20 to be described below.

In this case, in case that the thermal conduction panel bodies 200-1 and 200-2, which are unfolded flat before the bending process S20, are formed in a rectangular shape having a width in the leftward/rightward direction that is smaller in size than a length in the vertical direction based on FIG. 12, the arbitrary reference line T may be disposed to traverse a central portion between the left and right ends in the vertical direction, and the arbitrary reference line T may be a criterion for the bending process S20 (see FIG. 12B and 12C) to be described below.

In this case, the central portion between the left and right ends of the thermal conduction panel bodies 200-1 and 200-2 may be understood as a central portion, i.e., a boundary between one side thermal conduction panel 200-1 and the other side thermal conduction panel 200-2.

With reference to FIG. 12B and 12C, one side thermal conduction panel 200-1, which corresponds to the left side based on the arbitrary reference line T, and the other side thermal conduction panel 200-2, which corresponds to the right side based on the arbitrary reference line T, may be bent by a non-illustrated bending jig so as to be joined to each other.

In this case, third refrigerant flow paths 230 according to the embodiment may be additionally formed in addition to the first refrigerant flow path 210 and the second refrigerant flow paths 220. A plurality of strength reinforcement portions 240, which is required for a joining process S40 (see FIG. 12D) to be described below, may be formed to be in surface contact with each other while facing each other.

With reference to FIG. 12D, when one side thermal conduction panel 200-1 and the other side thermal conduction panel 200-2 of the thermal conduction panel bodies 200-1 and 200-2 are in surface contact with each other, one side thermal conduction panel 200-1 and the other side thermal conduction panel 200-2 may be joined to each other along rim ends thereof by using a predetermined joining method, and one side thermal conduction panel 200-1 and the other side thermal conduction panel 200-2 may be joined to each other by using the predetermined joining method with respect to the plurality of strength reinforcement portions 240 being in surface contact with each other.

In this case, one end and the other end of the first refrigerant flow path 210 may be formed by the bending process S20 so that the refrigerant flow spaces 205 communicate with the outside in order to ensure a refrigerant filling process and a caulking process. The remaining portion (the heat dissipation plate portion 203) may be sealed and coupled so that the refrigerant flow space 205 is completely blocked from the outside.

More specifically, as illustrated in FIG. 12, in the active heat dissipation apparatus 200 according to the embodiment of the present disclosure, based on the arbitrary reference line T defined in a straight shape in the vertical direction, the thermal conduction panel bodies 200-1 and 200-2 includes one side thermal conduction panel 200-1 configured to define the left end before the bending process S20, and the other side thermal conduction panel 200-2 configured to define the right end before the bending process S20. In this case, one side thermal conduction panel 200-1 and the other side thermal conduction panel 200-2 only need to be understood as defining the thermal conduction panel bodies 200-1 and 200-2 before the bending process S20.

However, the thermal conduction panel bodies 200-1 and 200-2 may be defined again as configurations after the bending process S20 to be described below.

For example, the thermal conduction panel bodies 200-1 and 200-2 are portions formed by the bending process S20 and the joining process S40 to be described below. The thermal conduction panel bodies 200-1 and 200-2 may be defined as including the press-fitting end 201 press-fitted with the press-fitting portion 150 formed to be inclined upward toward the left and right sides based on the trench structure 170 formed in the rear surface of the heat dissipation housing main body 110, i.e., the heat dissipation target, and the heat dissipation plate portion 203 that is a portion defined by the rim ends of the thermal conduction panel bodies 200-1 and 200-2, except for the press-fitting end 201, and configured to dissipate heat by means of the phase change of the refrigerant and the heat exchange with outside air.

That is, the heat dissipation plate portion 203 may be defined as a portion excluding the press-fitting end 201, i.e., defined as an entire region that performs heat dissipation after performing heat exchange between the refrigerant (particularly, the gaseous refrigerant), which is stored therein, and outside air. The configuration in which the gaseous refrigerant in the heat dissipation plate portion 203 exchanges heat with outside air means that the gaseous refrigerant is condensed and changed in phase into the liquid refrigerant.

Meanwhile, the plurality of strength reinforcement portions 240 may be formed on the heat dissipation plate portion 203 and protrude toward the refrigerant flow spaces 205 from an inner surface of one side thermal conduction panel 200-1 and an inner surface of the other side thermal conduction panel 200-2 spaced apart from each other in the thickness direction.

Further, as described below, the plurality of strength reinforcement portions 240 is simultaneously formed together with the second refrigerant flow paths 220, the third refrigerant flow paths 230, and the plurality of inclined guides 215 by the pressing process S10. It should be noted that the plurality of strength reinforcement portions 240 is formed to be recessed inward from the outside of the heat dissipation plate portion 203 when observed from the outside after the bending process S20 and the joining process S40.

The first refrigerant flow path 210 is positioned at the lower side based on the gravitational direction. The first refrigerant flow path 210 may be defined as a flow path that captures the refrigerant, which is mainly changed in phase into the liquid refrigerant in the refrigerant flow spaces 205 and flows downward in the gravitational direction, on the same inclined guides 215 and simultaneously and uniformly moves and disperses the liquid refrigerant over the entire vaporization zone in which the refrigerant is changed into the gaseous refrigerant by heat transferred from the heat generation elements 140 of the heat dissipation housing main body 110. In this case, among the functions of the first refrigerant flow path 210, the uniform movement and dispersion of the liquid refrigerant may be a concept that means that the liquid refrigerant is moved in a direction at least different from the gravitational direction by the absorber 300.

In addition, among the functions of the first refrigerant flow path 210, the uniform movement and dispersion of the liquid refrigerant only needs to be understood as a concept that means that the liquid refrigerant is uniformly distributed, supplied, and transmitted by the plurality of second refrigerant flow paths 220 or the plurality of inclined guides 215 formed to be inclined with respect to the single first refrigerant flow path 210. This configuration will be described more specifically with reference to the description of the absorber 300.

The absorber 300 to be described below is inserted and installed into the first refrigerant flow path 210, which makes it easy to capture and disperse the liquid refrigerant and transmit the liquid refrigerant in a direction different from the gravitational direction.

In this case, with reference to FIG. 13, the first refrigerant flow path 210 may be formed to be symmetric in the thickness direction of the refrigerant flow space 205 based on the arbitrary reference line T after the bending process S20. Therefore, the first refrigerant flow path 210 may be newly defined as a flow path including the arbitrary reference line T that is a criterion for the bending process S20.

### 4. First refrigerant flow path, press-fitting end, second refrigerant flow path, and heat dissipation plate portion

As described above, with reference to FIGS. 14 to 16, in the thermal conduction panel bodies 200-1 and 200-2, one side thermal conduction panel 200-1 and the other side thermal conduction panel 200-2 are bent about the arbitrary reference line T, such that the first refrigerant flow path 210 is formed therein, and the press-fitting end 201 is formed on the outer portion thereof and configured to be coupled to the press-fitting portion 150 formed in the rear surface of the heat dissipation housing main body 110, i.e., the heat dissipation target.

In addition, as described above, the thermal conduction panel bodies 200-1 and 200-2 may further include the heat dissipation plate portion 203 defined as the remaining portion excluding the press-fitting end 201.

The heat dissipation plate portion 203 may seal the refrigerant flow spaces 205 as the rim ends of one side thermal conduction panel 200-1 and the other side thermal conduction panel 200-2 are joined to each other by the predetermined joining method after the bending process S20.

In this case, the predetermined joining method may be any one of a welding coupling method and a bonding coupling method. Particularly, the laser welding method may be adopted among the welding coupling methods. However, the laser welding method does not necessarily need to be adopted. Any joining method may be adopted within a range in which the sealability is implemented to prevent a leak of the refrigerant stored therein.

Meanwhile, as illustrated in FIGS. 14 and 15, an end of the press-fitting end 201, which is configured to be inserted into the press-fitting portion 150, may be formed to be bent so as to include any one of a round cross-section (see FIGS. 14B, 14D, and 15A) and a flat cross-section (see FIGS. 14C, 14E, and 15B).

More specifically, as illustrated in FIGS. 14B, 14D, and 15A, the press-fitting end 201 may be formed to have a rounded cross-section with a semi-circular shape having a radius of a value of R1, or as illustrated in FIGS. 14C, 14E, and 15B, the press-fitting end 201 may be formed to have an edge end having a rounded cross-section with a radius smaller than R1 and have the remaining portion having a flat end.

The press-fitting end 201 implemented to have a value of R1 (see FIG. 15A) may be formed by the single bending process S20, which provides an advantage in terms of the process. In contrast, the press-fitting end 201 is disadvantageous in that an occupation volume of the first refrigerant flow path 210 with respect to the press-fitting portion 150 is relatively small.

On the contrary, the press-fitting end 201 implemented to have a value of R2 (see FIG. 15B) is formed by performing the bending process S20 twice, which causes a disadvantage in terms of the process. In contrast, the press-fitting end 201 is advantageous in that the occupation volume of the first refrigerant flow path 210 with respect to the press-fitting portion 150 is relatively large.

In this case, an outer surface of the press-fitting end 201 may be installed to be press-fitted, after being subjected to a thermal epoxy treatment, into the press-fitting portion 150 formed in the rear portion of the heat dissipation housing main body 110.

In addition, in case that the press-fitting end 201 is inserted into the press-fitting portion 150, at least a part of the first refrigerant flow path 210 may be introduced into a tip of the press-fitting portion 150. The structure of the active heat dissipation apparatus 200 according to the embodiment of the present disclosure and the structure of the active heat dissipation apparatus 1200 according to another embodiment of the present disclosure, which are installed on the press-fitting portion 150, will be described below more specifically.

Meanwhile, as illustrated in FIGS. 12 to 15, the plurality of second refrigerant flow paths 220 serves to guide the refrigerant so that the refrigerant, which is changed in phase into the gaseous refrigerant, flows toward the heat dissipation plate portion 203, exchanges heat with outside air, and then is condensed into the liquid refrigerant, naturally flows downward toward the first refrigerant flow path 210.

More specifically, as illustrated in FIGS. 12 to 15, the second refrigerant flow paths 220 may be defined as spaces between the plurality of inclined guides 215 provided in the condensation zone provided in a portion other than the first refrigerant flow path 210 and configured to guide the flow of the liquid refrigerant, which is changed in phase from the gaseous state to the liquid state, to the vaporization zone.

In this case, as illustrated in FIG. 13, the plurality of inclined guides 215, which defines the second refrigerant flow paths 220, may protrude toward the refrigerant flow spaces 205 from the inner surface of one side thermal conduction panel 200-1 and the inner surface of the other side thermal conduction panel 200-2 after the bending process S20 to be described below.

The plurality of inclined guides 215 may have a straight shape inclined downward toward the first refrigerant flow path 210 in the gravitational direction. Therefore, the liquid refrigerant, which is condensed on the heat dissipation plate portion 203, may be naturally condensed and then flow downward toward the first refrigerant flow path 210 along the portions between the plurality of inclined guides 215 inclined downward, thereby increasing a circulation speed of the liquid refrigerant.

In this case, the plurality of second refrigerant flow paths 220 or the plurality of inclined guides 215 may be disposed so that the adjacent second refrigerant flow paths 220 and the inclined guides 215 are parallel to one another. A flow of the liquid refrigerant, which is condensed in the condensation zone having a larger area than the vaporization zone approximately limited by the first refrigerant flow path 210, may be dispersed by the second refrigerant flow paths 220 or the inclined guides 215 arranged densely and uniformly parallelly, which may implement uniform heat dissipation performance and dissipate heat through the entire condensation zone.

In addition, the plurality of inclined guides 215 may be formed on one side thermal conduction panel 200-1 and the other side thermal conduction panel 200-2, and the tip portions protruding toward the refrigerant flow spaces 205 may be spaced apart from one another without being joined in the refrigerant flow spaces 205.

As described above, because the second refrigerant flow path 220 serves to guide the flow of the liquid refrigerant in the gravitational direction, the second refrigerant flow path 220 may have the size in the thickness direction so that the flow may be naturally formed in the gravitational direction without being stopped by surface tension, i.e., inherent characteristics of the liquid. In addition, the second refrigerant flow path 220 may be formed so that the dispersion flow toward the adjacent second refrigerant flow path 220 is suppressed by surface tension or gravity after the liquid refrigerant is condensed to a predetermined magnitude or larger.

Further, at least any one of one end and the other end of each of the plurality of second refrigerant flow paths 220 or the plurality of inclined guides 215 is connected to the vaporization zone or the first refrigerant flow path 210 formed in the vaporization zone. The end (i.e., any one of one end and the other end), which is connected to the vaporization zone or the first refrigerant flow path 210 formed in the vaporization zone, is positioned relatively below the other of one end and the other end in the gravitational direction.

Therefore, when at least any one of one end and the other end of each of the plurality of second refrigerant flow paths 220 is defined as 'one end', one end may have the same meaning as a 'lower end' positioned at a lower side based on the gravitational direction. On the contrary, when the other of one end and the other end of each of the plurality of second refrigerant flow paths 220 is defined as 'the other end', and the other end may have the same meaning as an 'upper end' positioned at an upper side based on the gravitational direction.

Further, as described above, at least any one of one end and the other end of each of the plurality of second refrigerant flow paths 220 or the plurality of inclined guides 215 may be formed to be connected to the first refrigerant flow path 210, and one end and the other end are connected straight.

According to the straight shape of the plurality of second refrigerant flow paths 220 described above, it is possible to minimize a distance between one end of the first refrigerant flow path 210, which is positioned to be closest to the heat generation element 140 and receives heat, and the other end that is an outermost peripheral end of the condensation zone in which the condensation is actively performed by heat exchange with outside air. It can be seen that the straight shape of the second refrigerant flow path 220 is an optimal shape capable of minimizing overlap lengths (flow resistance lengths) of a flow channel for the liquid refrigerant and a flow channel for the gaseous refrigerant.

For example, although not illustrated in the drawings, the description will be briefly described below, focusing on a difference between the second refrigerant flow path 220 having the straight shape and a case in which the second refrigerant flow path 220 has a honeycomb structure in consideration of the assurance of the heat dissipation area of the condensation zone corresponding to the heat dissipation plate portion 203.

That is, in case that the second refrigerant flow path 220 has a honeycomb structure, it is difficult to expect an active gas-liquid circulation because flow resistance, which suppresses a straight flow toward the other end of the heat dissipation plate portion 203 corresponding to a minimum distance, is applied when the liquid refrigerant changes in phase into the gaseous refrigerant by receiving heat in the vaporization zone corresponding to the press-fitting end 201 and then flows by being diffused toward the outer end.

In contrast, the active heat dissipation apparatus 200 according to the embodiment of the present disclosure has a difference in that the active heat dissipation apparatus 200 adopts a straight structure in which the gas-liquid circulation is smoothly performed from the first refrigerant flow path 210 (i.e., one widthwise end) to outer end (i.e., the other widthwise end), i.e., the end of the condensation zone without separate flow resistance, and adopts a gas-liquid flow separation structure to be described below.

That is, in the active heat dissipation apparatus 200 according to the embodiment of the present disclosure, the second refrigerant flow path 220 differs from the honeycomb structure in that the plurality of second refrigerant flow paths 220 is formed so as not to branch off from the other widthwise end toward one widthwise end, i.e., the first refrigerant flow path 210 positioned at the relatively lower side in the gravitational direction in order to guide the flow of the liquid refrigerant, which is changed in phase from the gaseous refrigerant, in the refrigerant flow spaces 205.

It can be ascertained that this provides a heat dissipation mechanism completely different from the honeycomb structure in which the RBFHP in the 'preceding literature' already introduced in the 'Background' section is provided in the form of a flow channel for a refrigerant.

That is, in the case of the RBFHP in the preceding literature, rim ends of two material sheets are joined and processed by a roll bonding method, and thus there is a concern about deterioration in thermal flow rate caused by thermal resistance of the material by a length of the rim ends, i.e., junction portions so that the liquid refrigerant initially receives heat substantially transferred from the heat generation element even though the interior is at least filled with the refrigerant. Because the flow channel is lengthened by the honeycomb structure toward the outer end after the liquid refrigerant is converted into the gaseous refrigerant by receiving heat, it is difficult to expect the active gas-liquid circulation because resistance occurs against the flow in a direction opposite to the condensed liquid refrigerant.

In contrast, in the case of the active heat dissipation apparatus 200 according to the embodiment of the present disclosure, the first refrigerant flow path 210, in which the liquid refrigerant is stored, is positioned adjacent to and spaced apart from the heat generation element 140 or the press-fitting portion 150, on which the heat generation element 140 is provided, by the thickness of the thermal conduction panel bodies 200-1 and 200-2 by performing the bending process S20 on the single metal panel member. Therefore, it is possible to implement a completely different heat dissipation mechanism by applying the gas-liquid flow separation structure and the straight structure in which the gas-liquid circulation is smoothly performed from the first refrigerant flow path 210 (i.e., one widthwise end) to the outer end (i.e., the other widthwise end), i.e., the end of the condensation zone without separate flow resistance.

That is, the plurality of second refrigerant flow paths 220 is formed so as not to branch off from the other widthwise end toward one widthwise end, i.e., the first refrigerant flow path 210 positioned at the relatively lower side in the gravitational direction in order to guide the flow of the liquid refrigerant, which is changed in phase from the gaseous refrigerant, in the refrigerant flow spaces.

Meanwhile, as described above, the plurality of inclined guides 215 may not only serve to define the second refrigerant flow paths 220 disposed between the inclined guides 215 and configured as flow paths for guiding the flow of the liquid refrigerant in the gravitational direction, but also serve to define the third refrigerant flow paths 230, to be described below, corresponding to the spacing portions in the thickness direction.

In this case, on the premise that the first refrigerant flow path 210 is positioned at the relatively lower side in the gravitational direction by tilting the entire heat dissipation housing main body 110, the plurality of inclined guides 215 may be patterned to be inclined with respect to the first refrigerant flow path 210 to define a flow path through which the liquid refrigerant flows.

In this case, the second refrigerant flow paths 220 defined as adjacent spaces between the plurality of inclined guides 215 may be refrigerant flow paths extending to be inclined upward toward the widthwise ends of the thermal conduction panel bodies 200-1 and 200-2 from the first refrigerant flow path 210 corresponding to the arbitrary reference line T. This is to allow the liquid refrigerant, which is liquefied in the heat dissipation plate portion 203, to be easily moved, by the weight thereof, toward the first refrigerant flow path 210 in which the absorber 300 is provided.

### 5. Third refrigerant flow path

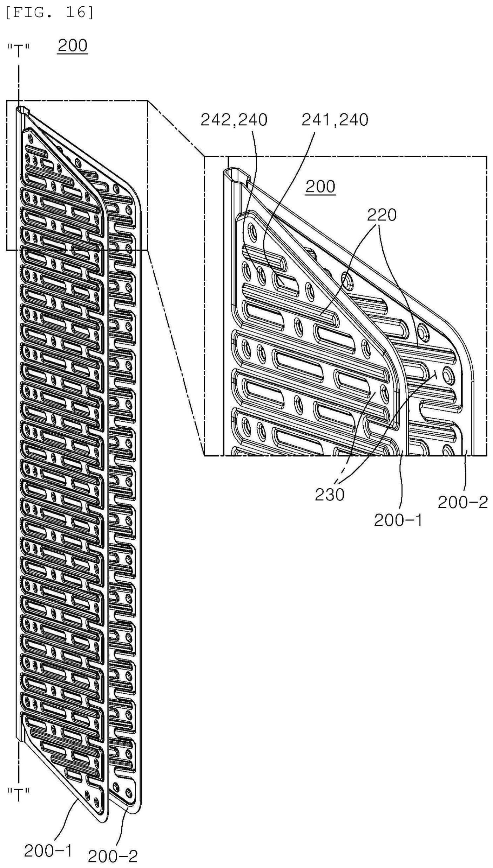

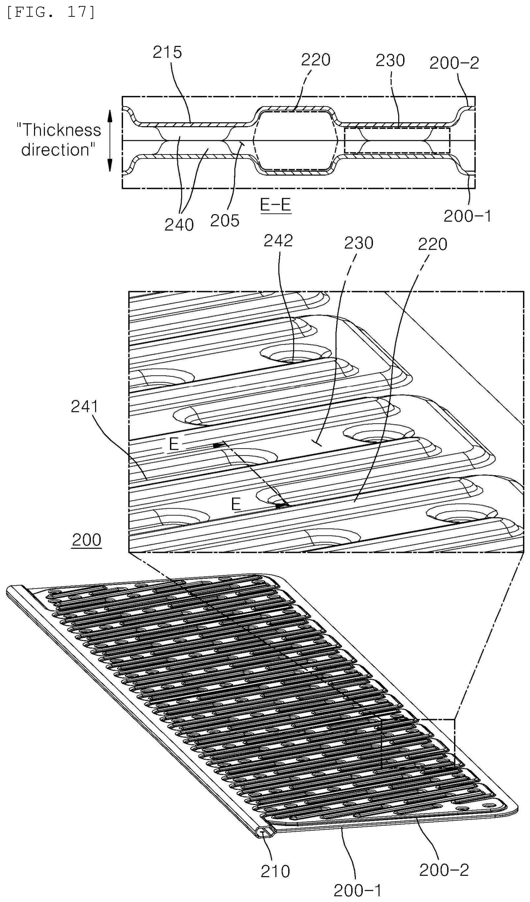

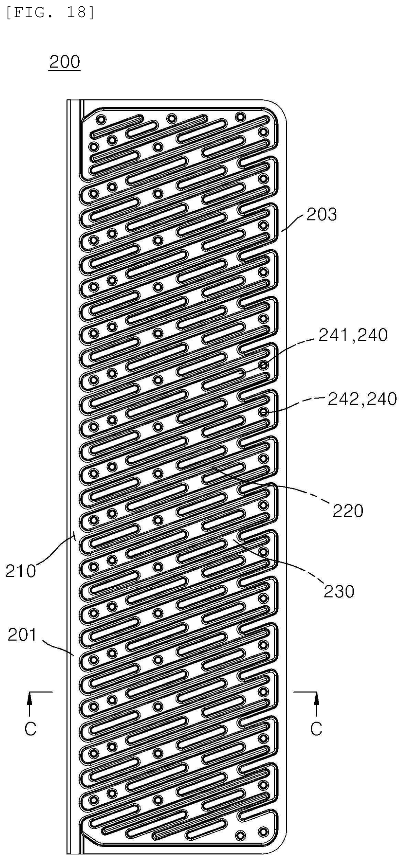

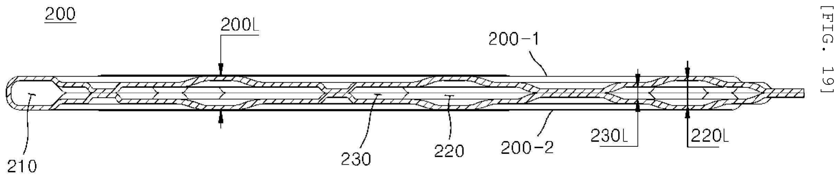

FIGS. 16 and 17 are a perspective view and a partially enlarged view thereof illustrating states made before and after the active heat dissipation apparatus according to the embodiment of the present disclosure is bent, FIG. 18 is a top plan view illustrating a state made after the active heat dissipation apparatus according to the embodiment of the present disclosure is bent, and FIG. 19 is a cross-sectional view taken along line C-C in FIG. 18.

As illustrated in FIGS. 16 to 19, the active heat dissipation apparatus 200 according to the embodiment of the present disclosure may further include the third refrigerant flow paths 230.

In this case, when the bending process S20 and the joining process S40 are completely performed on the thermal conduction panel bodies 200-1 and 200-2, the refrigerant flow spaces 205 are defined as any one surface of one side thermal conduction panel 200-1 and a part of any one surface of the other side thermal conduction panel 200-2 are joined to each other based on the arbitrary reference line T. The refrigerant flow spaces 205 may define the first refrigerant flow path 210 and the second refrigerant flow paths 220 and the third refrigerant flow paths 230 added according to the embodiment simultaneously with the joining process S40.

With reference to the cross-sectional view taken along line E-E in FIG. 17, the second refrigerant flow paths 220 are formed on one side thermal conduction panel 200-1 and the other side thermal conduction panel 200-2 and defined between the plurality of adjacent inclined guides 215, except for the thickness direction of the refrigerant flow spaces 205. In contrast, the third refrigerant flow path 230 may be defined as a space between the inclined guide 215 formed in one side thermal conduction panel 200-1 and the inclined guide 215 formed in the other side thermal conduction panel 200-2 in the thickness direction of the refrigerant flow spaces 205. However, it is noted that the configuration in which the second refrigerant flow path 220 is defined except for the thickness direction means that the direction, which is a criterion for the definition, is not the thickness direction but should not be interpreted as excluding the corresponding volume and a volume occupied by space in the thickness direction.

More specifically, in case that the inclined guide 215 further protrudes toward the refrigerant flow space 205 than the second refrigerant flow path 220, the third refrigerant flow path 230 may be set as a region in which the refrigerant flow space 205 has a smaller thickness than the second refrigerant flow path 220. That is, the third refrigerant flow paths 230 may be defined as regions with a smaller thickness than the second refrigerant flow paths 220 by the plurality of inclined guides 215.

Further, the third refrigerant flow paths 230 may be defined as portions of the surface of one side thermal conduction panel 200-1 and the surface of the other side thermal conduction panel 200-2 of the thermal conduction panel bodies 200-1 and 200-2, which face each other, i.e., portions where the plurality of inclined guides 215 is formed. The third refrigerant flow paths 230 may be defined as portions spaced apart from one another without being joined in the refrigerant flow spaces 205

The third refrigerant flow paths 230 may serve to provide a gas flow path through which the refrigerant, which is stored in the refrigerant flow spaces 205 and changed in phase into the gaseous refrigerant in the vaporization zone, i.e., the first refrigerant flow path 210, easily diffuses and flows to the entire heat dissipation plate portion 203. The gaseous refrigerant, which is vaporized in the first refrigerant flow path 210, i.e., the vaporization zone, may move toward the heat dissipation plate portion 203 and be smoothly and evenly dispersed and condensed through the third refrigerant flow paths 230 while dissipating heat.

For example, when the liquid refrigerant naturally flows downward through the spaces between the inclined guides 215 adjacent to the second refrigerant flow paths 220, the gaseous refrigerant actively flows through the third refrigerant flow paths 230, i.e., spaces that are not occupied by the liquid refrigerant.

However, this configuration does not mean that the liquid refrigerant is completely separated from the gaseous refrigerant through the third refrigerant flow paths 230 and does not occupy the space. It may be understood that the gaseous refrigerant flows more actively through the third refrigerant flow paths 230 than the gaseous refrigerant.

That is, because the phase change of the refrigerant does not completely separate the liquid refrigerant and the gaseous refrigerant, it is difficult to accurately distinguish and define the liquid refrigerant and the gaseous refrigerant. The second refrigerant flow path 220 may be approximately defined as a route through which the liquid refrigerant mainly flows because the second refrigerant flow path 220 is relatively large in size in the thickness direction, and the third refrigerant flow path 230 may be a route through which the gaseous refrigerant mainly flows.

More specifically, because the gaseous refrigerant has higher activity than the liquid refrigerant, the third refrigerant flow path 230 having a relatively small size in the thickness direction may be a main flow path. The second refrigerant flow path 220 having a relatively larger size in the thickness direction than the third refrigerant flow path 230 may be a main flow path in consideration of surface tension of the liquid refrigerant.

Meanwhile, the third refrigerant flow path 230 may be defined as a refrigerant flow path configured to connect the spaces between the second refrigerant flow paths 220 spaced apart from one another in parallel.

For example, before one side and the other side of the thermal conduction panel bodies 200-1 and 200-2 are bent, one side thermal conduction panel 200-1 and the other side thermal conduction panel 200-2 protrude, by the pressing process S10, to the portions where the refrigerant flow spaces are formed based on the arbitrary reference line T at the central portion where the first refrigerant flow path 210 is provided, and the second refrigerant flow paths 220 may have predetermined pattern shapes so as to be divided by the third refrigerant flow paths 230 formed so as not to be in surface contact with one another after the bending process. Of course, in this case, it is noted that the 'division' does not mean physical, spatial, and complete division, but means division of the shapes and positions of the second refrigerant flow path 220 and the third refrigerant flow path 230.

Meanwhile, as illustrated in FIG. 16, the thermal conduction panel bodies 200-1 and 200-2 may be coupled to be in surface contact with each other as one side thermal conduction panel 200-1 and the other side thermal conduction panel 200-2, which correspond to two opposite widthwise ends based on the arbitrary reference line T, are bent.

In this case, as described above, the first refrigerant flow path 210, the second refrigerant flow paths 220, and the third refrigerant flow paths 230 are formed to be vertically symmetric and provided on one side thermal conduction panel 200-1 and the other side thermal conduction panel 200-2 based on the arbitrary reference line T. The size in the thickness direction of each of the first refrigerant flow path 210, the second refrigerant flow paths 220, and the third refrigerant flow paths 230 may be an internal size twice as large as a depth of a recess formed in each of one side thermal conduction panel 200-1 and the other side thermal conduction panel 200-2 by the pressing process S10 to be described below.

More specifically, as illustrated in FIG. 19, the first refrigerant flow path 210 is a portion formed by the bending process S20 to be described below, i.e., a portion where the press-fitting end 201, which is directly in surface contact with the heat generation surface of the heat generation element 140 by means of the press-fitting portion 150 of the heat dissipation housing main body 110 is formed. A size of an outer surface of the portion where the press-fitting end 201 is formed may be approximately equal to or larger than a thickness 220L of the second refrigerant flow path 220.

Further, as illustrated in FIG. 19, a maximum size 220L of the second refrigerant flow path 220 in the thickness direction may be larger than a maximum size 230L in the thickness direction of the third refrigerant flow path 230.

This is because during the pressing process S10 performed before the bending process S20 on the thermal conduction panel bodies 200-1 and 200-2, the second refrigerant flow paths 220 are not compressed, and only the rim end for defining the heat dissipation plate portion 203, the plurality of inclined guides 215, the third refrigerant flow path 230, and the plurality of strength reinforcement portions 240 to be described below are compressed.

### 6. Plurality of strength reinforcement portions

Meanwhile, as illustrated in FIGS. 16 to 19, the active heat dissipation apparatus 200 according to the embodiment of the present disclosure may further include the plurality of strength reinforcement portions 240 formed on at least any one of one side thermal conduction panel 200-1 and the other side thermal conduction panel 200-2, formed to face one another, and protruding by predetermined lengths toward the refrigerant flow spaces 205 from the inner surface of one side thermal conduction panel 200-1 and the inner surface of the other side thermal conduction panel 200-2.

More specifically, in case that the refrigerant flow spaces 205 are formed by bending and joining the single metal panel member, one side thermal conduction panel 200-1 is formed at a rim end in the width and longitudinal directions of one side based on the arbitrary reference line T before the bending process, and the other side thermal conduction panel 200-2 is formed at a rim end in the width and longitudinal directions of the other side based on the arbitrary reference line T before the bending process.

Likewise, in case that the refrigerant flow spaces 205 are formed by joining two metal panel members, one side thermal conduction panel 200-1 may be formed at the rim end in the width and longitudinal directions of one side based on the rim end, at which the first refrigerant flow path 210 is formed, before the joining process, and the other side thermal conduction panel 200-2 may be formed at the rim end in the width and longitudinal directions of the other side based on the rim end, at which the first refrigerant flow path 210 is formed, before the joining process.

In this case, the plurality of strength reinforcement portions 240 are portions excluding a vaporization zone in which the arbitrary reference line T or the first refrigerant flow path 210 is formed. The plurality of strength reinforcement portions 240 may be formed on at least any one of one side thermal conduction panel 200-1 and the other side thermal conduction panel 200-2 that constitute the condensation zone.

In general, the plurality of strength reinforcement portions 240 may be formed on at least any one of one side thermal conduction panel 200-1 and the other side thermal conduction panel 200-2 that are provided in the form of a flat surface. The plurality of strength reinforcement portions 240 may serve to reinforce strength to prevent at least any one of one side thermal conduction panel 200-1 and the other side thermal conduction panel 200-2 from being sagged or pushed by external pressure or internal pressure applied by the phase change of the refrigerant.

In this case, at least after the bending process, a tip surface of the plurality of strength reinforcement portions 240 may further protrude toward the refrigerant flow spaces 205 corresponding to the thickness direction of the thermal conduction panel bodies 200-1 and 200-2 than the tips of the plurality of inclined guides 215.

In this case, a degree to which the tip surface of the plurality of strength reinforcement portions 240 protrudes toward the refrigerant flow space 205 may correspond to a degree to which the portion of one side thermal conduction panel 200-1 and the portion of the other side thermal conduction panel 200-2, which face each other, may be in surface contact with each other so as to be joined to each other by a predetermined joining method during the joining process S40 at least after the bending process S20.

However, the plurality of strength reinforcement portions 240 does not necessarily need to be in surface contact with one another after the bending process. Like the inclined guides 215, the plurality of strength reinforcement portions 240 may be spaced apart from one another in the refrigerant flow spaces 205.

However, in case that the plurality of strength reinforcement portions 240 is limited to portions that are joined to one another by a welding method or the like during the joining process S40 to be described below, the plurality of strength reinforcement portions 240 may protrude to be in surface contact with one another in the refrigerant flow spaces 205.

In this case, the plurality of strength reinforcement portions 240 may be subjected to sheet metal processing during the pressing process S10 so that the plurality of strength reinforcement portions 240 may be at least smaller than a minimum thickness in the refrigerant flow spaces 205 defined by the plurality of second refrigerant flow paths 220.

In this case, with reference to FIG. 17, because the second refrigerant flow path 220 is defined as the space between the two adjacent inclined guides 215, except for the thickness direction, among the plurality of inclined guides 215, the minimum thickness in the refrigerant flow space 205 defined by the second refrigerant flow path 220 may be interpreted as the same meaning as the size of the third refrigerant flow path 230 in the thickness direction.

As described above, in the active heat dissipation apparatus 200 according to the embodiment of the present disclosure, the plurality of strength reinforcement portions 240 is processed to be at least smaller than the thickness of the third refrigerant flow path 230 (or the minimum thickness of the second refrigerant flow path 220), such that the third refrigerant flow paths 230 may further increase contact surface areas with the freely flowing gaseous refrigerant, thereby condensing the refrigerant within a shorter time.

In addition, as illustrated in FIG. 13, the plurality of strength reinforcement portions 240 may be provided on one side thermal conduction panel 200-1 and the other side thermal conduction panel 200-2 so as to be symmetric with respect to one another based on the arbitrary reference line T and formed only in the plurality of inclined guides 215.

In this case, the plurality of inclined guides 215 may also be processed on flat shapes of one side thermal conduction panel 200-1 and the other side thermal conduction panel 200-2 by the pressing process S10 and serve to primarily reinforce strength. The plurality of strength reinforcement portions 240 may be processed again on the plurality of inclined guides 215, which has been primarily processed, and serve to secondarily reinforce strength.

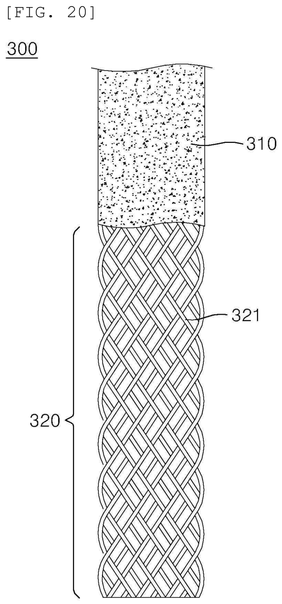

However, according to the embodiment, the plurality of inclined guides may be formed on a portion other than the inclined guide 215 (i.e., a portion irrelevant to the inclined guide 215), as in another embodiment (see 200T-1 in FIG. 20A and 200T-2 in FIG. 20B to be described below) to be described below. This configuration will be described more specifically with reference to the following corresponding embodiment.

In this case, the plurality of strength reinforcement portions 240 may be formed in the surface of one side thermal conduction panel 200-1 and the surface of the other side thermal conduction panel 200-2 of the thermal conduction panel bodies 200-1 and 200-2 that face each other. The tip surfaces of the plurality of strength reinforcement portions 240 may be disposed to face one another in the refrigerant flow space 205 or the first to third refrigerant flow paths 210, 220, and 230. Further, the facing and adjoining surfaces of the plurality of strength reinforcement portions 240, which are disposed to face one another, may be coupled by a laser welding method.

In particular, the plurality of strength reinforcement portions 240 may be formed in the third refrigerant flow paths 230, which mainly serve as flow channels for the gaseous refrigerant, in order to increase a condensation surface area in which the gaseous refrigerant in the refrigerant, which is changed in phase into the gaseous state, is condensed by coming into contact with the plurality of strength reinforcement portions 240 while flowing. However, because the third refrigerant flow paths 230 may be defined as spaces between the plurality of inclined guides 215 in the thickness direction as described above, this configuration may be based on the same concept within this range as the configuration in which the plurality of strength reinforcement portions 240 is formed in the plurality of inclined guides 215.

In this case, the plurality of strength reinforcement portions 240 may be formed in any shape as long as the shape may reinforce the strength of one side thermal conduction panel 200-1 and the other side thermal conduction panel 200-2. However, as illustrated in FIGS. 16 and 17, the strength reinforcement portion 240 may include a dot reinforcement portion 242 provided to have a circular cross-sectional shape, and a line reinforcement portion 241 elongated straight in the longitudinal direction and having only a longitudinal end formed to have a semi-circular cross-section.

More specifically, the plurality of line reinforcement portions 241 may be formed in the plurality of inclined guides 215 and elongated in the width direction of the thermal conduction panel bodies 200-1 and 200-2, and the plurality of line reinforcement portions 241 may be disposed to face one another when one side thermal conduction panel 200-1 and the other side thermal conduction panel 200-2 are joined after being bent.

Likewise, the plurality of dot reinforcement portions 242 may be formed between the plurality of line reinforcement portions 241 and provided in the plurality of inclined guides 215, and the plurality of dot reinforcement portions 242 may be disposed to face one another when one side thermal conduction panel 200-1 and the other side thermal conduction panel 200-2 are joined after being bent.

In this case, the plurality of line reinforcement portions 241 and the plurality of dot reinforcement portions 242 may be alternately disposed one by one in one inclined guide 215.

However, the plurality of strength reinforcement portions 240 does not necessarily need to separately include the plurality of line reinforcement portions 241 and the plurality of dot reinforcement portions 242. As illustrated in FIG. 20A to be described below, the reinforcement portions having elliptical shapes similar to the dot reinforcement portions 242 may, of course, be disposed at uniform intervals over the entire heat dissipation plate portion 203.

### 7. Absorber

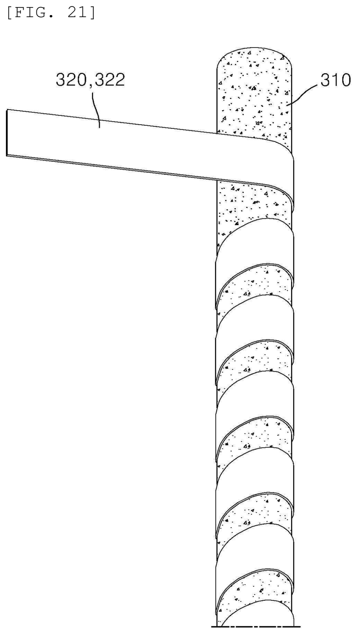

FIGS. 20 and 21 are perspective view illustrating an example of the absorber among the components of the active heat dissipation apparatus according to the embodiment of the present disclosure.

As illustrated in FIGS. 11, 14, 20, and 21, the active heat dissipation apparatus 200 according to the embodiment of the present disclosure may further include the absorber 300 configured to absorb the liquid refrigerant in the refrigerant guided by the second refrigerant flow paths 220 and then uniformly disperse the liquid refrigerant in the gravitational direction or to the first refrigerant flow path 210 inclined with respect to the gravitational direction.

More specifically, the absorber 300 is disposed in the first refrigerant flow path 210 positioned adjacent to the press-fitting portion 150, which is provided on the rear portion of the heat dissipation housing main body 110, i.e., the heat dissipation target, and configured to define the vaporization zone in which the refrigerant changes from the liquid refrigerant to the gaseous refrigerant. The absorber 300 may serve to raise at least the liquid refrigerant in the refrigerant to a side above an absorption point thereof by using a capillary force or absorbency.

To this end, the absorber 300 may include a plurality of pores (no reference numeral) configured to absorb or retain the liquid refrigerant and disperse the liquid refrigerant in the gravitational direction or a direction at least opposite to the gravitational direction (i.e., a downward direction).

The absorber 300 may maintain an absorption rate of the plurality of pores for the liquid refrigerant and prevent the shape deformation caused by sagging in the gravitational direction by means of a support structure (e.g., a framework support 320) to be described below.

In this case, the absorber 300 may be a metal sintered body formed by sintering metallic powder and have a concept including a wick member having a wick structure provided in a general vapor chamber. However, the present disclosure is not limited thereto. The absorber 300 may have any material or configuration as long as the absorber 300 may capture and transmit the entire liquid refrigerant in the upward/downward direction on the first refrigerant flow path 210 disposed to be inclined with respect to the gravitational direction and increase a limit of a thermal conduction material of a general heat dissipation fin in the related art, thereby maximizing the heat dissipation performance.

Meanwhile, as the absorber 300 is closer to the press-fitting end 201, the phase change from the liquid refrigerant to the gaseous refrigerant may be more easily and actively performed by heat transferred from the heat generation element 140. Therefore, the absorber 300 may be embedded to be close to the press-fitting end 201, as much as possible, having a relatively small width in the width direction in the refrigerant flow space 205 occupied by the absorber 300.

However, the absorber 300 does not necessarily need to be embedded to be close only to the press-fitting end 201, and the absorber 300 may be installed to evenly disperse the refrigerant over the entire heat dissipation plate portion 203 corresponding to the vaporization zone, in which the refrigerant may be vaporized, except for the press-fitting end 201.

However, in the case of the active heat dissipation apparatus 200 according to the embodiment of the present disclosure, the thermal conduction panel bodies 200-1 and 200-2, which are configured by the single member, are bent, the portions of the thermal conduction panel bodies 200-1 and 200-2, which correspond to the rim ends of the heat dissipation plate portion 203, are joined to each other, and then the absorber 300 is embedded through openings at two opposite ends of the first refrigerant flow path 210. Therefore, the vaporization zone of the refrigerant may be limited to the first refrigerant flow path 210 because of the manufacturing method.

In this case, the absorber 300 may include any one of a non-woven fabric having a plurality of pores (a kind of wick structure), a non-woven fabric supported by a metallic wire or a metallic braided body, and a metal sintered body formed by sintering metallic powder. Even in this case, like the main body part absorber 350, the metallic material may include copper excellent in thermal conductivity, and the non-woven fabric may be supported by a thin metal wire made of copper or a copper wire braided body made by braiding a metal wire.

That is, a non-woven fabric manufactured by using a fiber material may be adopted as the absorber 300 in an intact manner. In this case, the non-woven fabric material is a very flexible material, and it may be difficult to maintain a vertical shape of the non-woven fabric material because of a weight of the absorbed liquid refrigerant when the liquid refrigerant is absorbed. Therefore, the non-woven fabric may be supported by the copper wire or the braided body made of a copper wire material made by braiding the copper wire.

In this case, the non-woven fabric is inserted into the braided body made of a copper wire material to maintain a shape thereof. Therefore, the non-woven fabric, which is provided as the absorber 300, is stably fixed, without inadvertently moving, in the first refrigerant flow path 210 disposed in the gravitational direction (i.e., the vertical direction) or inclined with respect to the gravitational direction.

However, the non-woven fabric does not necessarily need to be inserted into the braided body made of a copper wire material and supported. A support configuration in which a single strand of copper wire penetrates a non-woven fabric in the vertical direction or spirally surrounds a non-woven fabric may be adopted.

In addition, despite a load of a retained liquid refrigerant, a non-woven fabric may be coupled to the interior of the braided body made of a copper wire material, or a copper wire or the braided body made of a copper wire material may spirally surround an outer peripheral surface of a non-woven fabric as long as the shape of the absorber 300 may be maintained.

More specifically, as illustrated in FIGS. 20 and 21, the absorber 300 may include an absorption body 310 having a predetermined absorption rate for the liquid refrigerant and configured to be deformed in shape by a predetermined external force equal to or higher than gravity, and the framework support 320 coupled to the absorption body 310 and configured to prevent the absorption body 310 from being deformed in shape by the external force.

In this case, the absorption body 310 may be made of any one of a non-woven fabric, cotton, and a sponge that defines the plurality of pores (a kind of wick structure). Because of the nature of the material of the absorption body 310 made of a non-woven fabric, cotton, and a sponge, the absorption body 310 may be disposed to be elongated upward and downward in the gravitational direction. However, in case that the plurality of pores contains a liquid, the absorption body 310 may be deformed in external shape by the weight of the liquid, such as sagging in the gravitational direction.

When a position of an uppermost end of the absorption body 310 is changed to a position at a lower side in the first refrigerant flow path 210 as the absorption body 310 contains the liquid and sags as described above, which may cause a problem of a decrease in the vaporization zone to the extent of the change.

The framework support 320 serves to prevent the deformation in shape, such as sagging, of the absorption body 310. To this end, the framework support 320 may be formed in a tubular shape having a hollow portion (no reference numeral) in which the absorption body 310 is positioned.

Particularly, because the framework support 320 is also configured to transfer heat, which is transferred from the external heat generation element 140, to the internal absorption body 310, the framework support 320 may be made of a metallic material having predetermined thermal conductivity or higher. For example, the metallic material of the framework support 320 may be copper.

In addition, as illustrated in FIG. 20, the framework support 320 may be braided in a tubular shape by using a wire made of a metallic material (see reference numeral '321'). As illustrated in FIG. 21, a single wire made of a metallic material may be spirally wound around an outer peripheral surface of the absorption body 310 (see reference numeral '322').

More specifically, with reference to FIG. 20, the framework support 321 may be braided in a tubular shape by using a metal (copper) wire made of a metallic material so that the liquid refrigerant, the flow of which is guided toward the first refrigerant flow path 210 through the plurality of second refrigerant flow paths 220, may be absorbed into the internal absorption body 310.

In this case, the framework support 321, which is a braided body braided in a tubular shape, may be braided to have a gap through which the liquid refrigerant in the refrigerant is transmitted at least by surface tension to the internal absorption body 310 from the outside. In this case, the gaseous refrigerant, which is changed in phase from the liquid refrigerant, may be easily dispersed to the outside through the gap in the braided absorption body 310.

In addition, with reference to FIG. 21, the framework support 322 may be configured such that a single metal (copper) panel (or wire) is spirally wound around the outer portion of the absorption body 310.

In this case, the metal panel (or metal wire) may at least have power for maintaining a shape to a degree to which the absorption body 310 is prevented from being sagged downward by gravity even when the absorption body 310 contains a sufficient amount of liquid refrigerant.

Meanwhile, as illustrated in FIG. 20, the framework support 321 of the absorber 300 is formed in a cylindrical shape, and the absorption body 310 may be formed in a cylindrical shape so as to be inserted into framework support 321 formed in a cylindrical shape.

As described above, in the active heat dissipation apparatus 200 according to the embodiment of the present disclosure, the absorption body 310 and the framework support 320 of the absorber 300 are separately manufactured and coupled. The framework support 320 does not necessarily need to be additionally provided. Only the absorption body 310 may be provided in case that the power for maintaining the shape of the absorption body 310 may prevent the absorption body 310 from being deformed in shape or sagged even when the liquid refrigerant is contained.

The absorber 300 according to the embodiments includes the absorption body 310 made of any one material of a non-woven fabric, cotton, and sponge, and the framework support 320 configured as a braided body braided in a tubular shape by using a metal (copper) wire material or configured as a shape made by spirally winding a metal (copper) wire. Therefore, the absorption body 310 is prevented from sagging downward regardless of the amount of liquid refrigerant contained in the absorption body 310, such that the uniform amount of liquid refrigerant may change in phase in the first refrigerant flow path 210.

In addition, as illustrated in FIG. 14, the active heat dissipation apparatus 200 according to the embodiment of the present disclosure may further include a plurality of absorber fixing guides 250.

The plurality of absorber fixing guides 250 may serve to stably fix the absorber 300, which is disposed to be elongated in the gravitational direction (i.e., the vertical direction), in the refrigerant flow spaces 205 (particularly, the first refrigerant flow path 210). In particular, the plurality of absorber fixing guides 250 serves to prevent a situation in which the absorber 300 is sagged in the gravitational direction by the absorbed liquid refrigerant in case that the absorber 300 adopts only the non-woven fabric that is not supported by the braided body made of a metallic material such as the framework support 320.

The plurality of absorber fixing guides 250 may be simultaneously formed together with the first to third refrigerant flow paths 210, 220, and 230, and the plurality of inclined guides 215 or the plurality of strength reinforcement portions 240 by the pressing process S10.

More specifically, the plurality of absorber fixing guides 250 protrudes toward the refrigerant flow spaces 205 to prevent the situation in which the absorber 300 made of a non-woven fabric is sagged in the gravitational direction by the absorbed liquid refrigerant. The plurality of absorber fixing guides 250 may be stably fixed while pushing the absorber 250 when the rim end of one side thermal conduction panel 200-1 and the rim end of the other side thermal conduction panel 200-2 are joined to each other by the joining process S40.

In this case, in case that the absorber 300 is configured such that the non-woven fabric is positioned and supported in the braided body made of a metallic material, a portion, which is substantially supported by the plurality of absorber fixing guides 250, may, of course, be an outer surface of the braided body.

In addition, the plurality of absorber fixing guides 250 may also serve to ensure a predetermined space, in which the gaseous refrigerant vaporized in the first refrigerant flow path 210 flows, by pushing the outer surface of the absorber 300 or the braided body made of a non-woven fabric configured to be easily deformed in external shape by an external force.

As described above, the absorber 300 is embedded in the first refrigerant flow path 210. Therefore, the liquid refrigerant, which is condensed and liquefied from the heat dissipation plate portion 203, may be moved to and retained at the portion close to the heat generation element 140 by absorbency (or capillary force) of the absorber 300 and changed in phase into the gaseous refrigerant by heat transferred from the heat generation element 140, and then the gaseous refrigerant may diffuse and flow back to the entire heat dissipation plate portion 203 by a principle of gas diffusion.

The gaseous refrigerant, which is moved to the heat dissipation plate portion 203, may be evenly and smoothly dispersed to the entire heat dissipation plate portion 203 through the third refrigerant flow paths 230 and condensed while dissipating heat by means of heat exchange with outside air. The condensed liquid refrigerant may be easily moved back to the first refrigerant flow path 210 in the gravitational direction along the second refrigerant flow paths 220 relatively larger in size in the thickness direction than the plurality of inclined guides 215.

The heat generated from the heat generation elements 140 is preferentially transferred to the first refrigerant flow path 210 in which the absorber 300 is installed, and the refrigerant, which is stored in the first refrigerant flow path 210 in which the absorber 300 is provided, is mostly present in the liquid state in the absorber 300 and then changed in phase into the gaseous state by heat transferred from the heat generation elements 140, and then particularly the gaseous refrigerant dissipates heat while flowing to the entire heat dissipation plate portions 203 of the thermal conduction panel bodies 200-1 and 200-2 through the third refrigerant flow paths 230.

Hereinafter, one refrigerant circulation, in which the liquid refrigerant is changed in phase into the gaseous refrigerant at the press-fitting end 201 and diffuses and flows to the heat dissipation plate portion 203, and the gaseous refrigerant is changed in phase into the liquid refrigerant at the heat dissipation plate portion 203 and returns to the press-fitting end 201, is defined as one cycle, and the time required for one cycle is defined as a 'cycle time of gas-liquid circulation' and will be described.

It will be understood that the final purpose of the specific shapes and arrangement designs of the first refrigerant flow paths 210 and 1210, the second refrigerant flow paths 220 and 1220, the third refrigerant flow paths 230, the plurality of inclined guides 215 and 1215, and the plurality of strength reinforcement portions 240 and 1240, which are included in the active heat dissipation apparatus 200 according to the embodiment of the present disclosure, a plurality of modified examples 200T-1, 200T-2, 200T-3, 200T-4, and 200T-5 to be described below, and the active heat dissipation apparatus 1200 according to another embodiment of the present disclosure to be described below is to maximize the heat dissipation performance by activating the gas-liquid circulation by minimizing the cycle time of the gas-liquid circulation.

### 8. First modified example and second modified example

FIGS. 22A and 22B are development views illustrating states made before thermal conduction panel bodies according to the first and second modified examples 200T-1 and 200T-2 are bent relative to some of the components of the embodiment of the present disclosure.

A difference from the above-described embodiment 200 of the present disclosure will be described with reference to the first and second modified examples 200T-1 and 200T-2 illustrated in FIGS. 22A and 22B.

That is, as illustrated in FIG. 22A, in the first modified example 200T-1 of the present disclosure, a plurality of strength reinforcement portions 240 may be provided only in the plurality of inclined guides 215 that separates the second refrigerant flow paths 220, as in the embodiment 200. Alternatively, some 240 of the plurality of strength reinforcement portions may be designed to be provided on an outer portion irrelevant to the second refrigerant flow path 220 or the third refrigerant flow path 230 and the plurality of inclined guides 215, unlike the embodiment 200.

In addition, it can be seen that there is the following difference obtained by the comparison between the active heat dissipation apparatus 200T-2 according to the second modified example of the present disclosure illustrated in FIG. 22B and the active heat dissipation apparatus 200 according to the embodiment of the present disclosure illustrated in FIGS. 9 to 21.

That is, as illustrated in FIG. 22B, in the active heat dissipation apparatus 200T-2 according to the second modified example of the present disclosure, only the plurality of inclined guides 215 may be formed in any one of one side thermal conduction panel 200-1 and the other side thermal conduction panel 200-2, and only the plurality of strength reinforcement portions 240, which is provided in the form of the dot reinforcement portions 242, may be formed in the other of one side thermal conduction panel 200-1 and the other side thermal conduction panel 200-2.

In this case, in the thermal conduction panel bodies 200-1 and 200-2 of the active heat dissipation apparatus 200T-2 according to the second modified example, the tip surfaces of the plurality of junction portions 240 and the tip surfaces of the plurality of inclined guides 215 may be disposed to be in surface contact with one another or face one another to a degree to which the tip surfaces of the plurality of junction portions 240 and the tip surfaces of the plurality of inclined guides 215 are almost in contact with one another in the refrigerant flow spaces 205 after the bending process S20.

More specifically, in the active heat dissipation apparatus 200T-2 according to the second modified example, the plurality of second refrigerant flow paths 220, which is defined between the plurality of inclined guides 215, may be formed to be inclined toward the widthwise ends thereof on any one 200-2 of one side thermal conduction panel 200-1 and the other side thermal conduction panel 200-2 corresponding to the left and right sides of the first refrigerant flow path 210 that serves as the comprehensive passageway for the refrigerant, and the plurality of dot reinforcement portions 242 may be provided on the other 200-1 of one side thermal conduction panel 200-1 and the other side thermal conduction panel 200-2 so as to face the tip surfaces of the plurality of inclined guides 215 formed to define the plurality of second refrigerant flow paths 220 after the bending process S20 to be described below.

In this case, the strength reinforcement portion 240 need not be separately provided on the other side thermal conduction panel 200-2. The plurality of inclined guides 215, which is provided to define the second refrigerant flow paths 220, only needs to be understood as serving as the strength reinforcement portions 240.

That is, in the embodiment of the present disclosure 200, the plurality of strength reinforcement portions 240 is provided as a mixture of the plurality of line reinforcement portions 241 and the plurality of dot reinforcement portions 242 without distinguishing between one side thermal conduction panel 200-1 corresponding to the left side of the thermal conduction panel bodies 200-1 and 200-2 and the other side thermal conduction panel 200-2 corresponding to the right side. In the active heat dissipation apparatus 200T-2 according to the second modified example of the present disclosure illustrated in FIG. 22B, different strength reinforcement elements are respectively provided on one side thermal conduction panel 200-1 corresponding to the left side and the other side thermal conduction panel 200-2 corresponding to the right side of the thermal conduction panel bodies 200-1 and 200-2.

In this case, the configuration in which a surface portion of the other side thermal conduction panel 200-2 having the plurality of inclined guides 215 is positioned at a lower side based on the gravitational direction is advantageous in guiding a smooth flow of the liquid refrigerant. Therefore, the surface portion of the other side thermal conduction panel 200-2 may be positioned at the relatively lower side based on the gravitational direction when being installed in the heat dissipation housing main body 110. Further, the configuration in which a surface portion of one side thermal conduction panel 200-1 having the plurality of dot reinforcement portions 242 is positioned at an upper side is advantageous in terms of a smooth flow of the gaseous refrigerant. Therefore, the surface portion of one side thermal conduction panel 200-1 may be positioned at the relatively upper side based on the gravitational direction when being installed in the heat dissipation housing main body 110.

In this case, as described above, the configuration in which the plurality of dot reinforcement portions 242 are joined to one another by welding (see the joining process S40 to be described below) provides the advantage in improving the overall rigidity of the thermal conduction panel bodies 200-1 and 200-2 after the bending process S20.

However, as described above, because the active heat dissipation apparatus 200 and the modified examples 200T-1, 200T-2, 200T-3, and 200T-2 thereof according to the present disclosure adopt, as the key component main part, the technical configuration in which the refrigerant is stored and heat dissipation performance is improved by the phase change of the refrigerant, the designs of the internal structures of the thermal conduction panel bodies 200-1 and 200-2 need to be optimally applied so as to correspond to the installation positions, the gravity, and the phase change of the refrigerant.

### 9. Additional embodiments

FIGS. 23A to 24B are perspective views and top plan views illustrating additional embodiments of the active heat dissipation apparatus according to the embodiment of the present disclosure.

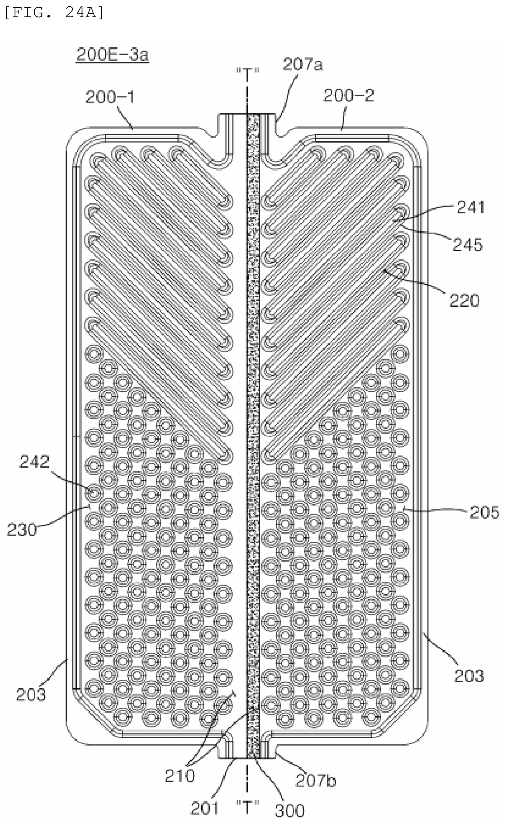

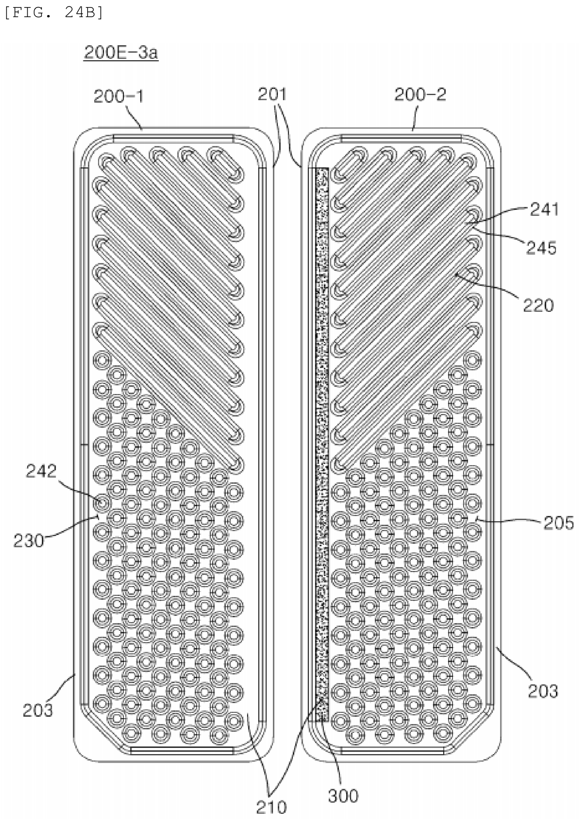

More specifically, FIGS. 23A and 24A illustrate an additional embodiment (hereinafter, referred to as an additional bending-type embodiment) manufactured by bending the thermal conduction panel bodies 200-1 and 200-2, which are provided as a single metal panel member, about the arbitrary reference line T by means of the above-mentioned bending process S20, and FIGS. 23B and 24B illustrate an additional embodiment (hereinafter, referred to as an additional joining-type embodiment) manufactured by joining the thermal conduction panel bodies 200-1 and 200-2, which are provided as two metal panel members, during the joining process S40 to be described below without the above-mentioned bending process S20.

In this case, it may be understood that in the additional bending-type embodiment in FIGS. 23A and 24A and the additional joining-type embodiment in FIGS. 23B and 24B, all the components (e.g., the plurality of inclined guides 215, the first refrigerant flow path 210, the second refrigerant flow path 220, and the like) in the refrigerant flow space 205 remain the same, except for external shape structures of one side caulking end 207a and the other side caulking end 207 of an additional bending-type embodiment 200E-1a formed at two opposite longitudinal ends of the thermal conduction panel bodies 200-1 and 200-2 to perform an essentially accompanied caulking finishing process by means of the bending process S20.

As illustrated in FIGS. 23A to 24B, in active heat dissipation apparatuses 200E-1a and 200E-1b according to the additional embodiments of the present disclosure, the plurality of inclined guides 215 may be provided straight on one side thermal conduction panel body 200-1 and the other side thermal conduction panel body 200-2 disposed at the left and right sides of the drawings based on the arbitrary reference line T or the press-fitting end 201 including the first refrigerant flow path 210.

In this case, assuming that the press-fitting ends 201 of the thermal conduction panel bodies 200-1 and 200-2 manufactured by the bending process S20 or the joining process S40 are inserted and coupled into the press-fitting portion 150 vertically disposed in the gravitational direction (upward/downward direction) with respect to the rear surface portion of the heat dissipation housing main body 110, which is a heat dissipation target, or inserted and coupled into the press-fitting portion 150 disposed to be inclined in the gravitational direction at least with respect to the rear surface portion of the heat dissipation housing main body 110, any one of the two opposite ends of the plurality of inclined guides 215 and the plurality of second refrigerant flow paths 210 defined by the plurality of inclined guides 215, which is adjacent to the first refrigerant flow path 210, may always also be disposed to be inclined at the lower side based on the gravitational direction.

Meanwhile, the single line reinforcement portion 241 of the strength reinforcement portions 240 may be formed on each of the plurality of inclined guides 215.

More specifically, in case that the plurality of inclined guides 215 are each formed straight while having a predetermined length and width, the line reinforcement portion 241 formed on each of the plurality of inclined guides 215 may be processed and formed straight while having a shorter length and a smaller width than the inclined guide 215 corresponding to each forming position.

It is to be understood that the plurality of inclined guides 215 and the line reinforcement portions 241 may be simultaneously formed during the sheet metal forming process performed by the press process S10.

In this case, at least the line reinforcement portions 241 may be formed symmetrically so as to face each other in the refrigerant flow space 205 in the state in which at least the joining is completed after the bending, and the line reinforcement portions 241 may further protrude toward the refrigerant flow space 205 than the plurality of inclined guides 215 so as to be joined to each other in the refrigerant flow space 205.

The line reinforcement portions 241, which are formed as described above, may be joined to each other in the refrigerant flow space 205 and serve to form independent flow paths for the liquid refrigerant formed by the plurality of inclined guides 215.

In this case, the configuration in which the independent flow paths are formed by the plurality of strength reinforcement portions 240, i.e., the line reinforcement portions 241 means that the plurality of inclined guides 215 are provided straight from the outer end of the heat dissipation plate portion 203 to the press-fitting end 201 and protrude to be in surface contact with one another in the refrigerant flow space 205 on the inclined guides 215, thereby forming a structure that prevents the liquid refrigerant from flowing toward the adjacent second refrigerant flow path 220.

The limitation has been described in which only the first refrigerant flow path 210, which corresponds to the vaporization area, and the second refrigerant flow path 220, which is the main flow path for the liquid refrigerant, are provided in the active heat dissipation apparatuses 200E-1a and 200E-1b according to the additional embodiment of the present disclosure. However, the separate third refrigerant flow path (not illustrated) is not required in case that the gaseous refrigerant freely flows through an empty space that is not occupied by the liquid refrigerant even while the flow of the liquid refrigerant is guided through the second refrigerant flow path 220.

Meanwhile, the active heat dissipation apparatuses 200E-1a and 200E-1b according to the additional embodiment of the present disclosure may each further have the above-mentioned absorber 300 at the side of the press-fitting end 201 corresponding to the first refrigerant flow path 210. The absorber 300 may be determined so that an uppermost end surface of the liquid refrigerant may vary depending on a predetermined absorption rate (absorbency) of the absorber 300.

In this case, in case that the thermal conduction panel bodies 200-1 and 200-2 are installed on the press-fitting portion 150 and inclined with respect to the gravitational direction after the joining, the liquid refrigerant is concentratedly stored at the lower portion of the two opposite longitudinal ends, such that the uppermost end surface of the liquid refrigerant absorbed by the absorber 300 may move to the relatively lower portion.

In order to raise the uppermost end surface of the liquid refrigerant absorbed by the absorber 300, the absorber 300 having a higher absorption rate (absorbency) needs to be adopted, and the surface of the liquid refrigerant stored in the first refrigerant flow path 210 needs to be raised.

This is because the most efficient function is performed because the vaporization area is substantially expanded when the uppermost end surface of the liquid refrigerant is determined as an upper end of the absorber 300.

The active heat dissipation apparatuses 200E-1a and 200E-1b according to the additional embodiment of the present disclosure may each further include fixing/joining portions 208F formed on the thermal conduction panel bodies 200-1 and 200-2 in order to further raise the uppermost end surface of the liquid refrigerant absorbed by the absorber 300, as described above.

More specifically, in case that the thermal conduction panel bodies 200-1 and 200-2 are disposed in the upward/downward direction or disposed to be inclined at least based on the gravitational direction with respect to the heat dissipation housing main body 110 having the press-fitting portion 150, the fixing/joining portions 208F may be formed at outer edge portions of the lower ends of the thermal conduction panel bodies 200-1 and 200-2 based on the gravitational direction and reduce the refrigerant flow space 205.

That is, the fixing/joining portions 208F are provided in triangular shapes on the outer edge portions of the lower ends of the heat dissipation plate portions 203 of one side thermal conduction panel 200-1 and the other side thermal conduction panel 200-2, the portions, which are in surface contact with one another, are simultaneously joined to the plurality of strength reinforcement portions 240 during the joining process S40, thereby reducing the space in which the liquid refrigerant is stored and substantially raising the surface of the liquid refrigerant stored in the first refrigerant flow path 210.

Therefore, the fixing/joining portion 208F may be understood as a component configured to proportionally move the uppermost end surface of the liquid refrigerant in the refrigerant, which is absorbed by the absorber 300, upward based on the gravitational direction in comparison with the area occupied by the liquid refrigerant.

In addition, it is to be understood that the area occupied by the fixing/joining portion 208F may be set in consideration of the absorption rate (absorbency) of the absorber 300 installed in the first refrigerant flow path 210.

However, because a heat dissipation amount per unit area may vary depending on the size of the area occupied by the fixing/joining portion 208F, the amount of the liquid refrigerant to be introduced into the first refrigerant flow path 210 may also vary, and the surfaces of the liquid refrigerant in the independent flow paths formed by he inclined guides 215 may not be uniform.

### 10. Comparison between comparative example and present disclosure

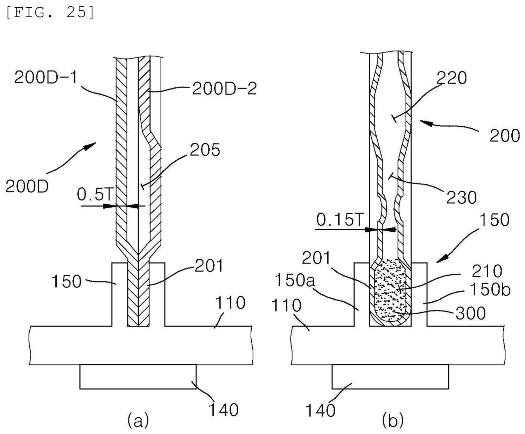

FIG. 25 is a cross-sectional view illustrating installed states of a comparative example 200D (a) and an active heat dissipation apparatus 200 (b) according to the embodiment of the present disclosure with respect to the press-fitting portion.

### 10-1. SUS material and bending

Hereinafter, it is noted that in order to smoothly compare and describe the active heat dissipation apparatus 200 according to the embodiment of the present disclosure and the active heat dissipation apparatus 200D according to the comparative example, the comparative example 200D, in the configuration illustrated in FIG. 25, is illustrated on the assumption that the press-fitting end 201 of the active heat dissipation apparatus 200 according to the embodiment of the present disclosure is fixedly inserted into the press-fitting portion 150 provided with the same specifications (i.e., shape and size).

First, the specifications of the active heat dissipation apparatus 200D according to the comparative example will be described in detail in order to specifically compare the active heat dissipation apparatus 200 according to the embodiment of the present disclosure illustrated in FIG. 25B and the comparative example 200D illustrated in FIG. 25A.

The active heat dissipation apparatus 200D according to the comparative example will be described on the assumption that the active heat dissipation apparatus 200D is manufactured by joining two panel members, which are made of an aluminum (Al) material very excellent in thermal conductivity, by a predetermined joining process, and the refrigerant flow space 205 in which the refrigerant is stored and flows through the phase change is formed.

As already known well, the aluminum (Al) material has thermal conductivity of 230 and specific gravity of 2.7. In the present disclosure, a thickness of one panel member is 0.5T (hereinafter, 'T' means 'mm' that is a unit of a length), and a sum of the thicknesses of the two panel members is 1T. This means that a thickness of the panel members inserted into the press-fitting portion 150 provided to be close to the heat generation elements 140, i.e., the heat dissipation target is 1T.

More specifically, as illustrated in FIG. 22A, one side thermal conduction panel 200D-1 and the other side thermal conduction panel 200D-2 of the comparative example 200D are manufactured under a condition in which one side thermal conduction panel 200D-1 and the other side thermal conduction panel 200D-2 are manufactured with a limit thickness of 0.5T by which one side thermal conduction panel 200D-1 and the other side thermal conduction panel 200D-2 cannot be manufactured any further with a small thickness because of a strength design requirement and a safety design requirement on a product in consideration of the aluminum material. A width in the pair of slot ribs 150a and 150b, which defines the press-fitting portion 150, is formed to have a 1T that is twice 0.5T, i.e., a sum of a thickness of one side thermal conduction panel 200D-1 and a thickness of the other side thermal conduction panel 200D-2 of the comparative example 200D. The press-fitting portions 150 having the same shape and size are also applied to the active heat dissipation apparatus 200 according to the embodiment of the present disclosure.

In this case, the requirements for strength design and safety design of a product made of an aluminum material imply that, although the aluminum material itself exhibits superior elongation and workability compared to a stainless steel (SUS) material and may therefore be manufactured to a thickness below the above-mentioned limit thickness, the aluminum material also needs to possess sufficient strength to reliably retain the refrigerant filled therein. To this end, additional processes such as heat treatment, cold working, or alloying of the aluminum metal panel member are required.

In particular, like the comparative example 200D, in case that the aluminum material is adopted as a main component material of the thermal conduction panel body, there is an advantage in that thermal conductivity is excellent. However, in addition to a problem of increase in costs because of the high costs, various problems occur as follows.

First, in the case of comparative example 200D including the thermal conduction panel bodies 200D-1 and 200D-2 made of an aluminum material, there is a great limitation in selecting the refrigerant. That is, in case that aluminum comes into contact with water, a chemical reaction may occur while producing a hydrogen material and changing aluminum into an aluminum oxide. In particular, hydrogen is partially produced, which causes a problem of an increase in internal pressure of the refrigerant flow space 205.

Second, the increase in internal pressure of the refrigerant flow space 205 of the comparative example 200D including the thermal conduction panel bodies 200D-1 and 200D-2 made of an aluminum material not only increases a risk of damage to the finished active heat dissipation apparatus 200D but also separates one side thermal conduction panel 200D-1 and the other side thermal conduction panel 200D-2, which additionally causes rattling during the gas-liquid circulation of the refrigerant and hinders the smooth gas-liquid circulation. In order to prevent this problem, the reinforcement element, such as the strength reinforcement portion 240 of the embodiments 200 according to the present disclosure, needs to be necessarily formed during the pressing process S10.

Third, because of the first and second problems, the refrigerant, which may be applied to the comparative example 200D made of an aluminum material, is limited to a special refrigerant such as a Honeywell refrigerant or Freon gas (CFC). However, recently, many countries are actively considering regulating the use of refrigerants to prevent environmental pollution, so there is a conflict with this international trend toward the prevention of environmental pollution. That is, even though products such as the comparative example 200D made of an aluminum material are produced, it may not be possible to market and apply the product in some countries because of the regulations on the use of the special refrigerant.

Fourth, there is a problem in that the thermal conduction panel bodies 200D-1 and 200D-2 made of an aluminum material have a design limitation in positioning the refrigerant close to the heat generation element in case that the limit thickness is preset as described above. In other words, pure aluminum does not have a poor elongation ratio due to its characteristics. However, as described above, when metal panel members made of aluminum are manufactured by heat treatment, cold working, or alloying to meet the strength design requirements and safety design requirements of the product to reliably retain the refrigerant inside without separation, the strength of the aluminum is increased, but the processability for pressing processes is reduced. For this reason, on the premise that the refrigerant flow spaces 205 having the same thickness are formed, the plurality of strength reinforcement portions 240, which is provided in the embodiments 200 according to the present disclosure to prevent rattling during the gas-liquid circulation of the refrigerant, cannot be formed by the pressing process.

Fifth, as in the active heat dissipation apparatus 200 according to the embodiment of the present disclosure, when the limit thickness is set for one side thermal conduction panel 200D-1 and the other side thermal conduction panel 200D-2, there is a problem in that the closest contact position of the refrigerant flow space 205 corresponding to the first refrigerant flow path 210, which captures the liquid refrigerant and is intended to be positioned substantially closest to the heat generation elements 140, is set outside the press-fitting portion 150. These problems lead to a problem that obstructs the advantage of the aluminum material excellent in thermal conductivity because a distance between the heat generation elements 140 and the liquid refrigerant increases.

Therefore, in the comparative example 200D, the case will be described in which the aluminum material is adopted as the metallic material of the metal panel member including the thermal conduction panel bodies 200D-1 and 200D-2, and the metal panel member is made of an aluminum alloy material having a predetermined tensile strength or higher.

Aluminum materials, including aluminum alloys, are one of the most popular thermally conductive metallic materials for heat dissipation elements because of very high thermal conductivity of 230 as described above, as well as low specific gravity.

However, as described above, aluminum has very good thermal conductivity and specific gravity, but aluminum is relatively expensive, and the types of refrigerants that are stored inside are restrictive.

Therefore, the active heat dissipation apparatus 200 according to the embodiment of the present disclosure has a key component main part that adopts a material less costly than an aluminum material, i.e., adopts a stainless steel (SUS) material and is designed and modified to have heat dissipation performance similar to that of an aluminum material.

More specifically, as illustrated in FIG. 25A, the active heat dissipation apparatus 200D according to the comparative example may include the thermal conduction panel bodies 200D-1 and 200D-2 that are two members having the refrigerant flow spaces 205 in which the refrigerant is stored and flows and provided in the form of a flat plate made of an aluminum material.

This differs from the configuration in which the active heat dissipation apparatus 200 according to the embodiment of the present disclosure is configured as a single member and bent to define the plurality of refrigerant flow paths 210, 220, and 230 corresponding to the refrigerant flow spaces 205.

However, even the case, in which the two members, i.e., the thermal conduction panel bodies 200D-1 and 200D-2 are joined as in the active heat dissipation apparatus 200D according to the comparative example, is identical to the case in which the two thermal conduction panel bodies 200D-1 and 200D-2 are coupled to each other by welding, as in the active heat dissipation apparatus 200 according to the embodiment of the present disclosure, within a range in which the first refrigerant flow path 210, the second refrigerant flow paths 220, and the third refrigerant flow paths 230 may be formed, and the absorber 300 may be installed in the portion corresponding to the first refrigerant flow path 210.

That is, in the active heat dissipation apparatus 200D according to the comparative example, the two thermal conduction panel bodies 200D-1 and 200D-2 may be coupled to each other and face each other, and the refrigerant flow spaces 205 may be defined in the thermal conduction panel bodies 200D-1 and 200D-2.

In this case, the active heat dissipation apparatus 200 according to the embodiment of the present disclosure, which is provided as a single member and bent to be symmetric vertically, may differ from the comparative example 200D having the two members.

In this case, unlike the active heat dissipation apparatus 200 according to the embodiment of the present disclosure, the active heat dissipation apparatus 200D according to the comparative example is manufactured so that the two separated members (the thermal conduction panel bodies 200D-1 and 200D-2) are joined by a predetermined joining method to define the refrigerant flow spaces 205 therein. This is because it is very difficult to precisely and additionally process the aluminum material, as described above, because the elongation ratio decreases during the metal processing process using an aluminum alloy in order to ensure predetermined strength.

For example, in case that the thermal conduction panel bodies 200D-1 and 200D-2 made of an aluminum material is subjected to the bending processing by the bending process S20 as in the embodiment of the present disclosure 200, a radius of curvature of the part for defining the press-fitting end 201 is relatively large inevitably because of very poor processability.

Because of the increase in radius of curvature of the press-fitting end 201, the groove size (i.e., the size between the pair of slot ribs 150a and 150b) of the press-fitting portion 150, which is manufactured to be installed on the rear surface of the heat dissipation housing main body 110, which is the heat dissipation target, needs to be increased, and the sizes of the thermal conduction panel bodies 200D-1 and 200D-2 need to be increased, which causes a problem of a significant decrease in number of thermal conduction panel bodies installed for each unit area of the rear surface of the heat dissipation housing main body 110.

More specifically, the elongation ratio of metal panel members made of aluminum material is generally 40% or more as the purity increases, which is greater than the elongation of metal panel members made of SUS material (see SUS304, SUS316, SUS321, SUS410 in the JIS standard), which is 35%, so it is expected to have good processability.

However, as described above, in case that the metal panel member made of aluminum is manufactured by heat treatment, cold working, or alloying depending on the strength design requirements and safety design requirements of the product, the elongation is reduced, and the processability is also poor.

In this case, the configuration in which the metal panel member made of an aluminum material and manufactured by heat treatment, cold working, alloying, or the like has poor processability means a concept in which the limit thickness makes it difficult to reduce the spacing distance between the refrigerant flow space 205, in which the liquid refrigerant is vaporized, and the inner surface of the press-fitting portion 150, which substantially receives heat from the heat generation elements 140, (requires separate additional processing), and it is not easy to process, by the pressing process, the reinforcement elements, such as the plurality of strength reinforcement portions 240 in the embodiment of the present disclosure 200 for preventing rattling of one side thermal conduction panel 200D-1 and the other side thermal conduction panel 200D-2 occurring during the gas-liquid circulation of the refrigerant (processability is poor).

That is, referring to the comparative example 200D described with reference to FIG. 25A, in case that the width between the pair of slot ribs 150a and 150b constituting the press-fitting portion 150 is designed to be twice the limit thickness on the assumption that it is difficult to perform further processing because of the limit thickness according to the design requirement, the distance between the heat generation element 140 and the refrigerant flow space 205, to which the liquid refrigerant is substantially is closest, is further increased outward from the outer end of the press-fitting portion 150 (the outer ends of the pair of slot ribs 150a and 150b), and differences in heat transfer rates and heat transfer amounts occur to that extent.

For example, as illustrated in FIG. 25A, when at least any one part of the refrigerant flow space 205, which corresponds to the first refrigerant flow path, is installed to have 1T, i.e., a thickness of twice 0.5T of the limit thickness, without being positioned in the slot ribs 150a and 150b of the press-fitting portion 150, in case that the material of the metal panel member, which constitutes the thermal conduction panel bodies 200D-1 and 200D-2 in the inside 150c of the pair of slot ribs 150a and 150b of the press-fitting portion 150 having the same shape and size, is an aluminum material, the thermal conduction panel bodies 200-1 and 200-2 made of a SUS material may be processed to have a thickness including the thickness of twice 0.15T so that a part of the first refrigerant flow path 210 may be positioned in the inside 150c of the pair of slot ribs 150a and 150b of the press-fitting portion 150, as in the active heat dissipation apparatus 200 according to the embodiment of the present disclosure illustrated in FIG. 25B.

Meanwhile, as in the comparative example 200D illustrated in FIG. 25A, when the metal panel member constituting the thermal conduction panel bodies 200D-1 and 200D-2 is manufactured to have the limit thickness according to the design requirement, the processability is degraded because of the increase in strength. For this reason, it is difficult to process the reinforcement elements corresponding to the plurality of strength reinforcement portions 240 by the pressing process. For this reason, other metal panel members have the disadvantage that the internal structure or reinforcement elements of the refrigerant flow space need to be processed by using different processing methods (e.g., etching or turning).

In contrast, in the case of the embodiment of the present disclosure 200 illustrated in FIG. 25B, the elongation ratio of the metal panel member made of a SUS material is very good, and the processability is also excellent. Therefore, the internal structure of the refrigerant flow space 205 including the first to third refrigerant flow paths 210, 220, and 230 and the plurality of strength reinforcement portions 240 may be simultaneously formed only by the single pressing process. Further, the portions of the plurality of strength reinforcement portions 240, which are joined to one another, are coupled by welding by the joining process, such that it is possible to prevent rattling or expansion and contraction of one side thermal conduction panel 200-1 and the other side thermal conduction panel 200-2 during the gas-liquid circulation of the refrigerant, which may prevent energy required to vaporize the liquid refrigerant from being unnecessarily consumed.

Further, as described above, in the case of the active heat dissipation apparatus 200D according to the comparative example, the press-fitting end 201 is formed to have the material thickness (0.5T*2) of the two thermal conduction panel bodies 200D-1 and 200D-2, and the processability is not good. For this reason, in case that the coupling process is performed by simply press-fitting the press-fitting portion 150, the fixing force to the heat dissipation housing main body 110 is inevitably low. Therefore, there is an inconvenience, in terms of the working process, of having to fit the press-fitting end 201 into the press-fitting portion 150 and then increase the coupling force through an additionally welding coupling method in order to supplement the fixing force.

Meanwhile, even in case that the refrigerant flow space 205 is formed in the thermal conduction panel bodies 200D-1 and 200D-2 made of an aluminum material, the types of refrigerants, with which the refrigerant flow space 205 is filled, may be very restrictive, as described above. For example, in case that distilled water (water) is adopted as the refrigerant, the water chemically reacts with the aluminum material, which makes it impossible for the water to serve as the refrigerant. Therefore, there is a problem in that the distilled water needs to be excluded from the selectable refrigerants.

In order to solve various problems with the thermal conduction panel bodies 200D-1 and 200D-2 of the comparative example 200D using the aluminum material, the active heat dissipation apparatus 200 according to the embodiment of the present disclosure adopts the SUS (stainless steel) material as the material of the thermal conduction panel bodies 200-1 and 200-2 and proposes various shape designs and features capable of ensuring heat dissipation performance corresponding to the case in which the aluminum material is adopted.

More specifically, as illustrated in FIG. 25B, in the active heat dissipation apparatus 200 according to the embodiment of the present disclosure, the press-fitting end 201 may be formed to have a predetermined curvature (e.g., R1 or R2, see FIGS. 15 and 16) by bending the thermal conduction panel bodies 200-1 and 200-2 made of the single material about the arbitrary reference line T by the bending process S20, and at least a part of the first refrigerant flow path 210 in the refrigerant flow space 205 may be disposed inward of the tips of the pair of slot ribs 150a and 150b constituting the press-fitting portion 150.

In this case, in the embodiment of the present disclosure 200, the material of the thermal conduction panel bodies 200-1 and 200-2 may be limited to a metallic material having an elongation ratio that satisfies the following conditions.

More specifically, as one of the conditions, it is assumed that the component corresponding to the thermal conduction panel body is provided in the form of a panel made of an aluminum material such as the RBFHP in the preceding literature. In case that the component with the thickness of twice the thickness is inserted, without an empty space, into the pair of slot ribs 150a and 150b of the press-fitting portion 150 formed on the rear surface of the heat dissipation housing main body 110 that is the heat dissipation target, the metallic material of the thermal conduction panel bodies 200-1 and 200-2 in the embodiment of the present disclosure 200 may be limited to a metallic material having an elongation ratio and being bendable with a thickness of 1/6 or less of the thickness of twice the thickness of the thermal conduction panel body of the RBFHP in the preceding literature.

For example, in case that the thermal conduction panel bodies 200D-1 and 200D-2 made of an aluminum material of the comparative example 200D or the RBFHP in the preceding literature has a thickness of 0.5T and is inserted into the press-fitting portion 150, the thickness of 1T of twice the thickness is inserted. Therefore, the thickness of the thermal conduction panel bodies 200-1 and 200-2 of the active heat dissipation apparatus 200 according to the embodiment of the present disclosure may be adopted as 0.15T that is 1/6 or less of 1T.

In addition, as described above, the metallic material adopted as the material of the thermal conduction panel bodies 200-1 and 200-2 of the embodiment of the present disclosure 200 may have an elongation ratio so that at least a part of the first refrigerant flow path 210 is bendable and inserted into the tip of the press-fitting portion 150.

Further, the metallic material may be limited to a material having an elongation ratio that allows the plurality of strength reinforcement portions 240 to be formed on the plurality of inclined guides 215 during the processing by the pressing process S10.

Further, the metallic material adopted as the material of the thermal conduction panel bodies 200-1 and 200-2 of the embodiment of the present disclosure 200 may be limited to a material having a thermal conductivity of 1/10 or less of a thermal conductivity (at a level of 230 W/m-K) of an aluminum material. It is already known that the actual thermal conductivity of the SUS material to be described below is at a level of 20 W/m-K that is 1/10 or less of the thermal conductivity of aluminum.

### 10-2. Benefit of being capable of selecting water as refrigerant

As described above, the material, which is most suitable for the limitations related to the elongation ratio and the thermal conductivity, may be the SUS material described above. In the active heat dissipation apparatus 200 according to the embodiment of the present disclosure, in case that the SUS material is adopted as the metallic material of the thermal conduction panel bodies 200-1 and 200-2, it is possible to not only overcome the limitations related to the elongation ratio and the thermal conductivity, but also provide an advantage capable of additionally adopting distilled water as the adoptable refrigerant.

That is, the refrigerant, with which the refrigerant flow spaces 205 of the thermal conduction panel bodies 200-1 and 200-2 made of the SUS material are filled, may be defined as a refrigerant, which does not chemically react with a metallic material having the elongation ratio, except for the refrigerant that chemically reacts with the panel made of an aluminum material.

As described above, distilled water (water) may be representatively adopted as the refrigerant that satisfies the definition. In case that distilled water is adopted as the refrigerant, there may be an advantage in terms of costs, vaporization heat, and surface tension in comparison with other refrigerants. In particular, because distilled water is characterized by high latent heat and sensible heat, it is possible to exhibit a sufficient heat transport ability even though a position of the press-fitting end 201 is relatively high based on the gravitational direction. Therefore, there is an advantage in that it is possible to ensure the diversity related to a fixing design with respect to the press-fitting portion 201 regardless of a gradient direction of the second refrigerant flow path 220.

More specifically, the refrigerant, with which the refrigerant flow space 205 is filled, may be distilled water (water) that does not cause any chemical reaction when the refrigerant comes into contact with the thermal conduction panel bodies 200-1 and 200-2 made of a metallic material, and may be changed from from the liquid state to the gaseous state or from the gaseous state to the liquid state by the thermal conductivity of the thermal conduction panel bodies 200-1 and 200-2.

In this case, the term "chemical reaction" also includes the additional production of materials that are "corroded" by the water adopted as the refrigerant or that change the pressure inside the refrigerant flow space 205.

However, because it is extremely unusual for contact between materials to result in no chemical reaction at all, especially over long periods of time, the concept of "chemical reaction" herein is generally interpreted broadly as a reaction that affects the phase change conditions of water, at least to the extent of changing the internal pressure of the refrigerant flow space 205.

In this case, the water, which is used as the refrigerant, may include any one of natural water, distilled water, and ultrapure water. However, if water is adopted, the water in the natural state is likely to contain organic and inorganic materials. Therefore, distilled water or ultra-pure water that has been purified, possibly after vaporization, may be used, or ultrapure water, from which organic and inorganic materials are removed, may be used.

In this case, ultrapure water is pure water that has been treated with advanced water purification methods such as reverse osmosis (RO), ion exchange resin, activated carbon filters, and sterilization to remove electrolytes, microorganisms, organic materials, and dissolved gases in the water. The ultrapure water is water with a specific resistivity of 18 MΩ.cm or more.

Further, in case that water is selected and employed as the refrigerant, the metallic material of the thermal conduction panel bodies 200-1 and 200-2 needs to be limited to a material that does not cause any chemical reaction when the material comes into contact with water, as can be inferred from the problems with the comparative example 200D.

Therefore, in the active heat dissipation apparatus 200 according to the embodiment of the present disclosure, the metallic material of the thermal conduction panel bodies 200-1 and 200-2 may include the stainless steel (SUS) material as the metallic material that does not cause any chemical reaction with water adopted as the refrigerant. Here, SUS is the standard designation for stainless steel in the JIS standard.

In addition, the active heat dissipation apparatus 200 according to the embodiment of the present disclosure has a higher elongation ratio than the comparative example 200D made of an aluminum alloy material or the RBFHP in the preceding literature. Therefore, the press-fitting end 201 is formed to have an external shape larger than the groove size of the press-fitting portion 150, and then the press-fitting end 201 is press-fitted into the press-fitting portion 150 in an interference-fit manner, such that a sufficient fixing force may be implemented without an additional process such as a separate welding process.

The adoption of the coupling method using the press-fitting method of press-fitting the press-fitting end 201 into the press-fitting portion 150 leads to the advantage capable of preventing in advance damage to the absorber 300, which is made of a fiber material such as a non-woven fabric, caused by welding heat generated by an additional welding process.

As described above, it can be seen that the first to third refrigerant flow paths 210, 220, and 230 of the embodiment of the present disclosure 200 are filled with the refrigerant, and the refrigerant dissipates heat while being actively changed in phase by heat transferred from the heat generation elements 140 provided in the heat dissipation housing main body 110, such that the heat dissipation performance may be maximized.

In particular, with reference to FIG. 25, unlike the comparative example 200D, in the case of the embodiment of the present disclosure 200, at least a part of the first refrigerant flow path 210 is introduced into the groove defined by the press-fitting portion 150 (i.e., into the tip of the press-fitting portion 150), such that the refrigerant absorbed and captured by the absorber 300 of the first refrigerant flow path 210 may be supplied with heat in the state in which the refrigerant is closer to the heat generation elements 140. Therefore, the phase change may be more actively performed in the vaporization zone, which leads to an advantage capable of ensuring the heat dissipation performance comparable to that in the case in which an aluminum material is adopted.

### 10-3. Hydrophobic coating material

However, in case that distilled water is adopted as the refrigerant with which the refrigerant flow space 205 is filled, the very high surface tension of water may lead to a problem of the deterioration in fluidity caused by the inner surface of the refrigerant flow space 205 formed somewhat thinly.

In order to solve the problem of the deterioration in fluidity of the liquid refrigerant, in the active heat dissipation apparatus 200 according to the embodiment of the present disclosure, a hydrophobic coating material is applied to portions corresponding to the inner surfaces of the thermal conduction panel bodies 200-1 and 200-2 that define the refrigerant flow space for the refrigerant.

In the case of the first refrigerant flow path 210, there is no great problem because the first refrigerant flow path 210 provides a comprehensive flow path regardless of a state of the stored refrigerant, and the first refrigerant flow path 210 is a flow path in which the liquid refrigerant is mainly absorbed by the absorber 300. However, in the case of the second refrigerant flow path 220 and the third refrigerant flow path 230, the flow paths, in which the liquid refrigerant flows along the surface, are provided, such that a coating layer using a hydrophobic coating material is applied to the inner surfaces of the thermal conduction panel bodies 200-1 and 200-2 that define the refrigerant flow spaces 205, thereby ensuring the more smooth fluidity of the liquid refrigerant.

However, it is not necessary to use hydrophobic coating materials to form the coating layer, and it may be possible to apply hydrophilic coating materials depending on the type of refrigerant or the characteristics of the flow path.

### 11. Another embodiment of the present disclosure (joining manufacturing) and heat dissipation housing main body arrangement structure

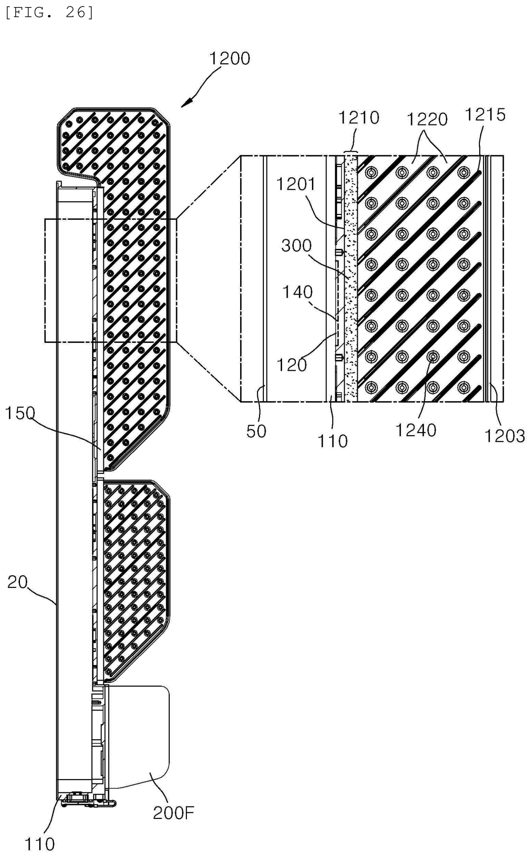

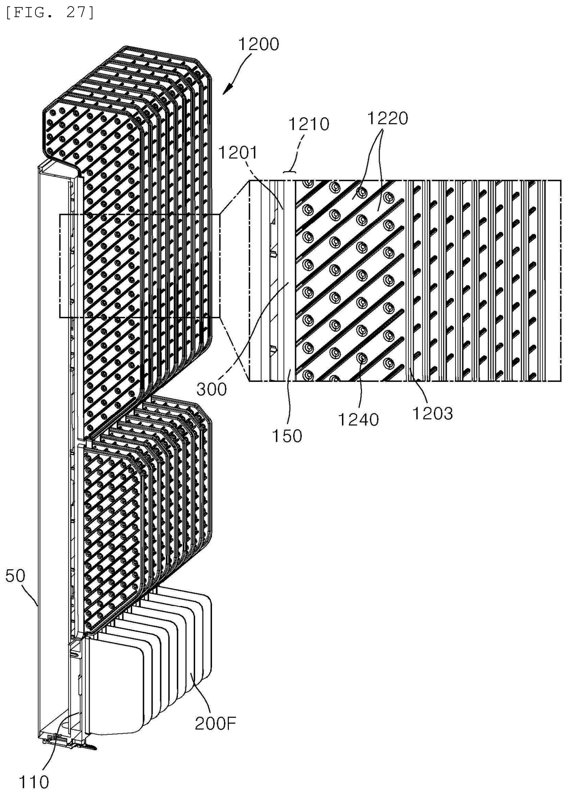

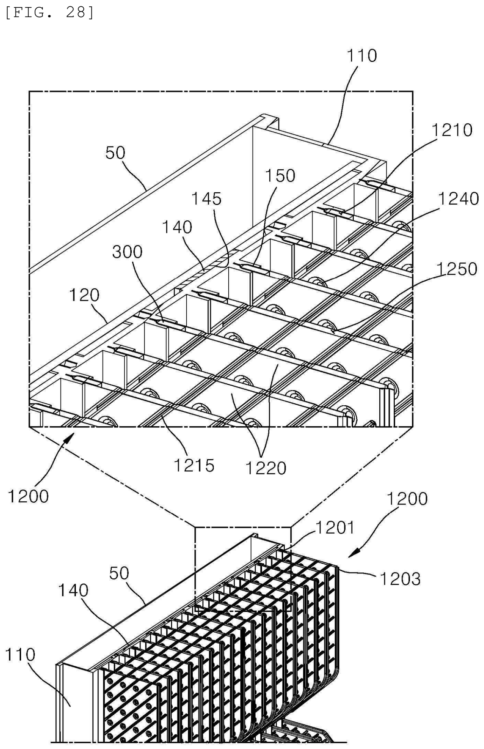

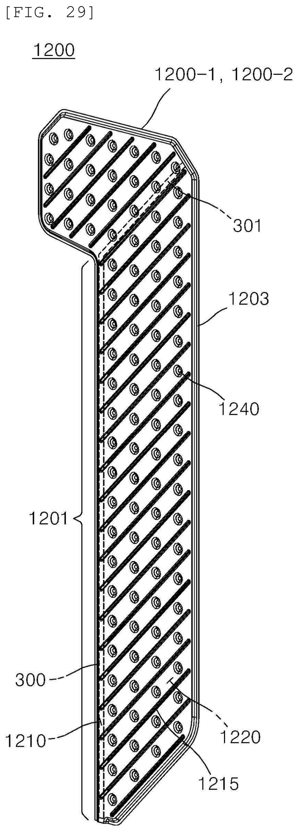

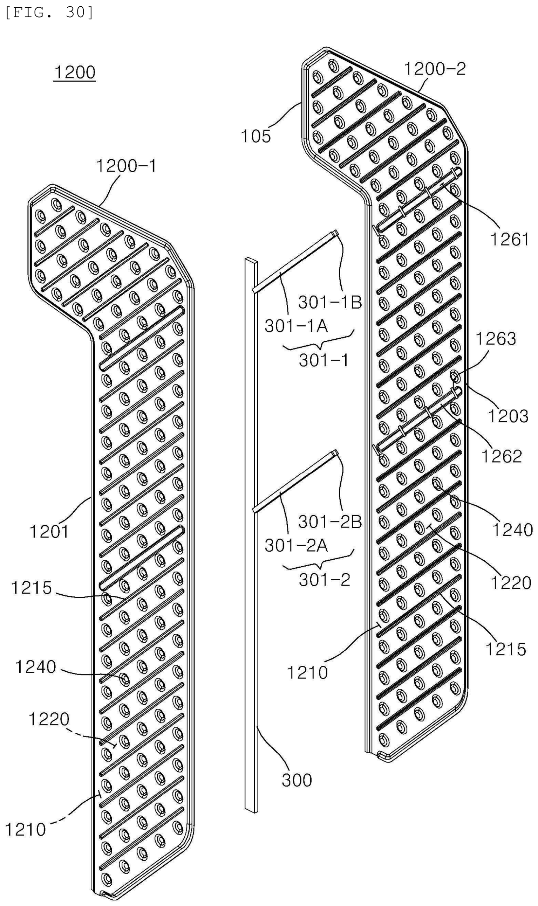

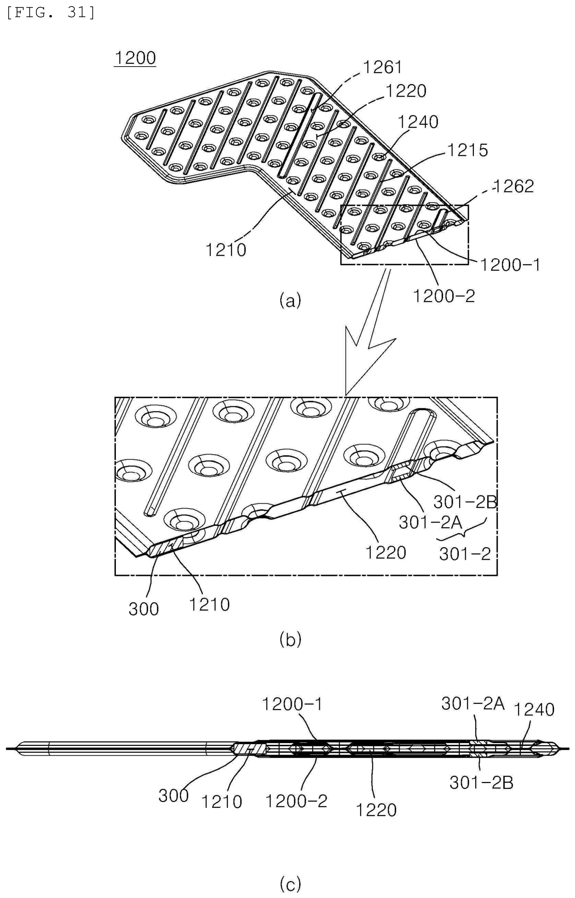

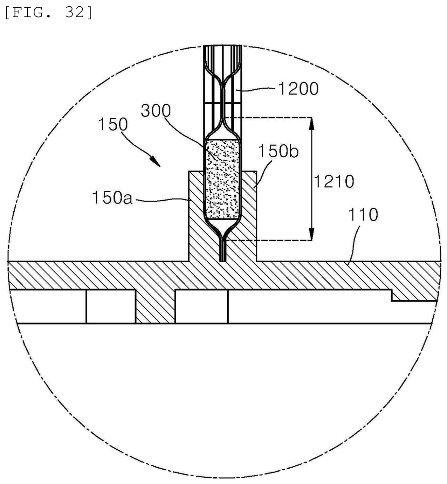

FIG. 26 is a cross-sectional view taken along line A-A in FIG. 4B and a partially enlarged view thereof, FIG. 27 is a cut-away perspective view taken along line A-A in FIG. 4B and a partially enlarged view thereof, FIG. 28 is a cut-away perspective view taken along line B-B in FIG. 4B and a partially enlarged view thereof, FIG. 29 is a perspective view illustrating an active heat dissipation apparatus according to another embodiment of the present disclosure, FIG. 30 is an exploded perspective view of FIG. 29, FIG. 31 is a cut-away perspective view (a), a partially enlarged view (b) thereof, and a cross-sectional view (c) of the corresponding part in FIG. 29, and FIG. 32 is a cross-sectional view illustrating a state in which the active heat dissipation apparatus according to another embodiment of the present disclosure is coupled to the press-fitting portion.

As described above, the active heat dissipation apparatus 200 according to the embodiment of the present disclosure and some of the modified examples 200T-1 and 200T-2 and the additional embodiment 200E-1a thereof have been described with reference to FIGS. 4A, 5A, and 7 to 24B on the premise that the first refrigerant flow path 210 is formed by bending the single metal panel member or by using the manufacturing method of the bending process S20.

However, the method of manufacturing the active heat dissipation apparatus according to the present disclosure is not necessarily limited to the embodiment 200 according to the bending process S20. Hereinafter, the active heat dissipation apparatus 1200 according to another embodiment of the present disclosure will be proposed and described with reference to FIGS. 4B, 5B, 23B, 24B, and 26 to 32, in which refrigerant flow spaces 1205 including the first refrigerant flow paths 1210 and the second refrigerant flow paths 1220 (including third refrigerant flow paths according to the embodiment) are formed by joining the two separated metal panel members by a joining method.

As illustrated in FIGS. 26 to 32, in the active heat dissipation apparatus 1200 according to another embodiment of the present disclosure, the refrigerant flow spaces 1205 may be formed by processing the two separated metal panel members, i.e., thermal conduction panel bodies 1200-1 and 1200-2, by the joining method (identical to the joining process S40 to be described below). This differs from the configuration in which the active heat dissipation apparatus 200 according to the embodiment of the present disclosure is manufactured by the different manufacturing method that forms the refrigerant flow spaces 205 by bending and then joining the single metal panel member.

The active heat dissipation apparatus 1200 according to another embodiment of the present disclosure may be coupled to the rear portion of the heat dissipation housing main body 110 implemented as the first installation embodiment illustrated in FIGS. 4A and 5A. However, as illustrated in FIGS. 4B and 5B, the description will be made on the premise that the active heat dissipation apparatus 1200 is coupled to and installed on the rear surface of the heat dissipation housing main body 110 implemented as the second installation embodiment including a shape of the press-fitting portion 150 suitable for different shapes of the press-fitting end 201 made by the difference in manufacturing methods.

With reference to FIGS. 26 to 29, on the rear portion of the heat dissipation housing main body 110 implemented as the second installation embodiment, the plurality of press-fitting portions 150 is disposed to be elongated in the upward/downward direction (i.e., the vertical direction), and the plurality of active heat dissipation apparatuses 1200 according to another embodiment of the present disclosure is installed to be spaced apart from one another in the leftward/rightward width direction.

In case that the plurality of active heat dissipation apparatuses 1200 according to another embodiment of the present disclosure is installed on the rear portion of the heat dissipation housing main body 110 implemented as the second installation embodiment as described above, the flow resistance of outside air in the vertical direction may be minimized, the introduction of outside air may be smoothly performed, and flow resistance against an ascending gas flow made by heat discharged from the active heat dissipation apparatuses 1200 may be minimized, in comparison with the active heat dissipation apparatuses 200 according to the embodiment of the present disclosure installed and patterned in a relatively 'V' shape.

In addition, the single press-fitting portion 150 may be disposed to be elongated in the upward/downward direction on the rear portion of the heat dissipation housing main body 110 implemented as the second installation embodiment. However, in consideration of the limitation in dispersion force or ascending force of the liquid refrigerant of the first refrigerant flow path 1210, the press-fitting portion 150 may be disposed to be divided into two or three zones in the upward/downward direction. In this case, a plurality of stationary heat dissipation fins 200F may be provided in a lower end zone, i.e., a portion where the heat dissipation necessity is low.

The active heat dissipation apparatus 1200 according to another embodiment of the present disclosure installed on the rear portion of the heat dissipation housing main body 110 implemented as the second installation embodiment may also include one side thermal conduction panel 1200-1, which defines one side surface in the thickness direction of the refrigerant flow space 1205 after being manufactured by the joining process S40, and the other side thermal conduction panel 1200-2 that defines the other side surface in the thickness direction of the refrigerant flow space 1205 after being joined.

In this case, the first refrigerant flow path 1210 and the second refrigerant flow path 1220 may be formed to be symmetric with respect to a junction surface between one side thermal conduction panel 1200-1 and the other side thermal conduction panel 1200-2.

However, the present disclosure is not necessarily limited to the configuration in which the first refrigerant flow path 1210 and the second refrigerant flow path 1220 provided on one side surface, which defines one side thermal conduction panel 1200-1, and the other side surface, which defines the other side thermal conduction panel 1200-2, are formed to be symmetric. The configuration does not exclude a configuration in which the first refrigerant flow path 1210 and the second refrigerant flow path 1220 are formed to be asymmetric, like the plurality of modified examples 200T-1, 200T-2, 200T-3, 200T-4, 200T-5, and 200T-2 of the active heat dissipation apparatus 200 according to the embodiment of the present disclosure illustrated in FIGS. 22A and 22B.

Meanwhile, even in the active heat dissipation apparatus 1200 according to another embodiment of the present disclosure, the first refrigerant flow path 1210 is a portion where the liquid refrigerant in the refrigerant stored in the refrigerant flow space 1205 is stored and retained, and the first refrigerant flow path 1210 has upper and lower ends vertically disposed in the gravitational direction, such that the refrigerant surface of the liquid refrigerant is at least positioned at a portion close to the lower end of the upper and lower ends of the first refrigerant flow path 1210.

The junction surface between one side thermal conduction panel 1200-1 and the other side thermal conduction panel 1200-2 may be defined as a rim end, i.e., a joinable area including a press-fitting end 1201 corresponding to the vaporization zone and a heat dissipation plate portion 1203 corresponding to the condensation zone.

That is, in the case of the active heat dissipation apparatus 200 or the like according to the embodiment of the present disclosure, the portions joined by the joining process S40 to be described below are the rim ends of the heat dissipation plate portion 203, except for the press-fitting end 201, i.e., the portion formed by the bending process S20. Therefore, it is noted in advance that the rim ends are partially different from the joined portions of the active heat dissipation apparatus 1200 according to another embodiment of the present disclosure where the two separated metal panel members are joined and sealed.

More specifically, in the thermal conduction panel bodies 1200-1 and 1200-2 of the active heat dissipation apparatus 1200 according to another embodiment of the present disclosure, the rim end of one side thermal conduction panel 1200-1 and the rim end of the other side thermal conduction panel 1200-2 are joined, such that the first refrigerant flow path 1210 may be formed inside any one of one widthwise end and the other widthwise end among the rim ends (one end, i.e., the left end based on FIG. 26), and the press-fitting end 1201, which is coupled to the press-fitting portion 150 formed on the rear surface of the heat dissipation housing main body 110, i.e., the heat dissipation target, may be formed outside any one of one widthwise end and the other widthwise end among the rim ends (one end).

In addition, in the thermal conduction panel bodies 1200-1 and 1200-2, the rim end of one side thermal conduction panel 1200-1 and the rim end of the other side thermal conduction panel 1200-2 are joined, such that the second refrigerant flow path 1220 may be formed inside the other of one widthwise end and the other widthwise end among the rim ends (the other end, i.e., the right end based on FIG. 26), except for the press-fitting end 1201 having the first refrigerant flow path 1210, and the heat dissipation plate portion 1203, which exchanges heat with outside air, may be formed outside the other of one widthwise end and the other widthwise end among the rim ends (the other end).

Meanwhile, as illustrated in FIGS. 4B and 5B, the active heat dissipation apparatus 1200 according to another embodiment of the present disclosure is installed on the press-fitting portion 150 and disposed to be elongated vertically in the upward/downward direction on the rear surface of the heat dissipation housing main body 110. Therefore, the press-fitting end 1201 corresponding to the front end may be parallel to the outer end of the heat dissipation plate portion 1203 corresponding to the rear end.

Therefore, the technical feature "among the plurality of inclined guides 215, the first refrigerant flow path 210 is positioned relatively below the second refrigerant flow path 220 in the gravitational direction", which is described in the description of the active heat dissipation apparatus 200 or the like according to the embodiment of the present disclosure, has a greater meaning when the technical feature defines an inclination forming direction of the second refrigerant flow path 1220 in the active heat dissipation apparatus 1200 according to another embodiment of the present disclosure.

That is, the configuration in which the first refrigerant flow path 1210 is positioned below the second refrigerant flow path 1220 in the gravitational direction means that the flow paths are formed to be inclined so that a portion of one end and the other end of the second refrigerant flow path 1220, which corresponds to an outer end side of the heat dissipation plate portion 1203, is positioned at a position higher, in the gravitational direction, than a portion corresponding to the press-fitting end 1201 having the first refrigerant flow path 1210.

Further, as illustrated in FIGS. 29 and 30, the active heat dissipation apparatus 1200 according to another embodiment of the present disclosure may further include auxiliary absorbers 301 in order to improve the absorption rate of the liquid refrigerant by the absorber 300.

In this case, as in the active heat dissipation apparatus 200 according to the embodiment of the present disclosure, the auxiliary absorber 301 may perform a basic function of increasing the absorption rate of the absorber 300 and further serve to allow the liquid refrigerant, which is condensed on the heat dissipation plate portion 1203 corresponding to the upper side of the heat dissipation housing main body 110, to be easily captured toward the upper end of the absorber 300 and absorbed in case that the auxiliary absorber 301 further extends upward than the upper end of the heat dissipation housing main body 110 so as to cover the upper end part of the heat dissipation housing main body 110, as in the active heat dissipation apparatus 1200 according to another embodiment of the present disclosure.

As illustrated in FIGS. 29 and 30, in the active heat dissipation apparatus 1200 according to another embodiment of the present disclosure, the auxiliary absorber 301 may be provided as two auxiliary absorbers 301-1 and 301-2 additionally installed at two points, i.e., the relatively upper portion and the relatively lower portion.

More specifically, the auxiliary absorber 301 may be seated and installed on auxiliary absorber installation portions 1261 and 1262 formed by deforming a part of the second refrigerant flow path 1220 so as to have a larger width.

In case that the two auxiliary absorbers 301 (see reference numerals 301-1 and 301-2) are installed, the auxiliary absorber installation portions 1261 and 1262 may, of course, be formed at two points corresponding to the positions of the auxiliary absorbers 301, as illustrated in FIG. 30.

The auxiliary absorbers 301 may include an upper auxiliary absorber 301-1 having a lower end connected adjacent to the upper end side of the absorber 300, and a lower auxiliary absorber 301-2 having a lower end connected adjacent to a middle portion of the absorber 300.

In addition, the upper auxiliary absorber 301-1 and the lower auxiliary absorber 301-2 may be installed with a pair of auxiliary absorbers 301-1A, 301-1B, 301-2A, and 301-2B made of a non-woven fabric and provided on the auxiliary absorber installation portions 1261 and 1262 formed on one side thermal conduction panel 1200-1 and the other side thermal conduction panel 1200-2.

Meanwhile, as illustrated in FIG. 30, a plurality of fixing ribs 1263 for stably fixing the auxiliary absorbers 301 may be provided in the refrigerant flow spaces 1205.

The plurality of fixing ribs 1263 may be formed to traverse the auxiliary absorber installation portions 1261 and 1262 in the width direction, and two opposite ends of the plurality of fixing ribs 1263 may be coupled to outer widthwise ends of the auxiliary absorber installation portions 1261 and 1262 by a separate welding method.

In this case, the auxiliary absorber installation portions 1261 and 1262 are processed and formed in the form of grooves for further increasing the thickness of the refrigerant flow space 1205 outward from the inner surface of one side thermal conduction panel 1200-1 and the inner surface of the other side thermal conduction panel 1200-2. Therefore, gaps, into which the auxiliary absorbers 301 are inserted and seated, may be defined between the auxiliary absorber installation portions 1261 and 1262 and the plurality of fixing ribs 1263, and the auxiliary absorbers 301 may be installed through the gaps.

The plurality of fixing ribs 1263 may prevent the auxiliary absorber 301 from separating from the refrigerant flow space 1205 in the thickness direction.

Meanwhile, in the active heat dissipation apparatus 1200 according to another embodiment of the present disclosure, one side thermal conduction panel 1200-1 and the other side thermal conduction panel 1200-2, which are configured as the two metal panel members, are joined to each other, in the state in which the rim ends including the portions corresponding to the press-fitting ends 1201 are in surface contact with one another, and made of the SUS material excellent in elongation ratios. Therefore, as illustrated in FIG. 32, one side thermal conduction panel 1200-1 and the other side thermal conduction panel 1200-2 may be coupled to the plurality of press-fitting portions 150 formed on the rear surface of the heat dissipation housing main body 110 by press-fitting in an interference-fit manner.

In this case, the rim end portions joined by the butt joint may be at least included, and half or more of the portion corresponding to the first refrigerant flow path 1210 (or the absorber 300) may be press-fitted to be positioned inward of the outer ends of the pair of slot ribs 150a and 150b that defines the press-fitting portion 150.

As described above, the active heat dissipation apparatus 1200 according to another embodiment of the present disclosure is made of the SUS material excellent in elongation ratios. Therefore, even though the absorber 300, which is made of a fiber material such as a non-woven fabric that is somewhat vulnerable to heat, is provided on the first refrigerant flow path 1210 side, it is advantageous that the absorber 300 may be securely fastened to the back side of the heat dissipation housing main body 110 by a simple press-fitting without using a welding process.

In addition, in comparison with the comparative example 200D illustrated in FIG. 25B and manufactured by the same joining method, the active heat dissipation apparatus 1200 according to another embodiment of the present disclosure may substantially improve the heat dissipation performance by changing the phase of the refrigerant according to the embodiment of the present disclosure because the first refrigerant flow path 1210 may be installed adjacent to the press-fitting portion 150 in a state in which the first refrigerant flow path 1210 having 0.7T made by at least subtracting a thickness of 0.3T (0.15T*2) from an installation thickness of 1T (0.5T*2) is ensured even though the same installation thickness of the press-fitting portion 150 is considered.

### 12. Comparison between experimental data of comparative example and present disclosure

FIG. 33 is a comparison graph (a) and a comparison view (b) for comparing temperatures of heat generation elements 140 of the active heat dissipation apparatus 200D according to the comparative example and the active heat dissipation apparatus 200 according to the embodiment of the present disclosure.

In order to identify the heat dissipation performance of the active heat dissipation apparatus 200 according to the embodiment of the present disclosure, the applicant of the present disclosure installed the active heat dissipation apparatus according to the comparative example 200D and the active heat dissipation apparatus according to the embodiment of the present disclosure 200 on the same rear surface of the heat dissipation housing main body 110 and on the press-fitting portions 150 with the same number or the same shape, mounted five heat generation elements 140 with input electric power of 25 W on the main board, and acquired temperature result values of the heat generation elements 140, as illustrated in FIG. 33.

With reference to FIG. 33, it can be seen that the temperature difference between the comparative example 200D and the first embodiment 200 of each of the five heat generation elements 140 is at least 0.2°C (see the heat generation element 1) and at most 2.1°C (see the heat generation element 4), which indicates that the temperatures of the heat generation elements of the active heat dissipation apparatus 200 according to the embodiment of the present disclosure are low.

The measured relatively low temperatures of the heat generation elements indicate, conversely, that the heat dissipation performance of the active heat dissipation apparatus 200 according to the embodiment of the present disclosure is better than that of the comparative example 200D.

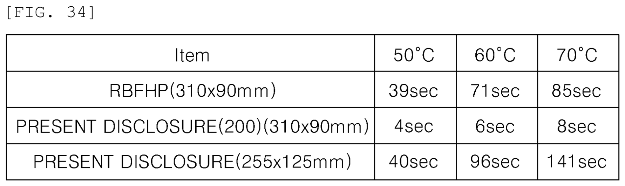

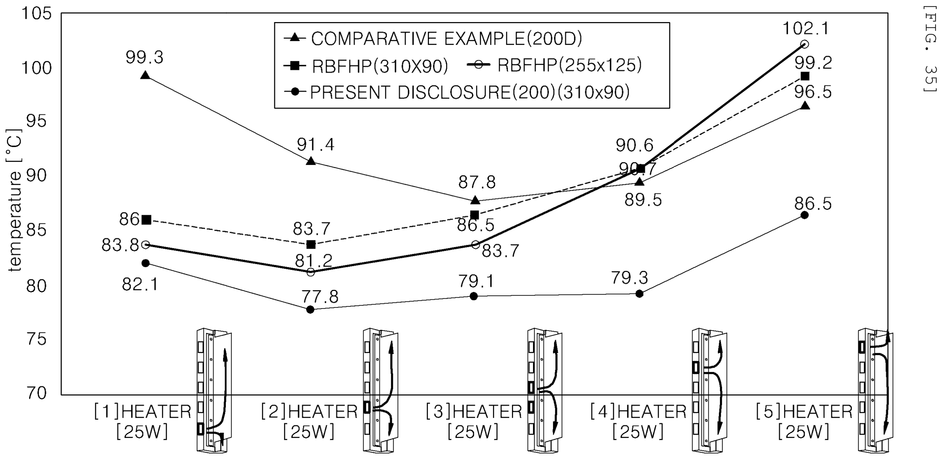

FIG. 34 is a table illustrating a result of measuring times for which the comparative example 200D including the thermal conduction panel bodies 200D-1 and 200D-2 made of an aluminum material and the active heat dissipation apparatus 200 according to the embodiment of the present disclosure made of a SUS material reach 50°C, 60°C, and 70°C. FIG. 35 is a graph for comparing temperatures of a heat dissipation fin (AL6063_REF) made of a general aluminum material and provided without using a refrigerant and products with two types of specifications estimated as an RBFHP of the preceding literature (a roll bonding fin (292*115 and 310*90) and an active heat dissipation apparatus (PTX (310*90) according to the embodiment of the present disclosure) in accordance with positions of the heat sources (heat generation elements).

The experiment to obtain the table of results in FIG. 34 was to simultaneously immerse partial portions of the products of the two geometry specifications of the preceding literature and the prototype of the active heat dissipation apparatus 200 according to the embodiment of the present disclosure in a water bath corresponding to the same heat source, and then to obtain the temperature rise time of the part not immersed in the water bath.

However, in order to identify that the results described above do not differ due to differences in the shape of the product itself, the RBFHP of the preceding literature was adopted in two different shapes, of which a prototype of the active heat dissipation apparatus 200 according to the embodiment of the present disclosure with the same shape (size) was manufactured and measured.

With reference to FIG. 34, it can be seen that the time to reach a certain temperature for two RBFHPs of the preceding literature made of the same aluminum material using a phase change of the refrigerant is generally faster for the product with a larger length than width among the product geometries (Roll Bonding Fin, 310*90) than for the other product (Roll Bonding Fin, 292*115) (i.e., the time to reach 50°C is 1 second shorter, the time to reach 60°C is 25 seconds shorter, and the time to reach 70°C is 36 seconds shorter).

This is presumed to be due to the active diffusive flow of the gaseous refrigerant, when the vaporization and condensation zones of the refrigerant are separated, but the condensation zone is further separated from the vaporization zone or is somewhat distinct. Therefore, it can be an important indicator for miniaturizing the front-to-back thickness of an antenna device (or electronic device), in that the size in the width direction may be reduced somewhat.

Furthermore, when comparing the respective temperature reaching times of the two RBFHP products of the preceding literature, the active heat dissipation apparatus 200, PTX, 310*90 according to the embodiment of the present disclosure and the product with the same geometry specification (Roll Bonding Fin, 310*90), it can be seen that the target temperature is reached in a dramatically shorter time, as shown in FIG. 31.

In other words, it can be seen that the time to reach the highest target temperature of 70°C is only 8 seconds for the active heat dissipation apparatus 200, PTX, 310*90 according to the embodiment of the present disclosure, which is nearly 5 times shorter than the time to reach the lowest target temperature of 50°C for the RBFHP of the Roll Bonding Fin, 310*90 specification in the preceding literature, and nearly 10 times shorter than the time to reach the same highest target temperature.

This indicates that the active heat dissipation apparatus 300, PTX, 310*90 according to the embodiment of the present disclosure has a very active gas-liquid circulation in the refrigerant flow space compared to the RBFHP's Roll Bonding, 310*90 product of the preceding literature.

That is, it is estimated that the active heat dissipation apparatus 200 according to the embodiment of the present disclosure performs substantially better heat dissipation compared to the RBFHP of the preceding literature due to the minimized separation distance of the refrigerant flow space 205 (more specifically, the first refrigerant flow path 210), and it is appreciated that the reduced separation distance between the liquid refrigerant filled in the refrigerant flow space 205 and the heating elements 140 may be a more realistic cause of the improved heat dissipation performance than the superior thermal conductivity of the material of the metal panel member itself.

As such, it is obvious that minimizing the time it takes to reach the target temperature for the entire condensation zone other than the vaporization zone will result in heat dissipation with faster and higher performance.

Meanwhile, the purpose of the test that resulted in the result shown in FIG. 34 is a temperature measurement result by position of a heat source (heating element) in a heat dissipation area elongated in the upward/downward direction, such as an antenna device in general, and the active heat dissipation apparatus 200 (PTX, 310*90) according to the embodiment of the present disclosure, which does not utilize phase change of the refrigerant, compared to a typical aluminum material heat dissipation fin (AL6063_REF) and two specification products (Roll Bonding Fin (292*115 and 310*90), which are presumed to be RBFHP of the preceding literature, in order to confirm the suitability of installation on an antenna device.

In order to obtain accurate results, a heat source (heating element) with a uniform power input (25 W) was placed at five locations equally spaced up and down, as illustrated in FIG. 35, the above four products were replaced with heat dissipation fins that perform heat dissipation, and the measurement was performed.

As a result, as illustrated in FIG. 35, it was identified that in the case of the general aluminum material heat dissipation fin (AL6063_REF) product, the temperature of the heat source from the lowest heat source to the third heat source in the middle is relatively high, and the temperature of the heat source from the bottom to the fourth heat source and the top heat source is relatively low, compared to the two specifications of the product (Roll Bonding Fin (292*115 and 310*90)) that are presumed to be RBFHP in the preceding literature.

While it is difficult to determine the exact cause of these results, it can be assumed that the two RBFHP products in the preceding literature are both more affected by the ascending airflow, which appears to be relatively hot air, at higher locations. As a result, the RBFHP of the preceding literature is not desirable in terms of heat dissipation performance to be applied to the entire heat dissipation area that is elongated in the upward/downward direction, such as an antenna device, but is preferably designed to be arranged intersecting with the above general aluminum heat dissipation fin (AL6063_REF) product for optimal performance according to each location.

In contrast, it will be appreciated that the active heat dissipation apparatus 200, PTX, 310*90 according to the embodiment of the present disclosure exhibits good heat source temperature values regardless of the height of the heat source, and thus has the advantage of being uniformly applicable to all heat dissipation areas elongated in the upward/downward direction, such as antenna devices.

As such, the active heat dissipation apparatus 200 according to the embodiment of the present disclosure provides the benefit of maximizing the heat dissipation performance of the product itself, while overcoming the limitations of refrigerant use and selection that have recently emerged as a regulatory issue in the international community.

### 13. Manufacturing method according to embodiment and another embodiment of present disclosure

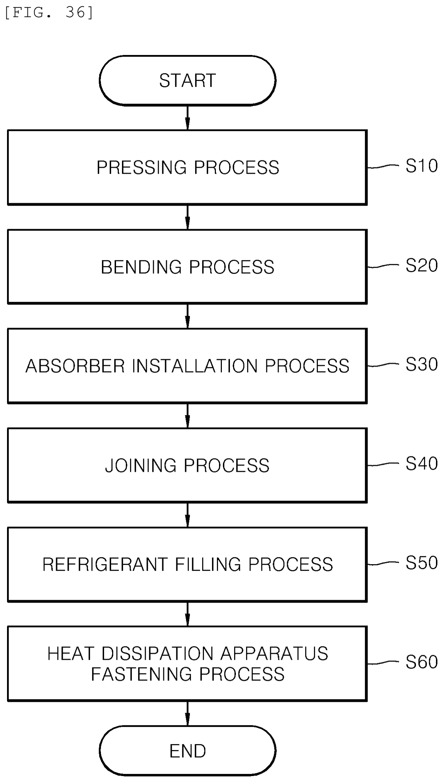

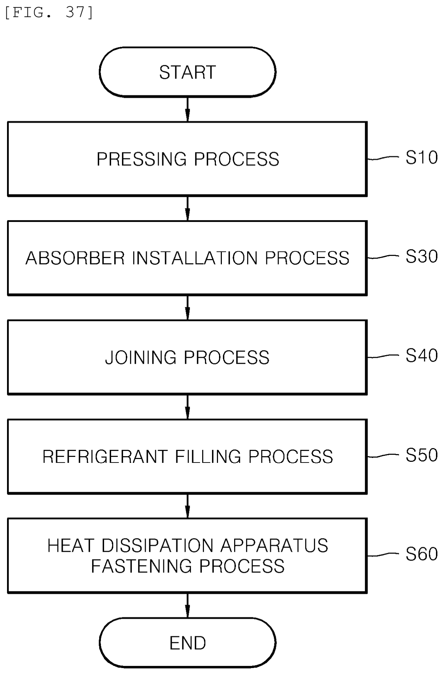

FIG. 36 is a flowchart illustrating a method of manufacturing the active heat dissipation apparatus according to the embodiment of the present disclosure, and FIG. 37 is a flowchart illustrating a method of manufacturing the active heat dissipation apparatus according to another embodiment of the present disclosure.

As illustrated in FIG. 36, the method of manufacturing the active heat dissipation apparatus according to the embodiments of the present disclosure includes the pressing process S10 of compressing the thermal conduction panel bodies 200-1 and 200-2, which is a single member and made of a thermally conductive material, so that the first refrigerant flow path 210, the second refrigerant flow paths 220, and the third refrigerant flow paths 230 are recessed by predetermined depths.

As illustrated in FIG. 12, the pressing process S10 may be defined as a process of manufacturing the single thermal conduction panel bodies 200-1 and 200-2 provided based on the same standard and specification so that the first to third refrigerant flow paths 210, 220, and 230 and the plurality of strength reinforcement portions 240 are formed symmetrically in case that the thermal conduction panel bodies 200-1 and 200-2 are bent about the arbitrary reference line T.

Meanwhile, the method of manufacturing the active heat dissipation apparatus according to the embodiment of the present disclosure may include: the bending process S20 of folding one side thermal conduction panel 200-1 at one widthwise side and the other side thermal conduction panel 200-2 at the other widthwise side about the arbitrary reference line T set based on the first refrigerant flow path 210 after the pressing process S10; and the joining process S40 of joining the rim ends, which correspond to the heat dissipation plate portions 203 of one side thermal conduction panel 200-1 and the other side thermal conduction panel 200-2, and the plurality of strength reinforcement portions 240 formed on the second refrigerant flow path 220 and the third refrigerant flow path 230 after the bending process S20.

In this case, the joining process S40 is performed for the purpose of sealing the refrigerant flow spaces 205 filled with the refrigerant. Because the press-fitting end 201, which corresponds to the first refrigerant flow path 210, is a portion already sealed by the bending process S20, the joining process S40 may be construed as a process joining the rim ends corresponding to the heat dissipation plate portions 203.

Meanwhile, the method of manufacturing the active heat dissipation apparatus according to the embodiments of the present disclosure may further include an absorber installation process S30 of installing the absorber 300, which absorbs and moves the liquid refrigerant by means of the capillary force, on a portion corresponding to the first refrigerant flow path 210 close to the press-fitting end 201 before the joining process S40.

In this case, the absorber 300 is inserted and installed through any one of the opening portions at two opposite ends of the two opposite longitudinal open ends of the first refrigerant flow path 210 formed by the bending process S20. Thereafter, the absorber 300 is filled with the refrigerant by a refrigerant filling process S50 to be described below, and then a process of caulking any one of the two opposite opened ends may be performed to block the one of the two opposite opened ends to prevent the refrigerant therein from leaking.

More specifically, the absorber installation process S30 may be defined as a process performed while the bending process S20 is performed, that is, defined as a process of inserting and installing the absorber 300 into the first refrigerant flow path 210 partially formed before the bending process S20 ends.

That is, with reference to FIG. 12, the first refrigerant flow path 210 is partially formed by bending one side thermal conduction panel 200-1 and the other side thermal conduction panel 200-2 about the arbitrary reference line T by a partial angle, as illustrated in FIG. 12B, during the bending process S20. Next, the absorber 300 is disposed and installed in the portion where the first refrigerant flow path 210 is to be formed. Next, the additional bending process S20 illustrated in FIG. 12C may be performed, and then the joining process S40 illustrated in FIG. 12D may be performed.

In this case, when the bending process S20 ends, the absorber 300 may be stably fixedly installed on the portion corresponding to the first refrigerant flow path 210 by the plurality of absorber fixing guides 250 formed on the portion of the first refrigerant flow path 210.

Thereafter, at the time of joining the rim ends of one side thermal conduction panel 200-1 and the other side thermal conduction panel 200-2 by means of the joining process S40 as described above, two opposite longitudinal ends corresponding to one end and the other end of the press-fitting end 201 constituting the first refrigerant flow path 210 are in an opened state, and any one of the two opposite open ends is caulked for an evacuation process (not illustrated) to be described below. Next, the other of the two opposite open ends, which is not caulked after the process of filling the refrigerant by the refrigerant filling process S50 to be described below, may be blocked by a caulking operation by a caulking finishing process (not illustrated) to be described below so that the refrigerant therein does not leak.

Further, the method of manufacturing the active heat dissipation apparatus according to the embodiment of the present disclosure may further include the refrigerant filling process S50 of filling the refrigerant through one longitudinal end or the other longitudinal end (i.e., any one of the two opposite open ends) of the first refrigerant flow path 210 after the joining process S40, and a heat dissipation apparatus fastening process S60 of installing the active heat dissipation apparatus into the press-fitting portion 150 of the heat dissipation housing main body 110 in a press-fitting manner after the refrigerant filling process S50.

The refrigerant filling process S50 may be performed by any one of the opening portions formed at one longitudinal one end and the other longitudinal end (i.e., the two opposite ends) of the first refrigerant flow path 210 and completely seal the first refrigerant flow path 210 after the refrigerant is filled, thereby preventing a leak of the refrigerant.

However, the method of manufacturing the active heat dissipation apparatus according to the embodiment of the present disclosure may further include a cleaning process (not illustrated) of caulking and blocking any one of the opening portions formed at the two opposite ends of the first refrigerant flow path 210 and cleaning the refrigerant flow space before the absorber installation process S30, and an evacuation process (not illustrated) of evacuating the refrigerant flow space through any one of the opening portions formed at the two opposite ends of the first refrigerant flow path, which is not caulked, after the cleaning process and before the refrigerant filling process S50 or after the refrigerant filling process S50.

In this case, the cleaning process may be performed by sequentially immersing the active heat dissipation apparatus 200 according to the embodiment of the present disclosure in an immersion bath - an ultrasonic bath - a rinse bath - a vapor degreasing bath and then drying the active heat dissipation apparatus 200 to finally remove moisture. The evacuation process may be performed by any one of a process (heating evacuation process method) of evacuating the inside of the apparatus, which is generally operated in a vacuum, by pumping, filling the refrigerant, heating and vaporizing the refrigerant, and then performing evacuation once more and a process (freezing evacuation process method) of filling the refrigerant, temporarily freezing (solidifying) the refrigerant, and then performing evacuation.

For reference, the evacuation process, which is the former method, i.e., the method of filling (injecting) the refrigerant after the evacuation, is a method using the fact that when the refrigerant is filled after forming a high vacuum state, the vacuum state changes to a low vacuum state because a change in degree of vacuum occurs at the time of filling (injecting) the refrigerant. Because this evacuation process is an inexpensive cheaper process, this evacuation process may be mainly applied to mass production and the manufacture of low-end products that prioritize price over quality.

Further, the evacuation process, which is the latter method, i.e., the method of performing the evacuation after filling (injecting) the liquid refrigerant and freezing the liquid refrigerant, specifically, fills and freezes the liquid refrigerant after the primary evacuation and then performs the secondary evacuation. The latter method performs more complicated processes than the former method. However, the latter method is advantageous to the high-vacuum product in that the reaction speed may be high, the NCG may be minimized, and the Qmax may be raised. Therefore, the latter method may reduce a vacuum facility capacity through the process of freezing the liquid refrigerant and increase a vacuum exhaust rate, such that the latter method may be mainly applied to low-volume production and manufacturing of high-value products.

The method may further include the caulking finishing process (not illustrated) of caulking the remaining opening portion of the first refrigerant flow path 210, which has remained without being caulked for the evacuation process, when the evacuation process ends.

In particular, as illustrated in FIG. 13, in the active heat dissipation apparatus 200 according to the embodiment of the present disclosure, one side caulking end 207a and the other side caulking end 207b are formed as partial portions of the press-fitting end 201, which correspond to one end and the other end of the first refrigerant flow path 210, protrude further outward. Therefore, during the caulking operation and the caulking finishing process performed after the joining process S40, a caulking process may be performed to block the opened portion by using a predetermined caulking member made of an elastic material, compress and completely seal the protruding portions by using a compression caulking tool (not illustrated), and then cutting and removing the compressed protruding portions.

Further, the method of manufacturing the active heat dissipation apparatus according to the embodiment of the present disclosure may further include at least any one of a leak test process (not illustrated) of testing whether the refrigerant leaks after the caulking finishing process, a performance inspection process (not illustrated) of finally inspecting the performance of the active heat dissipation apparatus 200 of the present disclosure, and a reliability test process of testing the reliability of the active heat dissipation apparatus 200 of the present disclosure.

Meanwhile, although not illustrated in the drawings, the method of manufacturing the active heat dissipation apparatus according to the embodiment of the present disclosure may further include a coating process (not illustrated) of applying a hydrophobic coating material onto one surface of the thermal conduction panel bodies 200-1 and 200-2, which define the refrigerant flow spaces 205 through which the refrigerant filled by the refrigerant filling process S50 flows, before the bending process S20 (or the absorber installation process S30).

In this case, the configuration is described in which a raw material of the coating layer is limited to the hydrophobic coating material on the assumption that water (distilled water) is adopted as the refrigerant. However, a hydrophilic coating material may, of course, be used depending on the type of adopted refrigerant or refrigerant flow path.

Meanwhile, with reference to FIG. 37, the method of manufacturing the active heat dissipation apparatus 1200 according to another embodiment of the present disclosure may be different from the method of manufacturing the active heat dissipation apparatus 200 (or the like) according to the embodiment of the present disclosure including the bending process S20 in terms of the following features.

That is, the method of manufacturing the active heat dissipation apparatus 1200 according to another embodiment of the present disclosure may include the pressing process S10 of forming and processing the refrigerant flow space including the first refrigerant flow path 1210 and the second refrigerant flow path 1220 with predetermined depths by compressing the two separated metal panel members, the joining process S40 of simultaneously forming the refrigerant flow spaces, which correspond to the first refrigerant flow path 1210 and the second refrigerant flow path 1220, by joining the rim ends of the thermal conduction panel bodies 1200-1 and 1200-2, which are provided as the two separated metal panel members, after the pressing process S10, and the refrigerant filling process S50 of filling the refrigerant flow space with the refrigerant.

In the method of manufacturing the active heat dissipation apparatus 200 or the like according to the embodiment of the present disclosure, the pressing process S10 is performed by using the single metal panel member, such that the refrigerant flow space including the first refrigerant flow path 210 and the second refrigerant flow path 220 is formed, and the rim ends, which exclude the press-fitting end 201 formed by the bending process S20, is formed to be capable of being joined by the joining process S40 that is to be performed subsequently.

In contrast, in the method of manufacturing the active heat dissipation apparatus 1200 according to another embodiment of the present disclosure, the portions of the two separated metal panel members, which correspond to the first refrigerant flow path 1210 and the second refrigerant flow path 1220, are formed together with the rim ends, which define the external shapes thereof, by a sheet metal forming process through the pressing process S10, and then the rim ends of the two separated metal panel members may be immediately joined by using the joining process S40 without performing the bending process S20.

Of course, even in the method of manufacturing the active heat dissipation apparatus 1200 according to another embodiment of the present disclosure, the absorber installation process S30 of installing the absorber 300 or the auxiliary absorber 301 before the joining process S40 may, of course, be performed.

In addition, this is interpreted to be based on the concept in which the joining process S40 includes the process of joining a plurality of strength reinforcement portions 1240 while simultaneously joining the rim ends of the two separated metal panel members by a predetermined method in case that the active heat dissipation apparatus 1200 according to another embodiment of the present disclosure includes the plurality of strength reinforcement portions 1240.

However, even in the method of manufacturing the active heat dissipation apparatus 1200 according to another embodiment of the present disclosure, in order to perform the cleaning process and the evacuation process performed after the joining process S40, the caulking finishing process may, of course, be performed after forming one end and the other end side of the portion, which corresponds to the press-fitting end 1201, so that one end and the other end side of the portion are opened.

According to the active heat dissipation apparatus 200 or 1200 according to the embodiments of the present disclosure configured as described above, heat is actively transferred and dissipated by changing the phases of the refrigerant filled therein, thereby overcoming the limitation on the material of the heat dissipation fin in the related art that dissipates heat, and implementing higher heat dissipation performance. Therefore, it is possible to provide an advantage of significantly improving the performance of the antenna device or the electronic device similar to the antenna device.

The embodiments of the active heat dissipation apparatus according to the present disclosure have been described above in detail with reference to the accompanying drawings. However, the present disclosure is not necessarily limited by the embodiments, and various modifications of the embodiments and any other embodiments equivalent thereto may of course be carried out by those skilled in the art to which the present disclosure pertains. Accordingly, the true protection scope of the present disclosure should be determined by the appended claims.

### [Industrial Applicability]

The present disclosure provides the active heat dissipation apparatus capable of improving heat dissipation performance by actively transferring heat, which is generated from the heat generation device (e.g., the electronic device), by means of the phase change of the refrigerant more effective than characteristics of the thermal conduction material of the active heat dissipation apparatus.

## Claims

1. An active heat dissipation apparatus comprising:
a thermal conduction panel body having a refrigerant flow space in which a refrigerant is stored and flows, the refrigerant flow space being formed in the thermal conduction panel body by bending or joining at least one metal panel member,
wherein the refrigerant flow space comprises:
a first refrigerant flow path positioned to be adjacent to a press-fitting portion provided on a rear surface portion of a heat dissipation housing main body that is a heat dissipation target, the first refrigerant flow path having a vaporization zone in which the refrigerant changes from a liquid phase to a gaseous phase; and
a plurality of strength reinforcement portions formed in a condensation zone excluding the vaporization zone of the first refrigerant flow path and configured to reinforce rigidity of the thermal conduction panel body configured to define one side surface and the other side surface of the refrigerant flow space, and
wherein the plurality of strength reinforcement portions comprise:
a plurality of line reinforcement portions positioned in a relatively upper region based on a gravitational direction in a state in which the plurality of line reinforcement portions are installed on the press-fitting portion, the plurality of line reinforcement portions being configured to form the second refrigerant flow paths configured to guide a flow of a liquid refrigerant in the refrigerant, with which the refrigerant flow space is filled, to the vaporization zone; and
a plurality of dot reinforcement portions that are portions that are not occupied by the plurality of line reinforcement portions, the plurality of dot reinforcement portions being positioned in a relatively lower region based on the gravitational direction in a state in which the plurality of dot reinforcement portions are installed on the press-fitting portion.

2. The active heat dissipation apparatus of claim 1, wherein the plurality of line reinforcement portions are provided in the condensation zone, and a single line reinforcement portion is provided on each of a plurality of inclined guides provided to define the second refrigerant flow path as a space, except for a thickness direction of the refrigerant flow space.

3. The active heat dissipation apparatus of claim 2, wherein the plurality of line reinforcement portions further protrude toward the refrigerant flow space than the plurality of inclined guides and define independent flow paths as the second refrigerant flow paths on the inclined guides.

4. The active heat dissipation apparatus of claim 2, wherein lower ends of the plurality of line reinforcement portions and the plurality of inclined guides are formed to be inclined toward the first refrigerant flow path so as to have predetermined inclination angles.

5. The active heat dissipation apparatus of claim 2, wherein any one of two opposite ends of each of the plurality of line reinforcement portions and the plurality of inclined guides, which adjoins the first refrigerant flow path, is always positioned below the other end based on the gravitational direction.

6. The active heat dissipation apparatus of claim 4, wherein the plurality of dot reinforcement portions are arranged to have an inclination angle equal to inclination angles of the plurality of line reinforcement portions and the plurality of inclined guides.

7. The active heat dissipation apparatus of claim 1, wherein the thermal conduction panel body comprises:
one side thermal conduction panel configured to define one side surface of the refrigerant flow space; and
the other side thermal conduction panel configured to define the other side surface of the refrigerant flow space, and
wherein the plurality of line reinforcement portions and the plurality of dot reinforcement portions are symmetrically formed based on the first refrigerant flow paths of one side thermal conduction panel and the other side thermal conduction panel.

8. The active heat dissipation apparatus of claim 7, wherein the second refrigerant flow paths are symmetrically formed on one side thermal conduction panel and the other side thermal conduction panel in the upper region and defined directly by the plurality of line reinforcement portions protruding to be in surface contact with one another in the refrigerant flow space, and
wherein the second refrigerant flow paths are symmetrically formed on one side thermal conduction panel and the other side thermal conduction panel in the lower region and defined indirectly by the plurality of dot reinforcement portions protruding to be in surface contact with one another in the refrigerant flow space.

9. The active heat dissipation apparatus of claim 7, wherein the plurality of dot reinforcement portions are arranged so that a vertical centerline of any arbitrarily selected one of the dot reinforcement portions is spaced apart farther from a portion where the first refrigerant flow path is positioned than a vertical line that connects a midpoint of a separation space between the two dot reinforcement portions positioned at a relatively upper side.

10. The active heat dissipation apparatus of claim 9, wherein an arrangement density of the plurality of dot reinforcement portions is set in consideration of surface tension of the refrigerant with which the refrigerant flow space is filled.

11. The active heat dissipation apparatus of claim 9, wherein an arrangement density of the plurality of dot reinforcement portions is set as a density determined when the amount of condensed liquid refrigerant falling immediately downward between the adjacent dot reinforcement portions among the plurality of dot reinforcement portions is minimized.
